# EUROPEAN PATENT APPLICATION

(11) **EP 4 580 357 A1**
(43) Date of publication of application: **02.07.2025**
(21) Application number: 24222954.0
(22) Date of filing: 23.12.2024
(51) Int. Cl.: H10K 50/12, H10K 50/15, H10K 85/60

(54) **LIGHT-EMITTING DEVICE AND ELECTRONIC DEVICE INCLUDING THE LIGHT-EMITTING DEVICE**

(30) Priority: 28.12.2023 KR 20230195611
(71) Applicant: Samsung Electronics Co., Ltd., Suwon-si, Gyeonggi-do 16677 (KR)
(72) Inventor: KIM, Jong Soo, 16678 Suwon-si (KR); LEE, Yeonkyung, 16678 Suwon-si (KR); JEONG, Daun, 16678 Suwon-si (KR); KIM, Sangmo, 16678 Suwon-si (KR); KIM, Hwang Suk, 16678 Suwon-si (KR); CHUNG, Yeon Sook, 16678 Suwon-si (KR)
(74) Representative: Elkington and Fife LLP

(57) **Abstract**

A light-emitting device and an electronic device including the same. The light-emitting device includes a first electrode, a second electrode facing the first electrode, and an interlayer disposed between the first electrode and the second electrode, wherein the interlayer includes an emission layer and a hole transport region. The hole transport region includes a first layer disposed between the first electrode and the emission layer, the emission layer includes a first compound and an organometallic compound, the organometallic compound includes a transition metal. The first layer includes a first material, and the light-emitting device satisfies Condition 1 or Condition 2 as described.

## Description

### FIELD OF THE INVENTION

The disclosure relates to a light-emitting device and an electronic device including the same.

### BACKGROUND OF THE INVENTION

Organic light-emitting devices are self-emissive devices that have wide viewing angles, high contrast ratios, short response times, and excellent characteristics in terms of luminance, driving voltage, and response speed, to provide full-color images. An organic light-emitting device includes an anode, a cathode, and an emission layer arranged between the anode and the cathode. A hole transport region may be provided between the anode and the emission layer, and an electron transport region may be provided between the emission layer and the cathode. Holes provided from the anode move toward the emission layer through the hole transport region, and electrons provided from the cathode move toward the emission layer through the electron transport region. The holes and the electrons recombine in the emission layer to produce excitons. The excitons may transition from an excited state to a ground state and in the process emit light of a given wavelength range.

### SUMMARY OF THE INVENTION

A light-emitting device with improved luminescence characteristics in a low gray level area may be achieved by improving capacitance characteristics in the device, and thereby provide high-quality electronic devices, e.g., display devices.

Additional aspects will be set forth in part in the description which follows and, in part, will be apparent from the description, or may be learned by practice of the presented embodiments of the disclosure.

According to one or more embodiments, a light-emitting device includes:
a first electrode; a second electrode facing the first electrode; and an interlayer disposed between the first electrode and the second electrode, wherein the interlayer comprises an emission layer and a hole transport region,
wherein the hole transport region includes a first layer, the first layer includes a first material and is disposed between the first electrode and the emission layer,
wherein the emission layer includes a host and an organometallic compound, the organometallic compound includes a transition metal, and the host includes a first compound, and
the light-emitting device satisfies Condition 1 or Condition 2:
   Condition 1
      Δ HOMO is less than 0 eV, and the dipole moment of the first material is less than 3.0 debye;
   Condition 2
      Δ HOMO is greater than 0 eV, and the dipole moment of the first material is equal to or greater than 3.0 debye,
wherein ΔHOMO is a value obtained by subtracting the HOMO energy level of the first compound from the HOMO energy level of the first material, wherein the HOMO energy level of the first compound, the HOMO energy level of the first material, and the dipole moment of the first material are each calculated based on density functional theory (DFT), and
   the HOMO energy level of the first compound and the HOMO energy level of the first material are negative values.

According to one or more embodiments, an electronic device includes the light-emitting device.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic representation of an organic light-emitting device according to an embodiment; and
FIG. 2 shows capacitance-voltage curves for OLED A4 and OLED A9, respectively.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below by referring to the Figures to explain certain aspects.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. Therefore, reference to "an" element in a claim followed by reference to "the" element is inclusive of one element as well as a plurality of the elements. "At least one" is not to be construed as limiting "a" or "an." "Or" means "and/or." As used herein, the term "and/or" includes any and all combinations of one or more of the associated listed items.

It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ±5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

A light-emitting device according to an embodiment includes a first electrode, a second electrode facing the first electrode, and an interlayer disposed between the first electrode and the second electrode, wherein the interlayer includes an emission layer and a hole transport region.

The term "interlayer" as used herein refers to a single and/or multiple layers disposed between the first electrode and the second electrode in the light-emitting device. The "interlayer" may include, in addition to an organic compound, an organometallic complex.

The hole transport region may be disposed between the first electrode and the emission layer.

For example, the first electrode may be a hole injection electrode or an anode, and the second electrode may be an electron injection electrode or a cathode.

The hole transport region may include a first layer, and the first layer may be disposed between the first electrode and the emission layer. The hole transport region, in addition to the first layer, may further include a hole injection layer, a hole transport layer, an electron-blocking layer, an auxiliary layer, or a combination thereof.

According to an embodiment, the first layer may be in direct contact with the emission layer.

The light-emitting device may further include an electron transport region disposed between the emission layer and the second electrode. The electron transport region may include a buffer layer, a hole-blocking layer, an electron transport layer, an electron injection layer, or a combination thereof.

The emission layer may include a host and an organometallic compound. The organometallic compound may include a transition metal.

In an embodiment, the host may include a first compound.

In another embodiment, when the host further includes an additional compound(s) other than the first compound, the HOMO energy level of the first compound may be greater than the HOMO energy level of the additional compound(s) included in the host. That is, the first compound may be a compound with the greatest HOMO energy level (or highest HOMO energy level) among the compounds included in the host.

In another embodiment, the emission layer may include the first compound and one or more additional compounds other than the first compound, wherein the HOMO energy level of the first compound may be greater than the HOMO energy level of the one or more compound(s) included in the host. That is, the first compound may be a compound with the greatest HOMO energy level (or highest HOMO energy level) among the compounds included in the host.

The first layer may include a first material.

The first compound included in the emission layer and the first material included in the first layer may be different from each other.

The first compound and the organometallic compound included in the emission layer and the first material included in the first layer may be understood by referring to the descriptions in the present specification.

The light-emitting device may satisfy Condition 1 or Condition 2:
Condition 1
   Δ HOMO is less than 0 eV, and the dipole moment of the first material is less than 3.0 debye;
Condition 2
   Δ HOMO is greater than 0 eV, and the dipole moment of the first material is equal to or greater than 3.0 debye.

The ΔHOMO is a value obtained by subtracting the HOMO energy level of the first compound from the HOMO energy level of the first material. That is, ΔHOMO is "HOMO energy level of the first material - HOMO energy level of the first compound," has the unit of "eV", and may be a negative or positive number.

The HOMO energy level of the first compound, the HOMO energy level of the first material, and the dipole moment of the first material may each be calculated based on density functional theory (DFT), and the HOMO energy level of the first compound and the HOMO energy level of the first material may each be a negative value. For example, the HOMO energy level of the first compound, the HOMO energy level of the first material, and the dipole moment of the first material may each be evaluated using the DFT method (T1 adiabatic) of the Gaussian program which is structurally optimized at the B3LYP/6-31G(d,p) level, as described in Evaluation Example 1.

Meanwhile, when the host further includes one or more additional compound(s) other than the first compound, the HOMO energy level of the additional compound(s) is also a negative number calculated based on DFT. For example, the HOMO energy level of the additional compound(s) is evaluated using the DFT method (T1 adiabatic) of the Gaussian program which is structurally optimized at the B3LYP/6-31G(d,p) level, as described in Evaluation Example 1, and may be a negative value.

In this specification, each of the HOMO energy level and lowest unoccupied molecular orbital (LUMO) energy level may be calculated based on DFT and may be a negative value.

The HOMO energy level, LUMO energy level, dipole moment, and triplet (T1) energy level of various compounds described herein are calculated based on DFT, and may be evaluated using, for example, the DFT method (T1 adiabatic) of the Gaussian program which is structurally optimized at the B3LYP/6-31G(d,p) level, as in Evaluation Example 1.

Holes injected from the first electrode migrate to the emission layer through the hole transport region. When driving the light-emitting device, accumulation of holes inside the emission layer and/or at the interface between the emission layer and the hole transport region causes a decrease in the luminescence efficiency and/or lifespan of the light-emitting device. The improvement in the capacitance of the light-emitting device may minimize such accumulation of holes within the emission layer and/or at the interface.

Accordingly, if the ΔHOMO of the light-emitting device is less than 0 eV as in Condition 1, that is, the HOMO energy level of the first material included in the first layer is less than the HOMO energy level of the first compound included in the emission layer (or when the HOMO energy level of the first material included in the first layer is deeper than the HOMO energy level of the first compound included in the emission layer), injection of holes from the first electrode into the emission layer may not proceed smoothly. Moreover, if the dipole moment of the first material included in the first layer is a relatively small value, i.e., less than 3.0 debye as in Condition 1 the energetic disorder of the first layer may be reduced and hole mobility in the first layer may be increased. As a result, injection and transport of holes may be performed at suitable speed, and thereby accumulation of holes within the emission layer and/or at the interface between the emission layer and the hole transport region can be relatively minimized or substantially prevented during operation (driving) of the light-emitting device.

Alternatively, if the ΔHOMO of the light-emitting device is greater than 0 eV as in Condition 2, that is, the HOMO energy level of the first material included in the first layer is greater than the HOMO energy level of the first compound included in the emission layer (or when the HOMO energy level of the first material included in the first layer is shallower than the HOMO energy level of the first compound included in the emission layer), injection of holes from the first electrode into the emission layer may proceed relatively smoothly. Moreover, if the dipole moment of the first material included in the first layer is a relatively large value of 3.0 debye or more as in Condition 2, the energetic disorder of the first layer may increase and hole mobility in the first layer may be reduced. As a result, injection and transport of holes may be performed at suitable speed, and thereby accumulation of holes within the emission layer and/or at the interface between the emission layer and the hole transport region can be relatively minimized or substantially prevented during operation (driving) of the light-emitting device.

Accordingly, if the light-emitting device satisfies Condition 1 or Condition 2 as described above, hole accumulation inside (within) the emission layer and/or at the interface between the emission layer and the hole transport region is substantially minimized or prevented during the operation of the light-emitting device and the capacitance characteristics of the light-emitting device can be improved. The result of which, for example, may lead to improvements of luminescence characteristics of the light-emitting device, for example, the minimization or prevention of turn-on and/or minimization or prevention of stains in the low gray level area may be effectively achieved. As a result, high-quality electronic devices can be manufactured by using the light-emitting devices described herein.

According to an embodiment, values, without a unit, obtained by multiplying the value obtained by subtracting 3 debye from the dipole moment of the first material by ΔHOMO may be 0.0 or a positive number (for example, 0.0 or more (greater) and 0.7 or less).

According to one or more embodiments, the light-emitting device may satisfy Condition 1, and ΔHOMO may be about -0.5 eV or more and less than about 0 eV, about -0.5 eV or more and less than about -0.001 eV, about -0.5 eV or more and less than about -0.005 eV, about -0.5 eV or more and less than about -0.01 eV, about -0.5 eV or more and less than about -0.052 eV, about -0.4 eV or more and less than about 0 eV, about -0.4 eV or more and less than about -0.001 eV, about -0.4 eV or more and less than about -0.005 eV, about -0.4 eV or more and less than about -0.01 eV, about -0.4 eV or more and less than about -0.052 eV, about -0.310 eV or more and less than about 0 eV, about -0.310 eV or more and less than about -0.001 eV, about -0.310 eV or more and less than about -0.005 eV, about -0.310 eV or more and less than about -0.01 eV, or about -0.310 eV or more and less than about -0.052 eV.

According to one or more embodiments, the light-emitting device may satisfy Condition 1, and the dipole moment of the first material may be about 0.5 debye or more and less than about 3.0 debye, about 0.8 debye or more and less than about 3.0 debye, about 1.0 debye or more and less than about 3.0 debye, about 1.2 debye or more and less than about 3.0 debye, about 1.341 debye or more and less than about 3.0 debye, about 0.5 debye or more and less than about 2.9 debye, about 0.8 debye or more and less than about 2.9 debye, about 1.0 debye or more and less than about 2.9 debye, about 1.2 debye or more and less than about 2.9 debye, about 1.341 debye or more and less than about 2.9 debye, about 0.5 debye or more and less than about 2.805 debye, about 0.8 debye or more and less than about 2.805 debye, about 1.0 debye or more and less than about 2.805 debye, about 1.2 debye or more and less than about 2.805 debye, or about 1.341 debye or more and less than about 2.805 debye.

According to one or more embodiments, the light-emitting device may satisfy Condition 2, and ΔHOMO may be more than 0 eV and about 0.1 eV or less, more than 0 eV and about 0.06 eV or less, more than 0 eV and about 0.043 eV or less, about 0.0001 eV or more and about 0.1 eV or less, about 0.0001 eV or more and about 0.06 eV or less, about 0.0001 eV or more and about 0.043 eV or less, about 0.001 eV or more and about 0.1 eV or less, about 0.001 eV or more and about 0.06 eV or less, or about 0.001 eV or more and about 0.043 eV or less.

According to one or more embodiments, the light-emitting device may satisfy Condition 2, and the dipole moment of the first material may be about 3.0 debye or more and about 6.0 debye or less, about 3.0 debye or more and about 5.0 debye or less, about 3.0 debye or more and about 4.667 debye or less, about 3.5 debye or more and about 6.0 debye or less, about 3.5 debye or more and about 5.0 debye or less, about 3.5 debye or more and about 4.667 debye or less, about 4.0 debye or more and about 6.0 debye or less, about 4.0 debye or more and about 5.0 debye or less, or about 4.0 debye or more and about 4.667 debye or less.

According to one or more embodiments, the HOMO energy level of the first compound included in the emission layer may be about -5.6 eV to about -4.8 eV, about -5.6 eV to about -4.9 eV, about -5.6 eV to about -5.0 eV, about -5.5 eV to about -4.8 eV, about -5.5 eV to about -4.9 eV, about -5.5 eV to about -5.0 eV, about -5.4 eV to about -4.8 eV, about -5.4 eV to about -4.9 eV, about -5.4 eV to about -5.07 eV, or about -5.419 eV to about -5.066 eV.

According to one or more embodiments, the triplet (T1) energy level of the first compound included in the emission layer may be 2.8 eV or more, about 2.8 eV to about 3.5 eV, about 2.8 eV to about 3.3 eV, about 2.8 eV to about 3.1 eV, about 2.8 eV to about 3.05 eV, or about 2.81 eV to about 3.05 eV.

According to one or more embodiments, the HOMO energy level of the first material included in the first layer may be about -5.6 eV to about -4.8 eV, about -5.6 eV to about -4.9 eV, about -5.6 eV to about -5.0 eV, about -5.5 eV to about -4.8 eV, about -5.5 eV to about - 4.9 eV, about -5.5 eV to about -5.0 eV, about -5.4 eV to about -4.8 eV, about -5.4 eV to about -4.9 eV, about -5.4 eV to about -5.07 eV, or about -5.419 eV to about -5.066 eV.

According to one or more embodiments, the dipole moment of the first material included in the first layer may be about 0.8 debye to about 7.0 debye, about 0.8 debye to about 6.0 debye, about 0.8 debye to about 5.1 debye, about 1.0 debye to about 6.0 debye, about 1.0 debye to about 5.1 debye, about 1.2 debye to about 6.0 debye, about 1.2 debye to about 5.1 debye, about 1.3 debye to about 6.0 debye, about 1.3 debye to about 5.1 debye, or about 1.341 debye to about 5.008 debye.

According to one or more embodiments, each of the first compound included in the emission layer and the first material included in the first layer may be a compound that includes at least one π electron rich C₃-C₆₀ cyclic group (for example, a carbazole group, an indolocarbazole group, a benzene group, etc.) and does not contain an electron-transporting moiety. Examples of the electron-transporting moiety include a cyano group, a fluoro group, a π electron-deficient nitrogen-containing C₁-C₆₀ cyclic group (for example, a triazine group, pyrimidine group, etc.), a phosphine oxide group, a sulfoxide group, etc.

According to one or more embodiments, each of the first compound included in the emission layer and the first material included in the first layer may include at least one carbazole group, at least one deuterium, at least one tert-butyl group, and at least one silicon (for example, silicon-containing group), or a combination thereof.

According to one or more embodiments, the first compound included in the emission layer may include at least one silicon (for example, silicon-containing group).

According to one or more embodiments, the first material included in the first layer may not include silicon (for example, silicon-containing group).

According to one or more embodiments, each of the first compound included in the emission layer and the first material included in the first layer may not include an amine moiety.

According to one or more embodiments, the transition metal of the organometallic compound may be iridium (Ir), platinum (Pt), palladium (Pd), gold (Au), osmium (Os), titanium (Ti), zirconium (Zr), hafnium (Hf), europium (Eu), terbium (Tb), thulium (Tm), or rhodium (Rh).

According to one or more embodiments, the organometallic compound included in the emission layer may further include n ligands bonded to the transition metal, and n may be an integer from 1 to 4. Each of the ligands may be a monodentate ligand, a bidentate ligand, a tridentate ligand, a tetradentate ligand, etc.

According to one or more embodiments, the organometallic compound included in the emission layer may further include n ligands bonded to the transition metal, the transition metal in the organometallic compound may be platinum (Pt) or palladium (Pd), n may be 1, and the ligand may be a tetradentate ligand.

According to one or more embodiments, the tetradentate ligand may include a carbene moiety coordinated to the transition metal.

According to one or more embodiments, the tetradentate ligand may include a carbene moiety of an imidazole group, or of a benzimidazole group, coordinated to the transition metal.

According to one or more embodiments, the organometallic compound included in the emission layer may further include n ligands bonded to the transition metal, the transition metal in the organometallic compound may be iridium (Ir) or osmium (Os), n may be 3, and at least one of the n ligands may be a bidentate ligand including -F substituent, a cyano substituent, or a combination thereof, or a bidentate ligand including a carbene moiety bonded to the transition metal. For example, the bidentate ligand may further include an imidazole group, benzimidazole group, or a triazole group.

According to one or more embodiments, the HOMO energy level of the organometallic compound may be about -4.1 eV to about -5.1 eV, about -4.1 eV to about -4.9 eV, about -4.1 eV to about -4.7 eV, about -4.3 eV to about -5.1 eV, about -4.3 eV to about -4.9 eV, or about -4.3 eV to about -4.7 eV.

According to one or more embodiments, the dipole moment of the organometallic compound may be about 4.0 debye to about 12.0 debye, about 4.0 debye to about 10.0 debye, about 4.0 debye to about 8.0 debye, about 6.0 debye to about 12.0 debye, about 6.0 debye to about 10.0 debye, about 6.0 debye to about 8.0 debye, about 7.0 debye to about 12.0 debye, about 7.0 debye to about 10.0 debye, or about 7.0 debye to about 8.0 debye

According to one or more embodiments, the T₁ energy level of the organometallic compound may be about 2.2 eV to about 3.0 eV, about 2.2 eV to about 2.8 eV, about 2.2 eV to about 2.7 eV, about 2.4 eV to about 3.0 eV, about 2.4 eV to about 2.8 eV, about 2.4 eV to about 2.7 eV, about 2.6 eV to about 3.0 eV, about 2.6 eV to about 2.8 eV, or about 2.6 eV to about 2.7 eV.

According to one or more embodiments, the organometallic compound may be an organometallic compound represented by Formula 3 and/or an organometallic compound represented by Formula 5. Descriptions of Formulae 3 and 5 are provided later.

According to one or more embodiments, the amount (weight) of the host in the emission layer may be 50 parts by weight or more, for example, about 50 parts by weight to about 99 parts by weight, about 60 parts by weight to about 95 parts by weight, or about 70 parts by weight to about 95 parts by weight, based on 100 parts by weight of the emission layer.

According to one or more embodiments, the host of the emission layer may further include a second compound, and the second compound is different from the first compound. The second compound may be included as one or more additional compound(s).

According to one or more embodiments, the host of the emission layer may further include a second compound, the second compound is different from the first compound, and the HOMO energy level of the first compound may be greater than (or higher than) the HOMO energy level of the second compound.

According to one or more embodiments, the host of the emission layer may include only a first compound, and the first compound may be a hole-transporting compound, an electron-transporting compound, or a bipolar compound.

According to one or more embodiments, the host of the emission layer may further include a second compound, the second compound is different from the first compound, and the first compound may be a hole-transporting compound and the second compound may be an electron-transporting compound.

According to one or more embodiments, the first compound may be a compound that includes at least one π electron-rich C₃-C₆₀ cyclic group (for example, a carbazole group, an indolocarbazole group, a benzene group, etc.), and does not include an electron-transporting moiety. Examples of the electron-transporting moiety include a cyano group, a fluoro group, a π electron-deficient nitrogen-containing C₁-C₆₀ cyclic group (for example, a triazine group, pyrimidine group, etc.), a phosphine oxide group, a sulfoxide group, etc.

According to one or more embodiments, the second compound may be a compound including at least one electron-transporting moiety. The electron-transporting moiety may be a cyano group, a fluoro group, a π electron-deficient nitrogen-containing C₁-C₆₀ cyclic group (for example, a triazine group, a pyrimidine group, etc.), a phosphine oxide group, a sulfoxide group, or a combination thereof.

According to one or more embodiments, the second compound may include an azine group (for example, a triazine group, etc.).

According to one or more embodiments, the second compound may include:
a triazine group; and
at least one carbazole group, at least one deuterium, at least one tert-butyl group, at least one silicon (for example, silicon-containing group), or a combination thereof.

According to one or more embodiments, the triplet (T₁) energy level of the second compound may be about 2.3 eV to about 3.5 eV, about 2.4 eV to about 3.2 eV, about 2.5 eV to about 3.1 eV, or about 2.6 eV to about 3.0 eV.

According to one or more embodiments, the LUMO energy level of the second compound may be about -2.2 eV to about -1.4 eV, about -2.0 eV to about -1.4 eV, about -1.8 eV to about -1.4 eV, about -2.2 eV to about -1.6 eV, about -2.0 eV to about -1.6 eV, or about -1.8 eV to about -1.6 eV.

When the host of the emission layer further includes a second compound, the weight ratio of the first compound to the second compound may be about 1 : 99 to about 99 : 1, about 10 : 90 to about 90 : 10, about 20 : 80 to about 80 : 20, about 30 : 70 to about 70 : 30, or about 40 : 60 to about 60 : 40. When the weight ratio of the first compound to the second compound satisfies these ranges described above, the balance between holes and electrons in the emission layer is effectively achieved, and a light-emitting device with excellent luminescence efficiency and/or lifespan characteristics may be implemented.

In one or more embodiments, the emission layer may emit blue light.

According to one or more embodiments, the emission layer may emit light (for example, blue light) having a maximum emission wavelength range of about 400 nm to about 490 nm, about 410 nm to about 470 nm, or about 420 nm to about 450 nm.

### Light-emitting device in which the organometallic compound is an emitter.

The organometallic compound included in the emission layer may be an emitter (or may function as an emitter). That is, the organometallic compound may be a compound that emits light by receiving generated excitons from a host and transitioning therefrom to the ground state.

For example, the emission layer may include a non-emissive material and an emitter, and the host may be included in the non-emissive material.

The organometallic compound may emit phosphorescent light or fluorescent (for example, delayed fluorescent) light.

The amount (weight) of the organometallic compound may be about 0.01 parts by weight to about 30 parts by weight, about 0.1 parts by weight to about 20 parts by weight, about 0.1 parts by weight to about 10 parts by weight, or about 0.5 parts by weight to about 5 parts by weight, based on 100 parts by weight of the emission layer.

According to an embodiment, the organometallic compound included in the emission layer may emit blue light.

According to one or more embodiments, the organometallic compound included in the emission layer may emit light (for example, blue light) having a maximum emission wavelength range of about 400 nm to about 490 nm, about 410 nm to about 470 nm, or about 420 nm to about 450 nm.

### Light-emitting device further including thermally activated delayed fluorescent material.

For example, the emission layer may further include a thermally activated delayed fluorescent material.

According to an embodiment, a thermally activated delayed fluorescent material included in the emission layer may be an emitter (or may function as an emitter), and the organometallic compound included in the emission layer may be a sensitizer (or may function as a sensitizer). Therefore, the light-emitting device may be a fluorescent light-emitting device. The sensitizer may effectively transfer excitons formed from non-emissive materials included in the emission layer to the emitter.

According to an embodiment, a thermally activated delayed fluorescent material included in the emission layer may be a sensitizer (or may function as a sensitizer), and the organometallic compound included in the emission layer may be an emitter (or may function as an emitter).

According to one or more embodiments, the thermally activated delayed fluorescence material may be a multiple resonance thermally activated delayed fluorescence material. The multiple resonance thermally activated delayed fluorescent material may be a polycyclic compound that i) does not include transition metal, and ii) includes a core in which two or more C₃-C₆₀ cyclic groups are condensed with each other and two C₃-C₆₀ cyclic groups in the core may be condensed with each other while sharing boron (B) or nitrogen (N).

According to one or more embodiments, the emitter may be a polycyclic compound represented by Formula 4. Formula 4 will be described later.

According to one or more embodiments, the amount (weight) of the thermally activated delayed fluorescent material may be about 0.01 parts by weight to about 30 parts by weight, about 0.1 parts by weight to about 20 parts by weight, about 0.1 parts by weight to about 10 parts by weight, or about 0.5 parts by weight to about 5 parts by weight, based on 100 parts by weight of the emission layer.

According to one or more embodiments, the thermally activated delayed fluorescent material included in the emission layer may emit blue light.

According to one or more embodiments, the thermally activated delayed fluorescent material included in the emission layer may emit light (for example, blue light) having a maximum emission wavelength range of about 400 nm to about 490 nm, about 410 nm to about 470 nm, or about 420 nm to about 450 nm.

According to one or more embodiments, at least one of the first material, the first compound, and the organometallic compound, and optionally, at least one of the second compound and the thermally activated delayed fluorescent material may include at least one deuterium.

### Description of Formulae 1-1, 1-2 and 1-3

Each of the first material included in the first layer and the first compound included in the emission layer, as used herein, may be a compound represented by Formula 1-1, a compound represented by Formula 1-2, a compound represented by Formula 1-3, or a combination thereof:

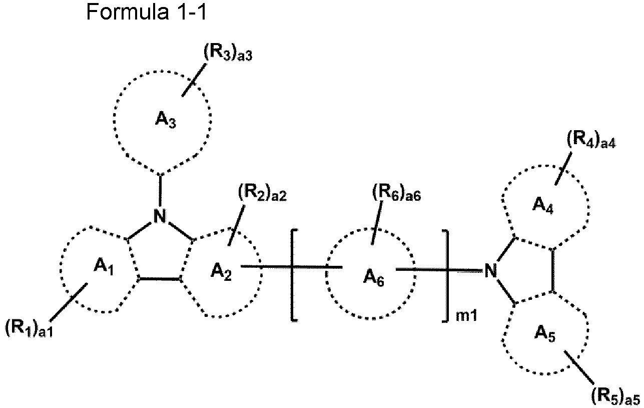

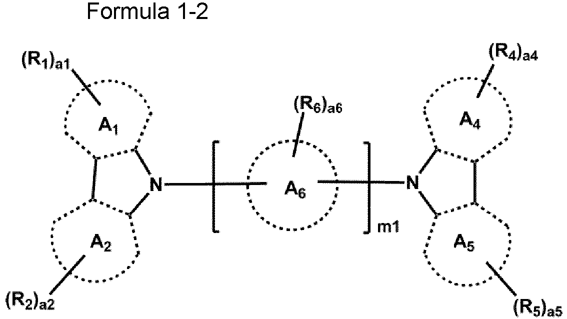

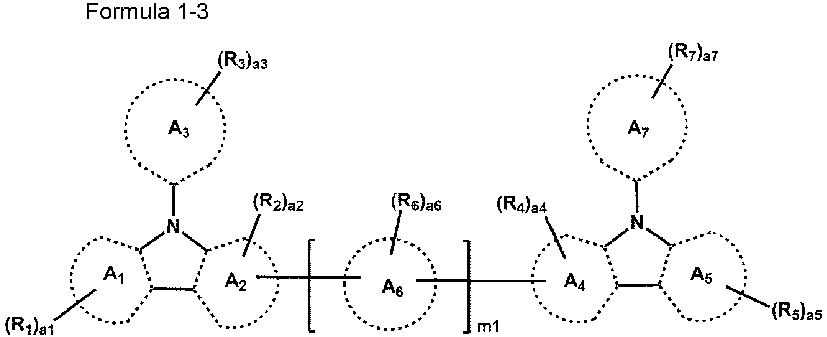

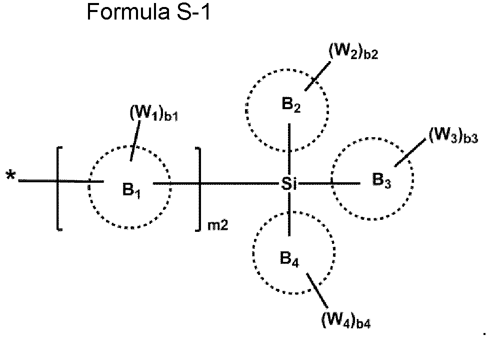

In Formulae 1-1, 1-2 and 1-3, R₁ to R₇ may each independently be:
a group represented by Formula S-1;
hydrogen, deuterium, a C₁-C₆₀ alkyl group, a deuterated C₁-C₆₀ alkyl group, a C₁-C₆₀ alkoxy group, or a deuterated C₁-C₆₀ alkoxy group; or
a π electron-rich C₅-C₆₀ cyclic group that is unsubstituted or substituted with deuterium, a C₁-C₆₀ alkyl group, a C₁-C₆₀ alkoxy group, a π electron-rich C₅-C₆₀ cyclic group, or a combination thereof, and
a1 to a7 in Formulae 1-1, 1-2 and 1-3 may each independently be an integer from 1 to 20, for example, 1 to 10, 1 to 5, or 1 to 4,
each of ring A₁ to ring A₇ and ring B₁ to ring B₄ in Formulae 1-1, 1-2, 1-3, and S-1 may be a π electron-rich C₅-C₆₀ cyclic group,
m1 and m2 in Formulae 1-1, 1-2, 1-3 and S-1 may each independently be 0, 1, 2, or 3, and i) when m1 is 0, a group represented by 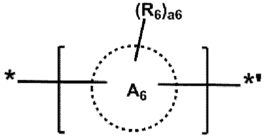 may be a single bond, and ii) when m2 is 0, a group represented by 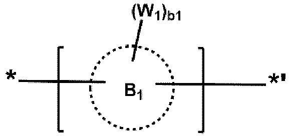 may be a single bond,
W₁ to W₄ in Formula S-1 may each independently be:
   hydrogen, deuterium, a C₁-C₆₀ alkyl group, a deuterated C₁-C₆₀ alkyl group, a C₁-C₆₀ alkoxy group, or a deuterated C₁-C₆₀ alkoxy group; or
   a π electron-rich C₅-C₆₀ cyclic group that is unsubstituted or substituted with deuterium, a C₁-C₆₀ alkyl group, a C₁-C₆₀ alkoxy group, a π electron-rich C₅-C₆₀ cyclic group, or a combination thereof, and
   b1 to b4 in Formula S-1 may each independently be an integer from 1 to 20, for example, 1 to 10, 1 to 5, or 1 to 4.

According to an embodiment, at least one of R₁, R₂, R₃, R₄, R₅, and R₆ in Formula 1-1, at least one of R₁, R₂, R₄, R₅, and R₆ in Formula 1-2, and at least one of R₁, R₂, R₃, R₄, R₅, R₆ and R₇ in Formula 1-3 may be a group represented by Formula S-1.

According to one or more embodiments, each of R₁ to R₇ in Formulae 1-1, 1-2, and 1-3 may not be a group represented by Formula S-1.

According to one or more embodiments, R₁ to R₇ in Formulae 1-1, 1-2 and 1-3 may each independently be:
a group represented by Formula S-1;
hydrogen, deuterium, a C₁-C₂₀ alkyl group, a deuterated C₁-C₂₀ alkyl group, a C₁-C₂₀ alkoxy group, or a deuterated C₁-C₂₀ alkoxy group; or
a benzene group, a naphthalene group, a furan group, a thiophene group, a pyrrole group, a cyclopentadiene group, a silole group, a benzofuran group, a benzothiophene group, an indole group, an indene group, a benzosilole group, a dibenzofuran group, a dibenzothiophene group, a carbazole group, a fluorene group, a dibenzosilole group, a benzofurocarbazole group, a benzo thienocarbazole group, an indolocarbazole group, an indenocarbazole group, or a benzosilolocarbazole group, each unsubstituted or substituted with deuterium, a C₁-C₂₀ alkyl group, a deuterated C₁-C₂₀ alkyl group, a C₁-C₂₀ alkoxy group, a deuterated C₁-C₂₀ alkoxy group, a phenyl group, a deuterated phenyl group, a biphenyl group, a deuterated biphenyl group, a terphenyl group, a deuterated terphenyl group, a naphthyl group, a furanyl group, a thiophenyl group, a pyrrolyl group, a cyclopentadienyl group, a silolyl group, a benzofuranyl group, a benzothiophenyl group, an indolyl group, an indenyl group, a benzosilolyl group, a dibenzofuranyl group, a deuterated dibenzofuranyl group, a dibenzothiophenyl group, a deuterated dibenzothiophenyl group, a carbazolyl group, a deuterated carbazolyl group, a fluorenyl group, a dibenzosilolyl group, a benzofurocarbazolyl group, a benzothienocarbazolyl group, an indolocarbazolyl group, an indenocarbazolyl group, a benzosilolocarbazolyl group, or a combination thereof.

According to one or more embodiments, R₁ to R₇ in Formulae 1-1, 1-2 and 1-3 may each independently be:
a group represented by Formula S-1;
hydrogen, deuterium, a C₁-C₂₀ alkyl group, or a deuterated C₁-C₂₀ alkyl group; or
a benzene group, a dibenzofuran group, a dibenzothiophene group, a carbazole group, a benzofurocarbazole group, a benzothienocarbazole group, or an indolocarbazole group, each unsubstituted or substituted with deuterium, a C₁-C₂₀ alkyl group, a deuterated C₁-C₂₀ alkyl group, a phenyl group, a deuterated phenyl group, a biphenyl group, a deuterated biphenyl group, a terphenyl group, a deuterated terphenyl group, a dibenzofuranyl group, a deuterated dibenzofuranyl group, a dibenzothiophenyl group, a deuterated dibenzothiophenyl group, a carbazolyl group, a deuterated carbazolyl group, or a combination thereof.

According to one or more embodiments, each of i) R₁, ii) R₃, iii) R₄, or iv) R₃ and R₄, in Formula 1-1 may be a group represented by Formula S-1.

According to one or more embodiments, R₆ in Formula 1-2 may be a group represented by Formula S-1.

Meanwhile, rings A₁ to rings A₇ and rings B₁ to rings B₄ in Formulae 1-1, 1-2, 1-3, and S-1 may each independently be a benzene group, a naphthalene group, a furan group, a thiophene group, a pyrrole group, a cyclopentadiene group, a silole group, a benzofuran group, a benzothiophene group, an indole group, an indene group, a benzosilole group, a dibenzofuran group, a dibenzothiophene group, a carbazole group, a fluorene group, a dibenzosilole group, a benzofurocarbazole group, a benzothienocarbazole group, an indolocarbazole group, an indenocarbazole group, or a benzosilolocarbazole group.

According to an embodiment, rings A₁, A₂, A₄ and A₅ may each independently be a benzene group, a benzofuran group, a benzothiophene group, or an indole group.

According to one or more embodiments, rings A₃, A₆ and A₇, and rings B₁ to ring B₄ may each independently be a benzene group, a dibenzofuran group, a dibenzothiophene group, a carbazole group, a benzofurocarbazole group, a benzothienocarbazole group, or an indolocarbazole group.

W₁ to W₄ in Formula S-1 may each independently be:
hydrogen, deuterium, a C₁-C₂₀ alkyl group, a deuterated C₁-C₂₀ alkyl group, a C₁-C₂₀ alkoxy group, or a deuterated C₁-C₂₀ alkoxy group; or
a benzene group, a naphthalene group, a furan group, a thiophene group, a pyrrole group, a cyclopentadiene group, a silol group, a benzofuran group, a benzothiophene group, an indole group, an indene group, a benzosilol group, a dibenzofuran group, a dibenzothiophene group, a carbazole group, a fluorene group, a dibenzosilol group, a benzofurocarbazole group, a benzo thienocarbazole group, an indolocarbazole group, an indenocarbazole group, or a benzosilolocarbazole group, each unsubstituted or substituted with deuterium, a C₁-C₂₀ alkyl group, a deuterated C₁-C₂₀ alkyl group, a C₁-C₂₀ alkoxy group, a deuterated C₁-C₂₀ alkoxy group, a phenyl group, a deuterated phenyl group, a biphenyl group, a deuterated biphenyl group, a terphenyl group, a deuterated terphenyl group, a naphthyl group, a furanyl group, a thiophenyl group, a pyrrolyl group, a cyclopentadienyl group, a silolyl group, a benzofuranyl group, a benzothiophenyl group, an indolyl group, an indenyl group, a benzosilolyl group, a dibenzofuranyl group, a deuterated dibenzofuranyl group, a dibenzothiophenyl group, a deuterated dibenzothiophenyl group, a carbazolyl group, a deuterated carbazolyl group, a fluorenyl group, a dibenzosilolyl group, a benzofurocarbazolyl group, a benzothienocarbazolyl group, an indolocarbazolyl group, an indenocarbazolyl group, a benzosilolocarbazolyl group, or a combination thereof.
Specific examples of first compound included in emission layer and first material included in first layer.

According to an embodiment, the first compound included in the emission layer and the first material included in the first layer may each independently be selected from Compounds H1 to H108 and deuterium-containing derivatives thereof.

The term "deuterium-containing derivative" as used herein refers to a compound that has the same backbone as the backbone of a corresponding compound, but in which at least one of the hydrogens in the compound is replaced with deuterium, or in which the substitution position of the deuterium contained in the compound is changed.

According to one or more embodiments, the first compound included in the emission layer may be selected from Compounds H1 to H42 and deuterium-containing derivatives thereof.

According to one or more embodiments, the first compound included in the emission layer may be selected from Compounds H2 to H14 and H43 to H108 and deuterium-containing derivatives thereof.

According to one or more embodiments, the first compound included in the emission layer may include a carbazole moiety, or a benzene moiety in which each hydrogen is optionally replaced with deuterium.

According to one or more embodiments, the first material included in the first layer may be selected from Compounds H2 to H14 and H43 to H108 and deuterium-containing derivatives thereof.

According to one or more embodiments, when the first compound included in the emission layer is Compound H1, the first material included in the first layer may be selected from Compounds H5 to H108 and deuterium-containing derivatives thereof:

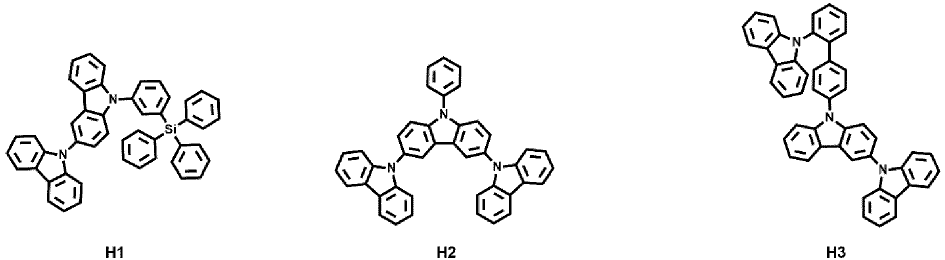

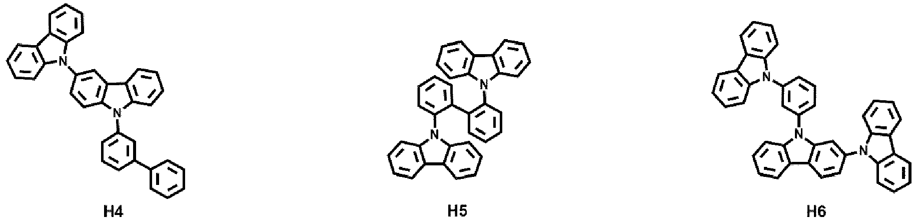

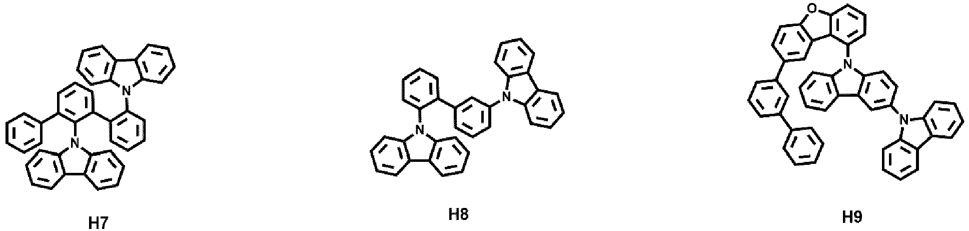

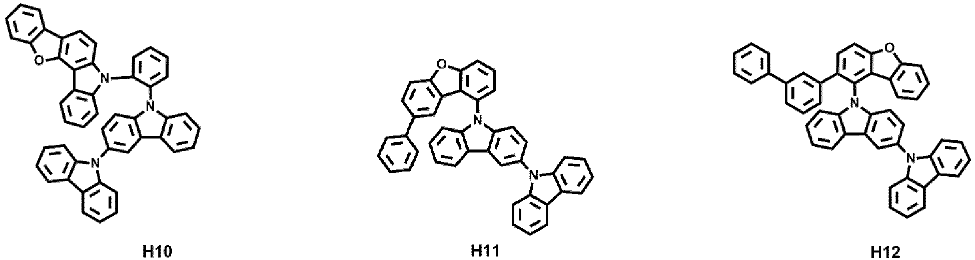

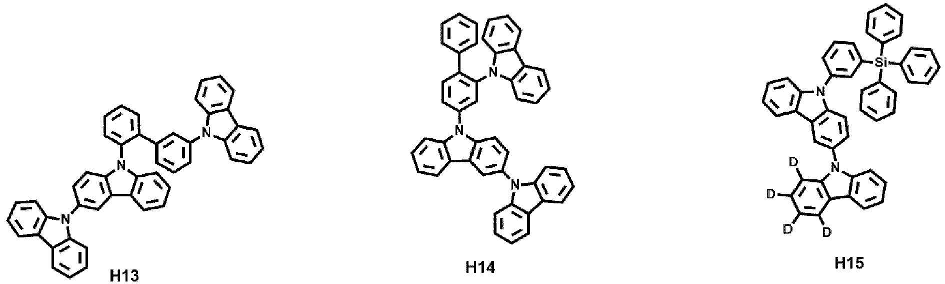

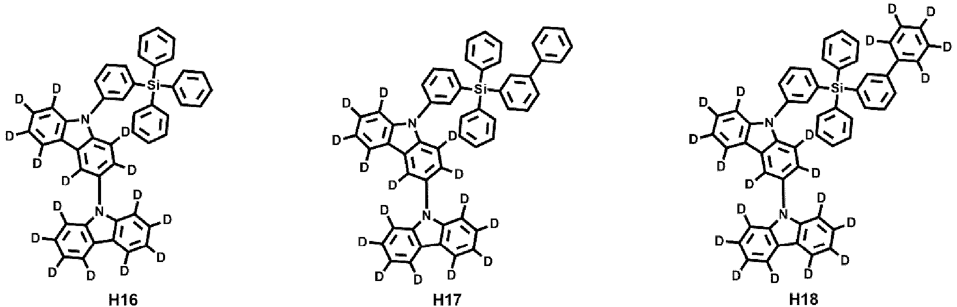

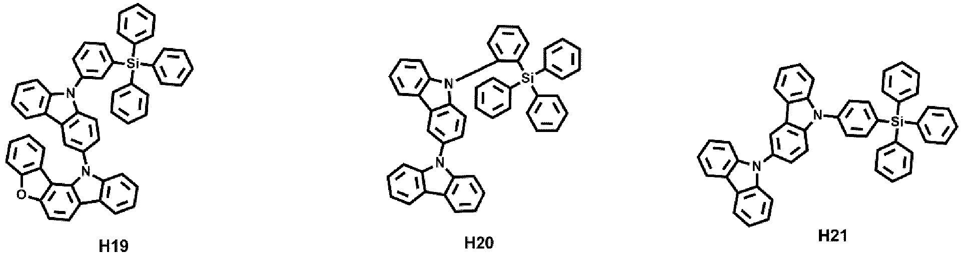

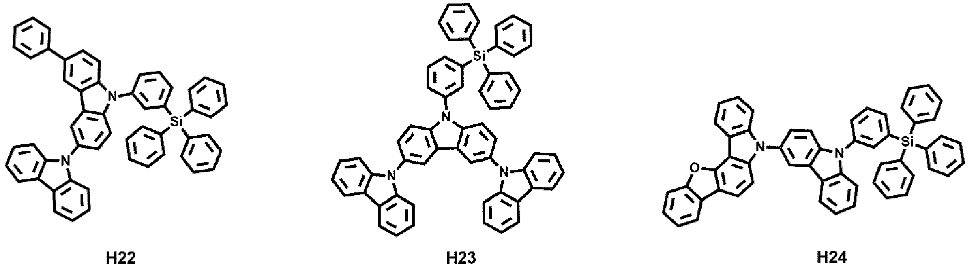

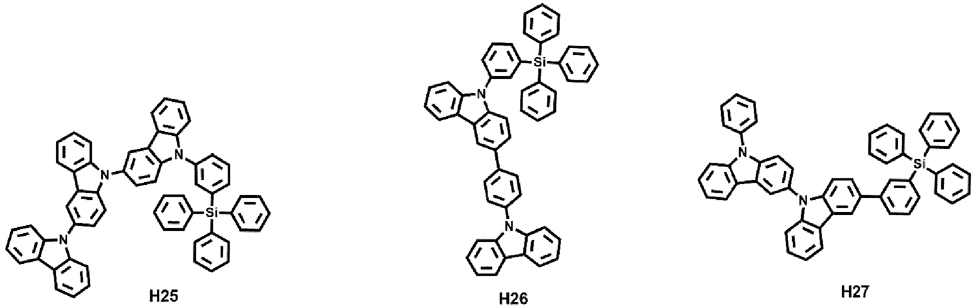

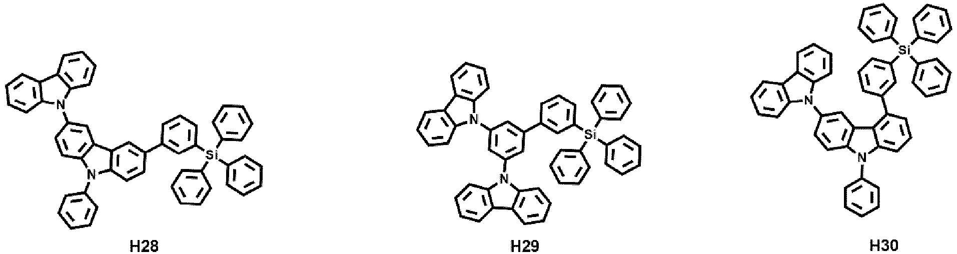

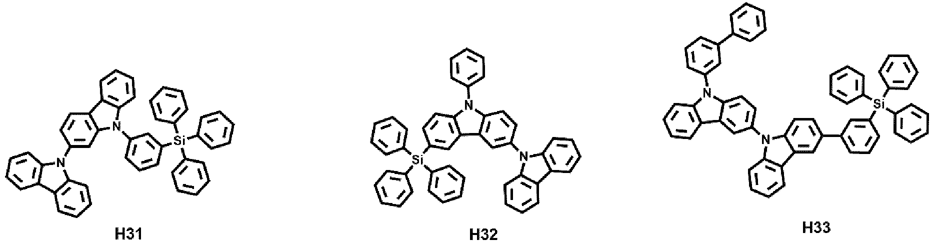

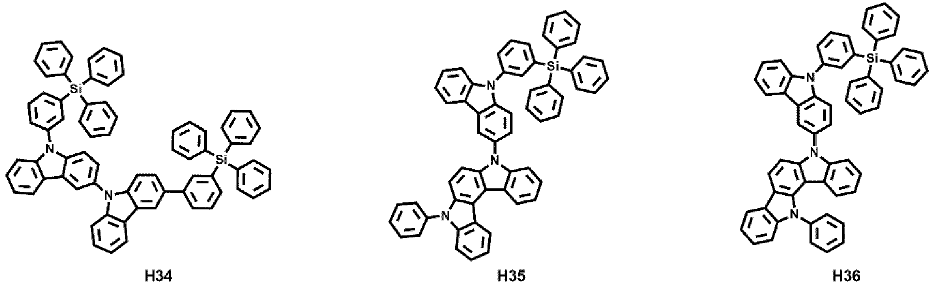

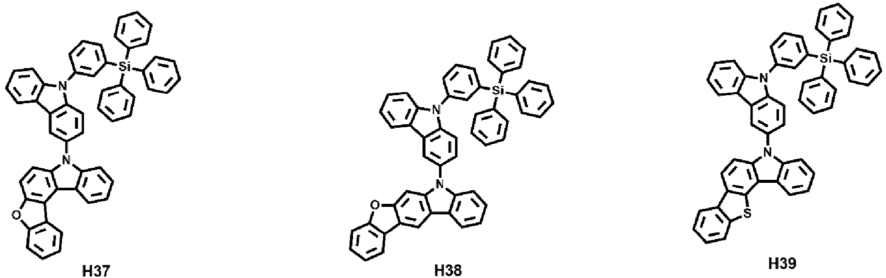

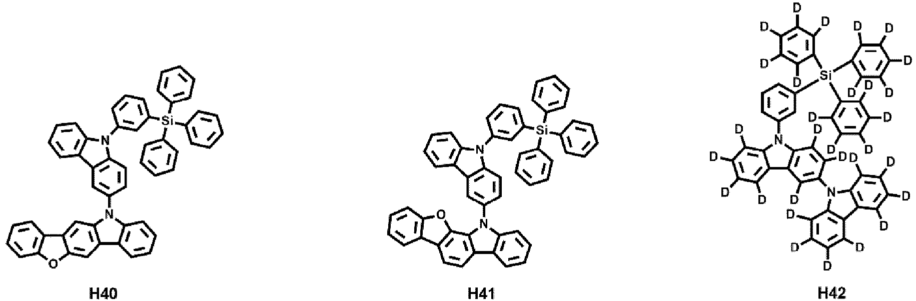

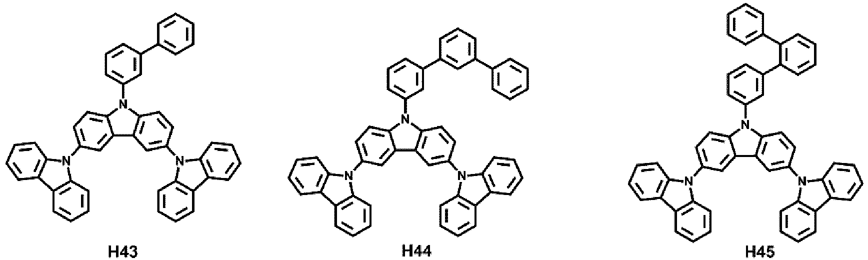

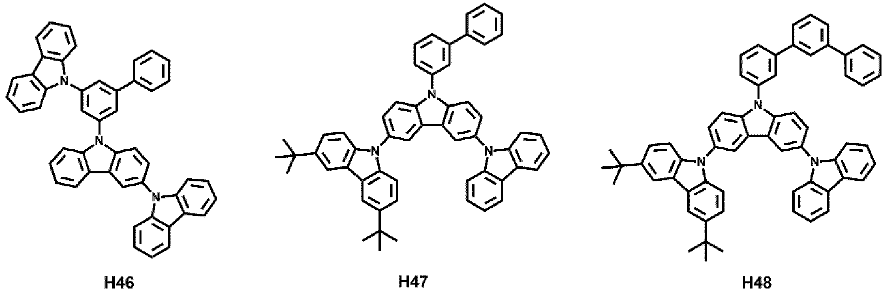

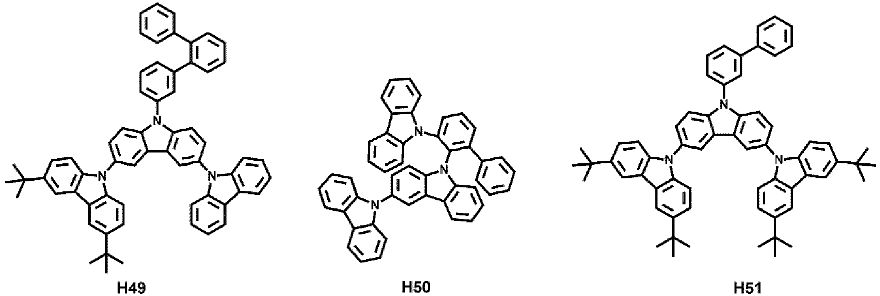

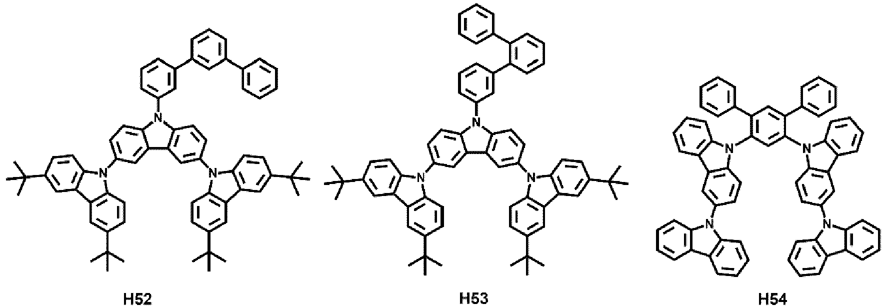

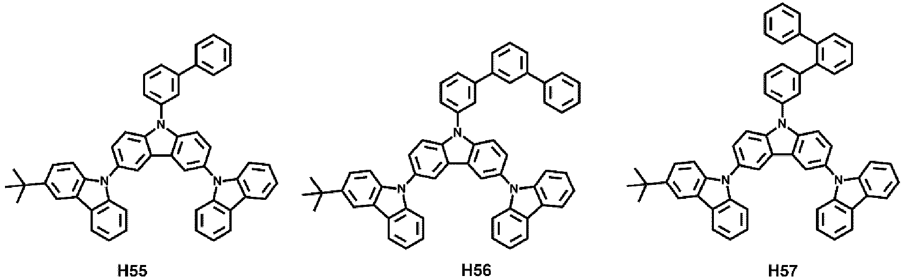

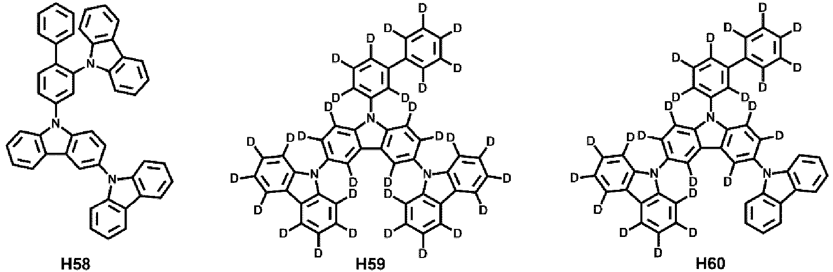

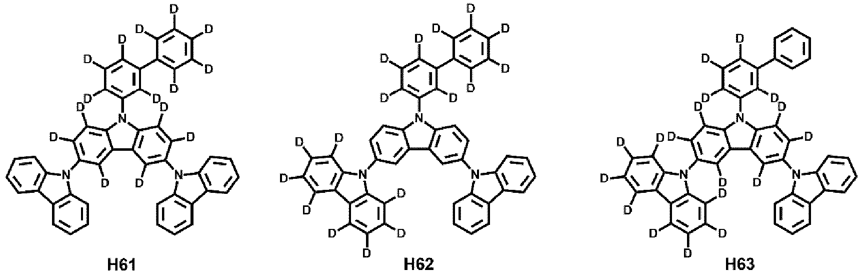

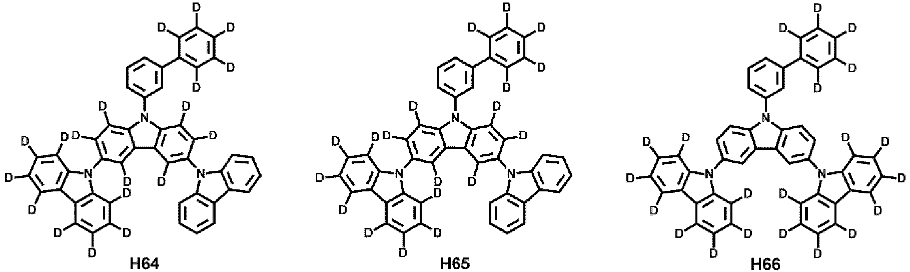

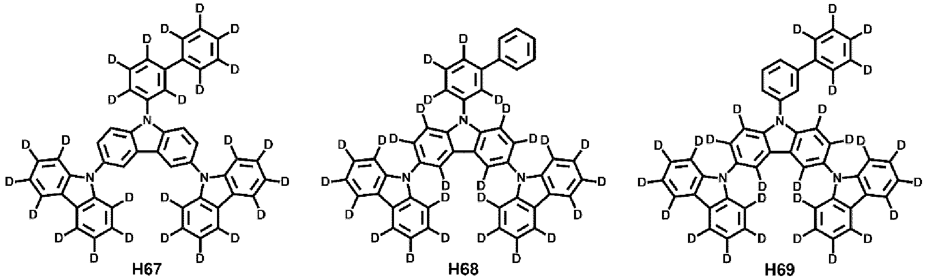

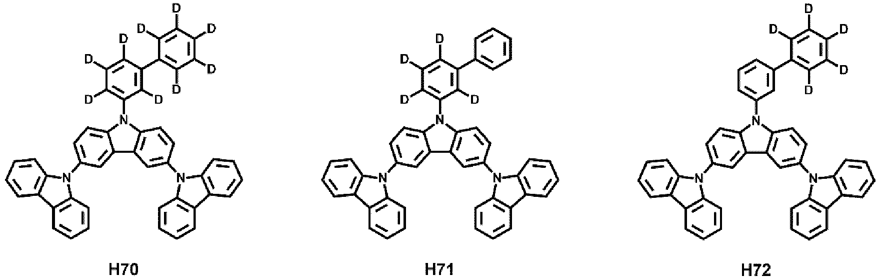

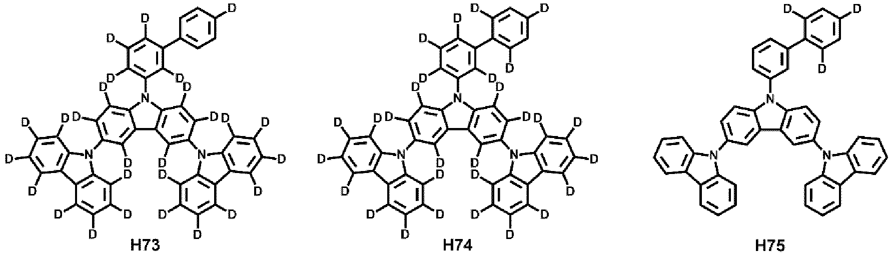

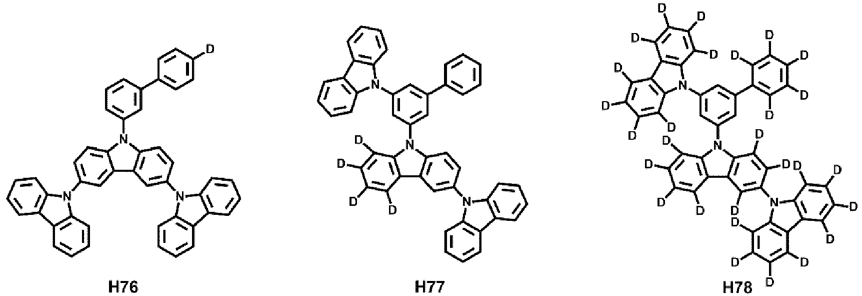

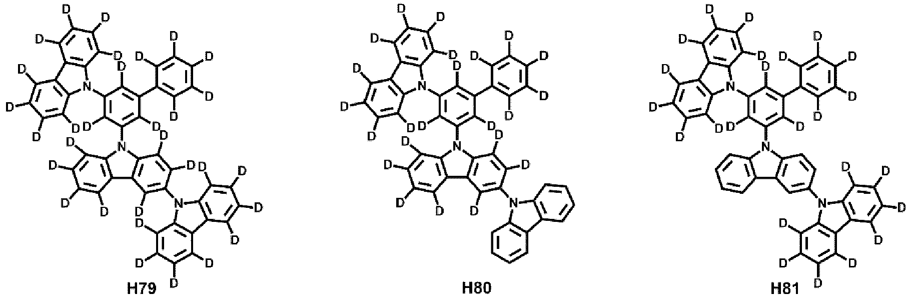

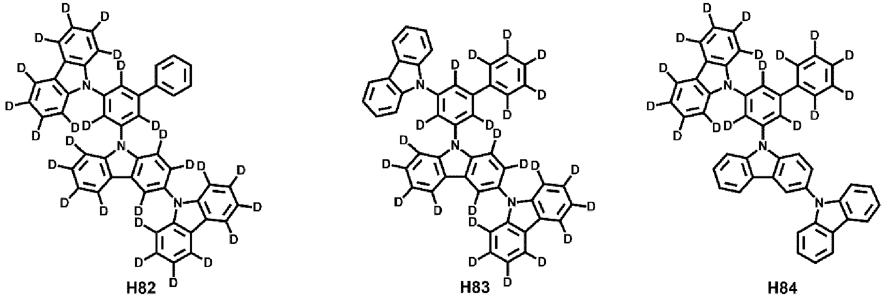

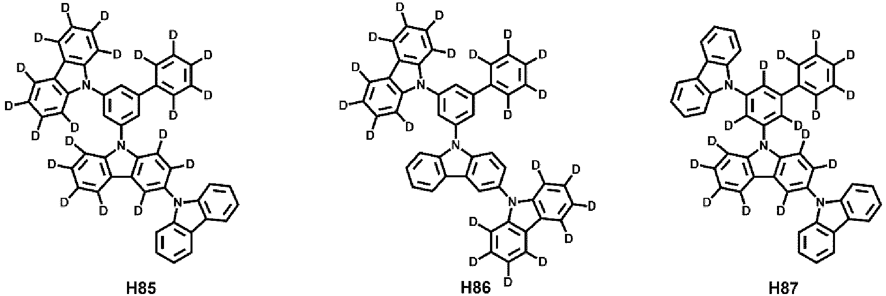

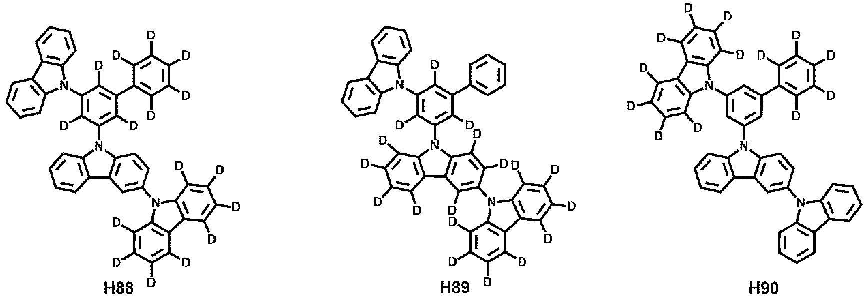

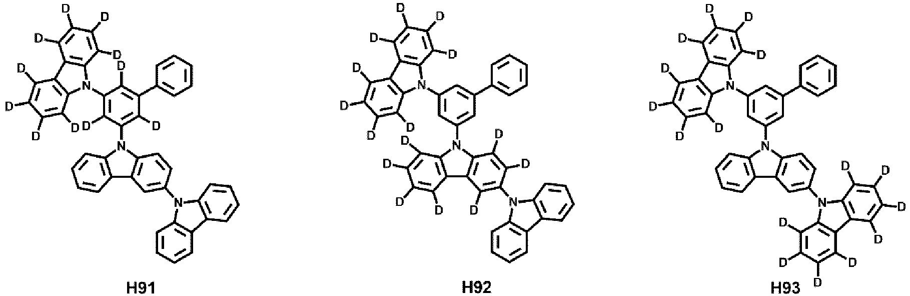

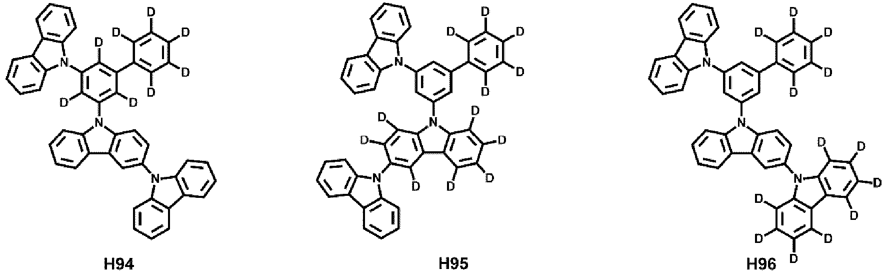

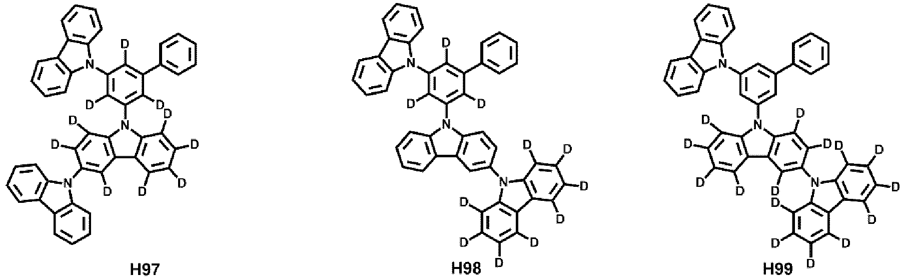

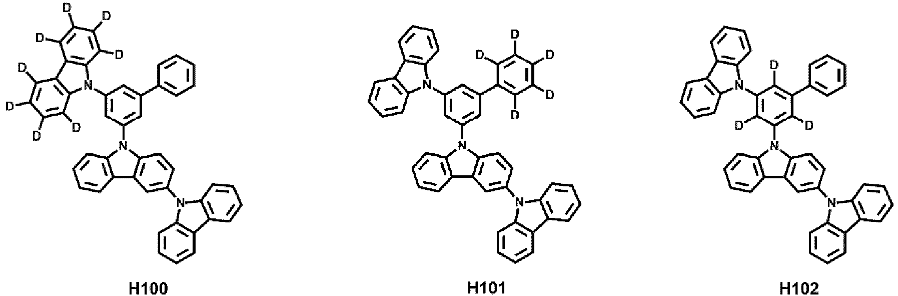

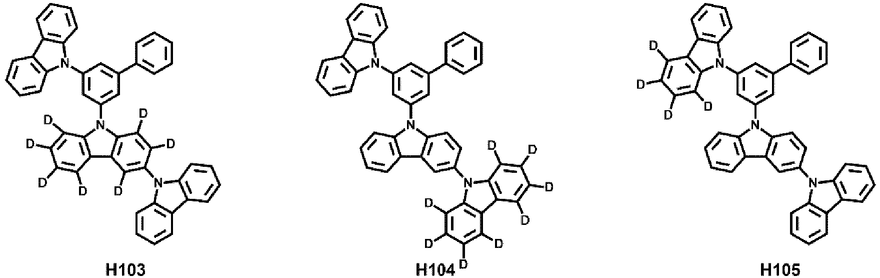

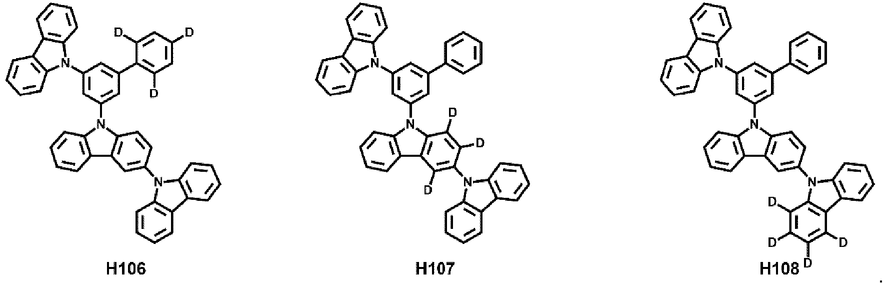

### Description of Formula 2

The second compound included in the emission layer in the present specification may be a compound represented by Formula 2: 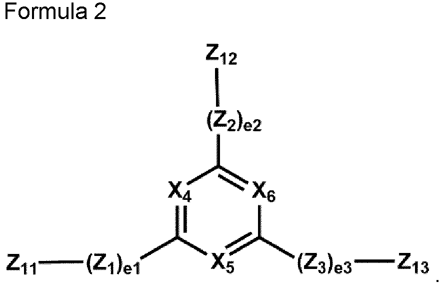 In Formula 2,
X₄ may be N, C(H) or C(Z₁₄), X₅ may be N, C(H) or C(Z₁₅), and X₆ may be N, C(H) or C(Z₁₆), and at least one of X₄ to X₆ may be N,
Z₁ to Z₃ may each independently be *-Si(Ar₁)(Ar₂)-*', a C₅-C₃₀ carbocyclic group unsubstituted or substituted with at least one R₀, or a C₂-C₃₀ heterocyclic group unsubstituted or substituted with at least one R₀,
e1 to e3 may each independently be 0, 1, 2, or 3, i) when e1 is 0, the group represented by *-(Z₁)ₑ₁-*' is a single bond, ii) when e2 is 0, the group represented by *-(Z₂)ₑ₂-*' is a single bond, and iii) when e3 is 0, the group represented by *-(Z₃)ₑ₃-*' is a single bond,
Z₁₁ to Z₁₃ may each independently be *-Si(Ar₁₁)(Ar₁₂)(Ar₁₃), a C₅-C₃₀ carbocyclic group unsubstituted or substituted with at least one R₀, or a C₂-C₃₀ heterocyclic group unsubstituted or substituted with at least one R₀,
Ar₁, Ar₂, Ar₁₁, Ar₁₂, and Ar₁₃ may each independently be a C₅-C₃₀ carbocyclic group unsubstituted or substituted with at least one R₀, or a C₂-C₃₀ heterocyclic group unsubstituted or substituted with at least one R₀.
R₀ and Z₁₄ to Z₁₆ may each independently be:
   deuterium, a C₁-C₆₀ alkyl group, or a deuterated C₁-C₆₀ alkyl group; or
   a C₅-C₃₀ carbocyclic group or a C₂-C₃₀ heterocyclic group, each unsubstituted or substituted with deuterium, a C₁-C₆₀ alkyl group, a deuterated C₁-C₆₀ alkyl group, a C₅-C₃₀ carbocyclic group, a C₂-C₃₀ heterocyclic group, or a combination thereof.

For example, at least two of X₄ to X₆ in Formula 2 may be N.

As another example, each of X₄, X₅, and X₆ in Formula 2 may be N.

According to an embodiment, Z₁, Z₂, and Z₃ may each independently be *-Si(Ar₁)(Ar₂)-*', a benzene group unsubstituted or substituted with at least one R₀, or a carbazole group unsubstituted or substituted with at least one R₀.

According to one or more embodiments, Z₁, Z₂, and Z₃ may each independently be a group represented by one of Formulae 2(1) to 2(3): 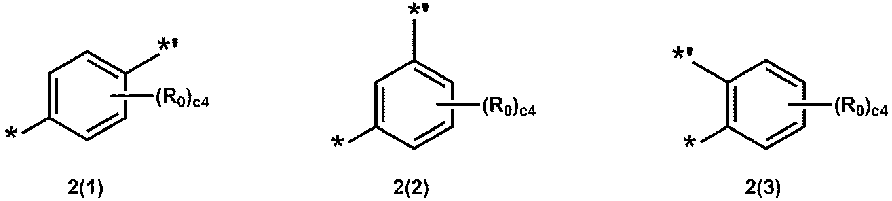 In Formulae 2(1) to 2(3),
R₀ will be described in detail later,
c4 is an integer from 0 to 4, and
* and *' are each a binding site to a neighboring atom.

According to one or more embodiments, Z₁, Z₂, and Z₃ may each independently be a group represented by one of Formulae 2(2) and 2(3).

According to one or more embodiments, in Formula 2,
i) e1 may be 1, 2 or 3 and each of e2 and e3 may be 0, or
ii) e1 and e2 may each independently be 1, 2, or 3 and e3 may be 0, or
iii) e1, e2, and e3 may each independently be 1, 2, or 3.

According to one or more embodiments, Z₁₁, Z₁₂, and Z₁₃ may each independently be:
*-Si(Ar₁₁)(Ar₁₂)(Ar₁₃); or
a phenyl group or an N-carbazolyl group, each unsubstituted or substituted with deuterium, a C₁-C₂₀ alkyl group, a phenyl group, an N-carbazolyl group, or a combination thereof.

According to one or more embodiments, at least one of Z₁₁, Z₁₂, and Z₁₃ may each independently be:
*-Si(Ar₁₁)(Ar₁₂)(Ar₁₃); or
an N-carbazolyl group which is unsubstituted or substituted with deuterium, a C₁-C₂₀ alkyl group, a phenyl group, an N-carbazolyl group, or a combination thereof.

According to one or more embodiments, at least one of Z₁₁, Z₁₂, and Z₁₃ may be *-Si(Ar₁₁)(Ar₁₂)(Ar₁₃), or a group represented by Formula 2-CZ: 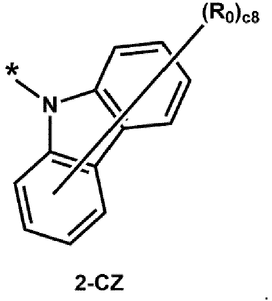 In Formula 2-CZ,
R₀ will be described in detail later, and
c8 may be an integer from 0 to 8, and
* indicates a binding site to a neighboring atom.

According to one or more embodiments, in Formula 2,
i) each of Z₁₁, Z₁₂ and Z₁₃ may be the same as each other, or
ii) Z₁₁ and Z₁₂ may be different from each other, and Z₁₂ and Z₁₃ may be the same as each other, or
iii) Z₁₁, Z₁₂ and Z₁₃ may be different from each other.

According to one or more embodiments, Ar₁, Ar₂, Ar₁₁, Ar₁₂, andAr₁₃ may each independently be a phenyl group which is unsubstituted or substituted with deuterium, a C₁-C₂₀ alkyl group, a phenyl group, an N-carbazolyl group, or a combination thereof.

According to one or more embodiments, R₀ and Z₁₄, Z₁₅, and Z₁₆ may each independently be:
deuterium, a C₁-C₂₀ alkyl group, or a deuterated C₁-C₂₀ alkyl group; or
a phenyl group or an N-carbazolyl group, each unsubstituted or substituted with deuterium, a C₁-C₂₀ alkyl group, a phenyl group, an N-carbazolyl group, or a combination thereof.

According to one or more embodiments, the second compound may be a compound represented by Formula 2-1 or 2-2: 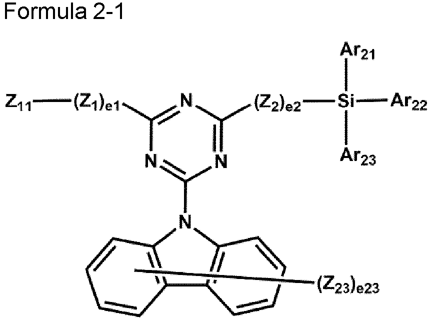 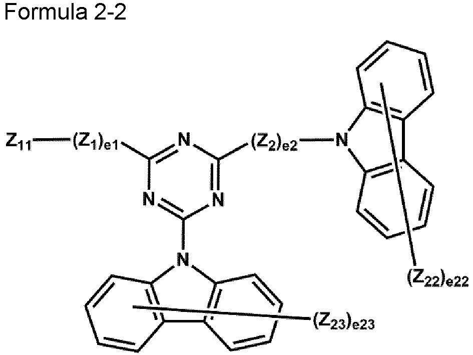 wherein, in Formulae 2-1 and 2-2,
the description of each of Z₁, Z₂, e1, e2 and Z₁₁ is the same as provided herein,
each of Z₂₂ and Z₂₃ is the same as described in connection with R₀ in the present specification,
e23 and e22 may each independently be an integer from 0 to 8, and
Ar₂₁, Ar₂₂, and Ar₂₃ are the same as described in connection with Ar₁₁, Ar₁₂, and Ar₁₃ in the present specification, respectively.

According to one or more embodiments, e2 in Formula 2-1 may not be 0.

According to one or more embodiments, the second compound is represented by Formulae 2-1 or 2-2, and may satisfy at least one of Condition 11, Condition 12, or Condition 13:
Condition 11
   Z₁₁ in Formulae 2-1 and 2-2 is a phenyl group or an N-carbazolyl group, each unsubstituted or substituted with deuterium, a C₁-C₂₀ alkyl group, a phenyl group, an N-carbazolyl group, or a combination thereof.
Condition 12
   Z₁₁ in Formulae 2-1 and 2-2 is *-Si(Ar₁₁)(Ar₁₂)(Ar₁₃).
Condition 13
   Z₁ and Z₂ in Formulae 2-1 and 2-2 may each independently be an o-phenylene group or an m-phenylene group, each unsubstituted or substituted with deuterium, a C₁-C₂₀ alkyl group, a phenyl group, an N-carbazolyl group, or a combination thereof.

According to one or more embodiments, the second compound may satisfy at least one of Condition 14 and Condition 15:
Condition 14
   The second compound includes at least one deuterium.
Condition 15
   The second compound includes at least one tert-butyl group

### Specific examples of second compound

According to an embodiment, the second compound may be selected from Compounds E1 to E47 and deuterium-containing derivatives thereof:

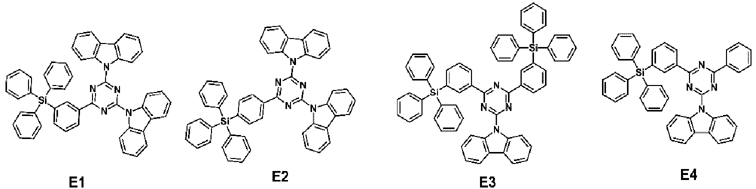

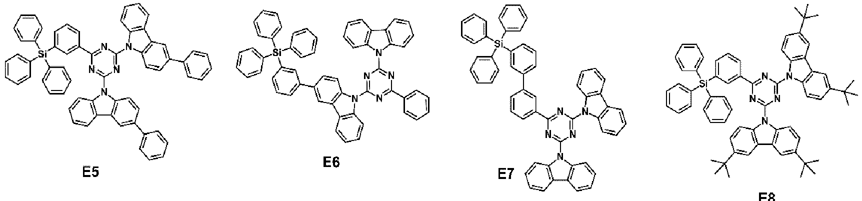

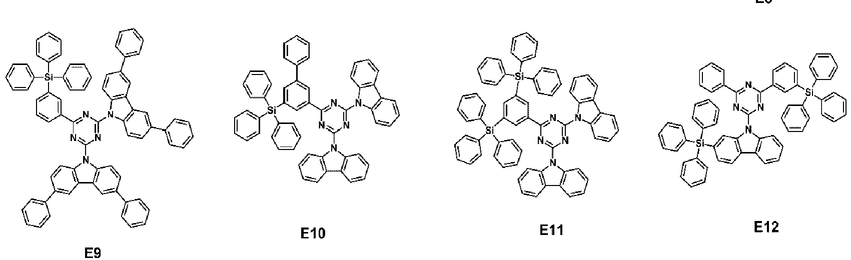

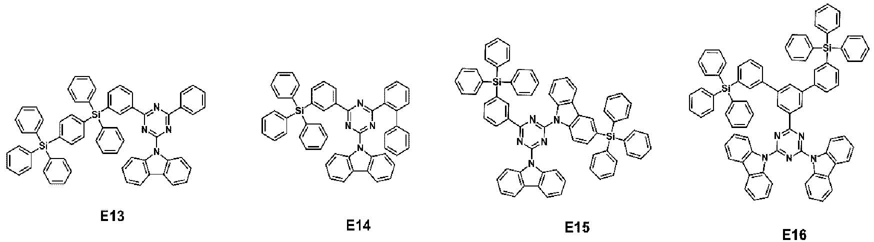

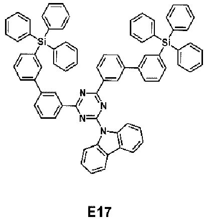

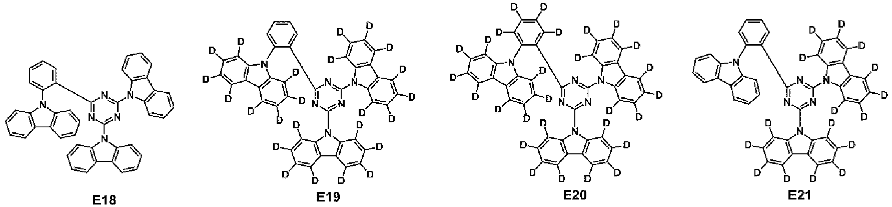

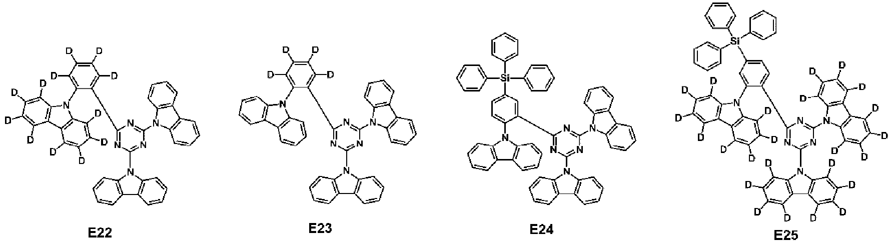

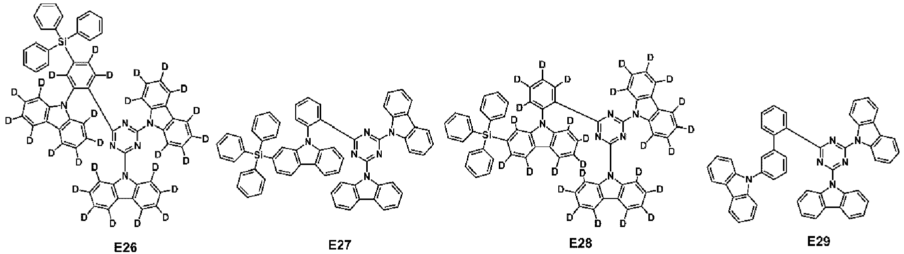

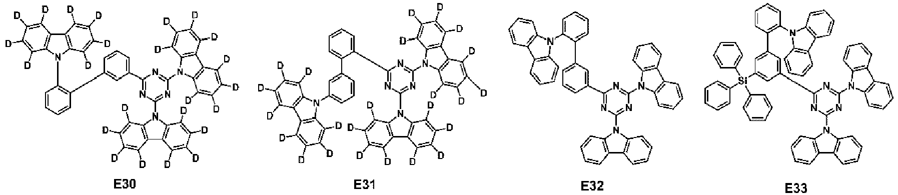

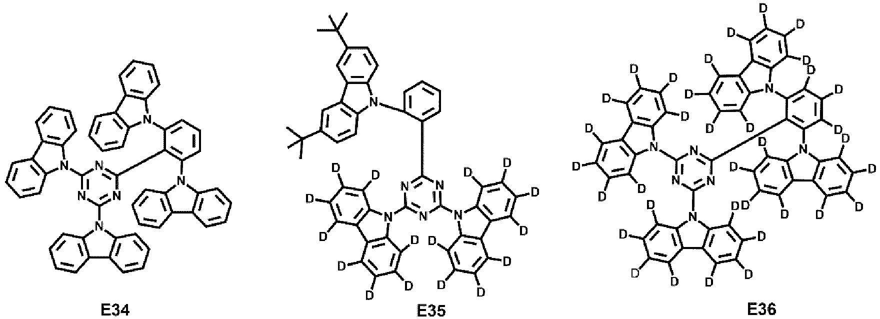

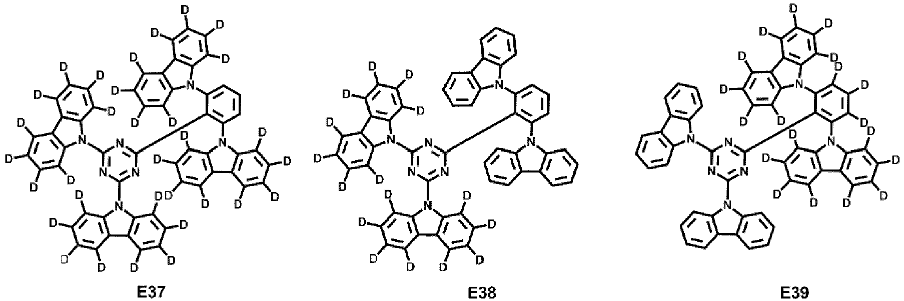

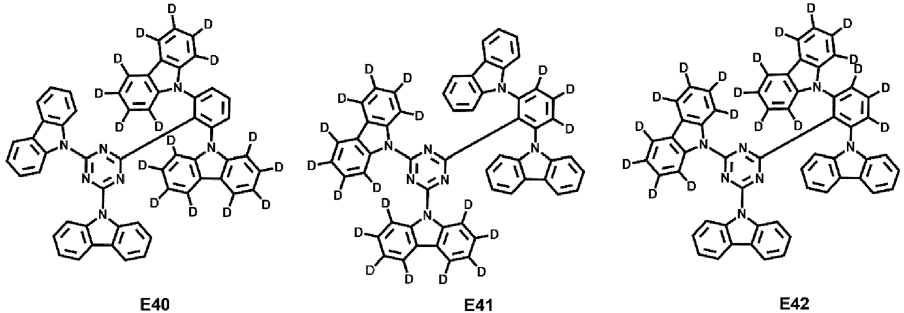

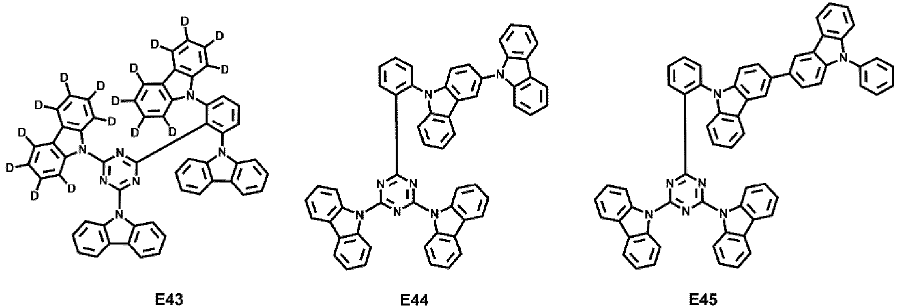

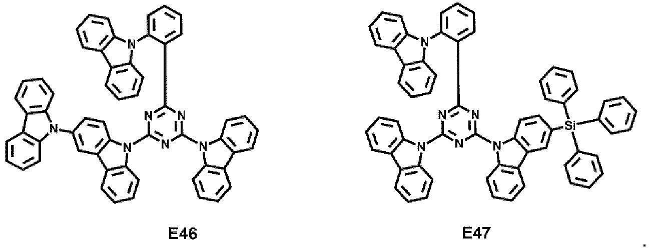

### Description of Formula 3

The organometallic compound included in the emission layer in the present specification may be an organometallic compound represented by Formula 3: 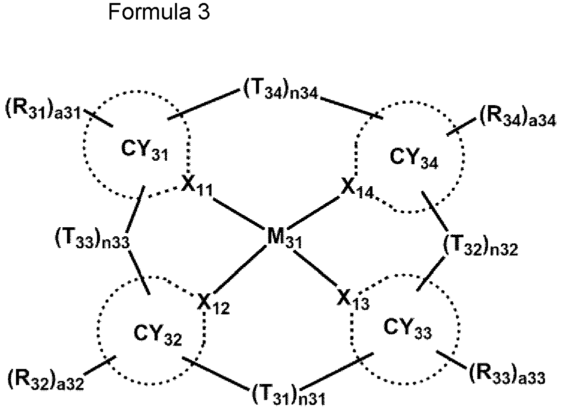 wherein, in Formula 3,
M₃₁ may be a transition metal,
X₁₁ to X₁₄ may each independently be C or N,
two bonds of a bond between X₁₁ and M₃₁, a bond between X₁₂ and M₃₁, a bond between X₁₃ and M₃₁, or a bond between X₁₄ and M₃₁ may be a coordinate bond, and the remaining two bonds may be a covalent bond,
ring CY₃₁ to ring CY₃₄ may each independently be a C₅-C₃₀ carbocyclic group or a C₁-C₃₀ heterocyclic group,
T₃₁ may be a single bond, a double bond, *-N(R₃₅ₐ)-*', *-B(R₃₅ₐ)-*', *-P(R₃₅ₐ)-*', *-C(R₃₅ₐ)(R_{35b})-*', *-Si(R₃₅ₐ)(R_{35b})-*', *-Ge(R₃₅ₐ)(R_{35b})-*', *-S-*', *-Se-*', *-O-*', *-C(=O)-*', *-S(=O)-*', *-S(=O)₂-*', *-C(R₃₅ₐ)=*', *=C(R₃₅ₐ)-*', *-C(R₃₅ₐ)=C(R_{35b})-*', *-C(=S)-*', *-C=C-*', a C₅-C₃₀ carbocyclic group unsubstituted or substituted with at least one R₁₀ₐ, or a C₁-C₃₀ heterocyclic group unsubstituted or substituted with at least one R₁₀ₐ,
T₃₂ may be a single bond, a double bond, *-N(R₃₆ₐ)-*', *-B(R₃₆ₐ)-*', *-P(R₃₆ₐ)-*', *-C(R₃₆ₐ)(R_{36b})-*', *-Si(R₃₆ₐ)(R_{36b})-*', *-Ge(R₃₆ₐ)(R_{36b})-*', *-S-*', *-Se-*', *-O-*', *-C(=O)-*', *-S(=O)-*', *-S(=O)₂-*', *-C(R₃₆ₐ)=*', *=C(R₃₆ₐ)-*', *-C(R₃₆ₐ)=C(R_{36b})-*', *-C(=S)-*', *-C=C-*', a C₅-C₃₀ carbocyclic group unsubstituted or substituted with at least one R₁₀ₐ, or a C₁-C₃₀ heterocyclic group unsubstituted or substituted with at least one R₁₀ₐ,
T₃₃ may be a single bond, a double bond, *-N(R₃₇ₐ)-*', *-B(R₃₇ₐ)-*', *-P(R₃₇ₐ)-*', *-C(R₃₇ₐ)(R_{37b})-*', *-Si(R₃₇ₐ)(R_{37b})-*', *-Ge(R₃₇ₐ)(R_{37b})-*', *-S-*', *-Se-*', *-O-*', *-C(=O)-*', *-S(=O)-*', *-S(=O)₂-*', *-C(R₃₇ₐ)=*', *=C(R₃₇ₐ)-*', *-C(R₃₇ₐ)=C(R_{37b})-*', *-C(=S)-*', *-C=C-*', a C₅-C₃₀ carbocyclic group unsubstituted or substituted with at least one R₁₀ₐ, or a C₁-C₃₀ heterocyclic group unsubstituted or substituted with at least one R₁₀ₐ,
T₃₄ may be a single bond, a double bond, *-N(R₃₈ₐ)-*', *-B(R₃₈ₐ)-*', *-P(R₃₈ₐ)-*', *-C(R₃₈ₐ)(R_{38b})-*', *-Si(R₃₈ₐ)(R_{38b})-*', *-Ge(R₃₈ₐ)(R_{38b})-*', *-S-*', *-Se-*', *-O-*', *-C(=O)-*', *-S(=O)-*', *-S(=O)₂-*', *-C(R₃₈ₐ)=*', *=C(R₃₈ₐ)-*', *-C(R₃₈ₐ)=C(R_{38b})-*', *-C(=S)-*', *-C=C-*', a C₅-C₃₀ carbocyclic group unsubstituted or substituted with at least one R₁₀ₐ, or a C₁-C₃₀ heterocyclic group unsubstituted or substituted with at least one R10a,
n31 to n34 may each independently be an integer from 0 to 5, and three or more of n31 to n34 may each independently be an integer from 1 to 5,
when n31 is 0, T₃₁ is absent, when n32 is 0, T₃₂ is absent, when n33 is 0, T₃₃ is absent, or when n34 is 0, T₃₄ is absent,
when n31 is 2 or more, two or more of T₃₁(s) may be identical to or different from each other, when n32 is 2 or more, two or more of T₃₂(s) may be identical to or different from each other, when n33 is 2 or more, two or more of T₃₃(s) may be identical to or different from each other, and when n34 is 2 or more, two or more of T₃₄(s) may be identical to or different from each other,
R₃₁ to R₃₄, R₃₅ₐ, R_{35b}, R₃₆ₐ, R_{36b}, R₃₇ₐ, R_{37b}, R₃₈ₐ, and R_{38b} may each independently be hydrogen, deuterium, -F, -Cl, -Br, -I, -CD₃, -CD₂H, -CDH₂, -CF₃, -CF₂H, -CFH₂, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ heteroaryl alkyl group, a substituted or unsubstituted monovalent non-aromatic condensed polycyclic group, a substituted or unsubstituted monovalent non-aromatic condensed heteropolycyclic group, -N(Q₁)(Q₂), - Si(Q₃)(Q₄)(Q₅), -Ge(Q₃)(Q₄)(Q₅), -B(Q₆)(Q₇), -P(=O)(Q₈)(Q₉), or -P(Q₈)(Q₉),
a31 to a34 may each independently be an integer from 0 to 20,
two or more of R₃₁(s) in the number of a31 may optionally be bonded to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₃₂(s) in the number of a32 may optionally be bonded to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₃₃(s) in the number of a33 may optionally be bonded to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₃₄(s) in the number of a34 may optionally be bonded to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₃₁, R₃₂, R₃₃, R₃₄, R₃₅ₐ, R_{35b}, R₃₆ₐ, R_{36b}, R₃₇ₐ, R_{37b}, R₃₈ₐ, and R_{38b} may optionally be bonded to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀ₐ is the same as described in connection with R₃₁, and
* and *' each indicate a binding site to a neighboring atom, and the term "substituted" is as defined herein.

According to an embodiment, M₃₁ in Formula 3 may be Pt, Pd, or Au.

According to one or more embodiments, M₃₁ in Formula 3 may be Pt or Pd.

According to one or more embodiments, the bond between X₁₁ and M₃₁ in Formula 3 may be a coordinate bond.

In one or more embodiments, in Formula 3, X₁₁ may be C, and a bond between X₁₁ and M₃₁ may be a coordinate bond. That is, X₁₁ in Formula 3 may be C in a carbene moiety.

In one or more embodiments, ring CY₃₁ to ring CY₃₄ in Formula 3 may each independently be i) a first ring, ii) a second ring, iii) a condensed ring in which two or more first rings are condensed with each other, iv) a condensed ring in which two or more second rings are condensed with each other, or v) a condensed ring in which at least one first ring is condensed with at least one second ring,
wherein the first ring may be a cyclopentane group, a cyclopentadiene group, a furan group, a thiophene group, a pyrrole group, a silole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, a triazine group, an oxazine group, a thiazine group, a dihydropyrazine group, a dihydropyridine group, or a dihydroazasilinane group.

According to one or more embodiments, ring CY₃₁ in Formula 3 may be an imidazole group, a benzimidazole group, a naphthoimidazole group, or a pyridoimidazole group.

According to one or more embodiments, rings CY₃₂ and CY₃₄ in Formula 3 may each independently be a benzene group, a naphthalene group, a pyridine group, a pyrimidine group, a pyridazine group, a pyrazine group, a quinoline group, an isoquinoline group, a benzene group to which an adamantane group is condensed, or a benzene group to which a norbornane group is condensed.

According to one or more embodiments, ring CY₃₃ in Formula 3 may be a benzene group, a naphthalene group, a pyridine group, a pyrimidine group, a pyridazine group, a pyrazine group, a benzene group to which an adamantane group is condensed, a benzene group to which a norbornane group is condensed, a carbazole group, a dibenzofuran group, a dibenzothiophene group, a benzocarbazole group, a naphthocarbazole group, an azacarbazole group, an azadibenzofuran group, an azadibenzothiophene group, an azabenzocarbazole group, or an azanaphthocarbazole group.

According to one or more embodiments, T₃₁ in Formula 3 may be *-S-*' or *-O-*'.

According to one or more embodiments, each of T₃₂ and T₃₃ in Formula 3 may be a single bond.

According to one or more embodiments, in Formula 3, X₁₁, X₁₂, and X₁₃ may be C, and X₁₄ may be N.

According to an embodiment, R₃₁ to R₃₄, R₃₅ₐ, R_{35b}, R₃₆ₐ, R_{36b}, R₃₇ₐ, R_{37b}, R₃₈ₐ, and R_{38b} may each independently be:
hydrogen, deuterium, -F, -Cl, -Br, -I, -CD₃, -CD₂H, -CDH₂, -CF₃, -CF₂H, -CFH₂, a cyano group (CN), a nitro group, an amino group, a C₁-C₂₀ alkyl group, or a C₁-C₂₀ alkoxy group;
a C₁-C₂₀ alkyl group or a C₁-C₂₀ alkoxy group, each substituted with at least one of deuterium, -F, -Cl, -Br, -I, -CD₃, -CD₂H, -CDH₂, -CF₃, -CF₂H, -CFH₂, a cyano group (CN), a nitro group, an amino group, and a phenyl group; or
a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, or an anthracenyl group, each unsubstituted or substituted with at least one of deuterium, -F, -Cl, -Br, -I, -CD₃, -CD₂H, -CDH₂, -CF₃, -CF₂H, -CFH₂, a cyano group (CN), a nitro group, an amino group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, and an anthracenyl group.

According to an embodiment, the organometallic compound represented by Formula 3 may be an organometallic compound represented by Formula 3-1 or an organometallic compound represented by Formula 3-2:

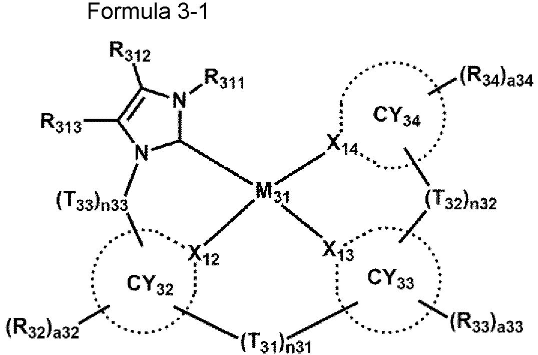

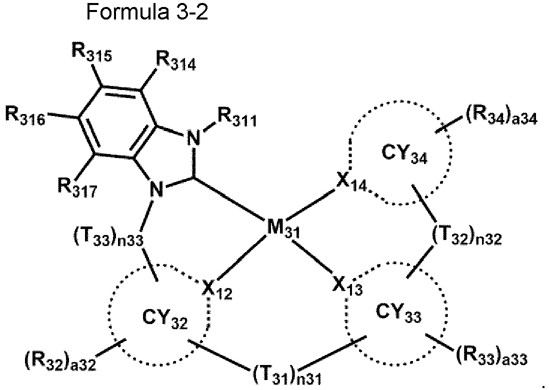

In Formula 3-1, the bond between the carbon of the imidazole group and M₃₁ may be a coordinate bond. That is, the imidazole group in Formula 3-1 may include a carbene moiety bonded to M₃₁.

In Formula 3-2, the bond between the carbon of the benzimidazole group and M₃₁ may be a coordinate bond. That is, the benzimidazole group in Formula 3-2 may include a carbene moiety bonded to M₃₁.

Therefore, Formula 3-1' in which the carbon bonded to M₃₁ in the imidazole group is carbene, is the same as Formula 3-1, and Formula 3-2' in which the carbon bonded to M₃₁ in the benzimidazole group is carbene, is the same as Formula 3-2: 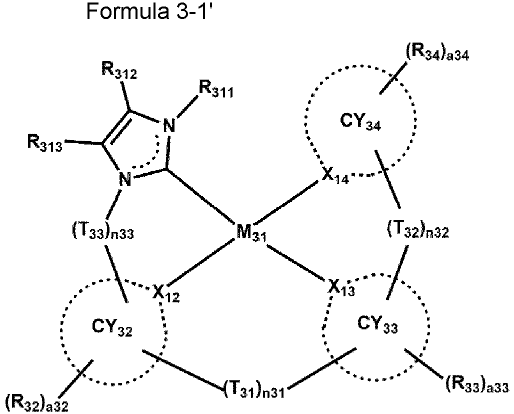 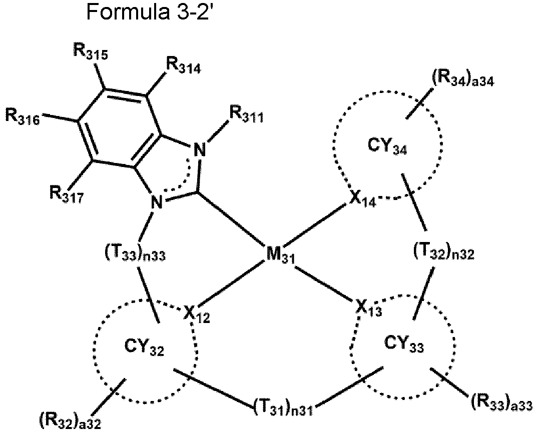 wherein, in Formulae 3-1 and 3-2,
M₃₁, CY₃₂, CY₃₃, CY₃₄, X₁₂, X₁₃, X₁₄, T₃₁, T₃₂, T₃₃, n31, n32, n33, R₃₂, R₃₃, R₃₄, a32, a33, and a34 are each the same as described herein, and
each of R₃₁₁ to R₃₁₇ is the same as described in connection with R₃₁. In an embodiment, in Formulae 3-1 and 3-2,
R₃₁₁ to R₃₁₇ may each independently be:
   hydrogen, deuterium, -F, -Cl, -Br, -I, -CD₃, -CD₂H, -CDH₂, -CF₃, -CF₂H, -CFH₂, -SF₅, a hydroxyl group, a cyano group, a nitro group, an amidino group, a hydrazine group, a hydrazone group, a carboxylic acid group or a salt thereof, a sulfonic acid group or a salt thereof, or a phosphoric acid group or a salt thereof;
   a C₁-C₂₀ alkyl group or a C₁-C₂₀ alkoxy group, each unsubstituted or substituted with deuterium, -F, -Cl, -Br, -I, -CD₃, -CD₂H, -CDH₂, -CF₃, -CF₂H, -CFH₂, - SF₅, a hydroxyl group, a cyano group, a nitro group, an amidino group, a hydrazine group, a hydrazone group, or a combination thereof;
   a C₃-C₁₀ cycloalkyl group, a C₁-C₁₀ heterocycloalkyl group, a C₆-C₆₀ aryl group, a C₇-C₆₀ arylalkyl group, a C₆-C₆₀ aryloxy group, a C₆-C₆₀ arylthio group, a C₁-C₆₀ heteroaryl group, a C₂-C₆₀ heteroaryl alkyl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, -SF₅, a hydroxyl group, a cyano group, a nitro group, an amidino group, a hydrazine group, a hydrazone group, a C₁-C₂₀ alkyl group, a C₁-C₂₀ alkoxy group, or a combination thereof;
   -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or-P(Q₈)(Q₉).

For example, in Formulae 3-1 and 3-2,
at least one of R₃₁₁ to R₃₁₇ may be
a C₁-C₂₀ alkyl group, a C₆-C₆₀ aryl group, or a C₇-C₆₀ arylalkyl group, each unsubstituted or substituted with at least one of a methyl group, an ethyl group, an n-propyl group, an isopropyl group, an n-butyl group, an isobutyl group, a sec-butyl group, a tert-butyl group, a phenyl group, a cumyl group, or a combination thereof.

According to an embodiment, the organometallic compound represented by Formula 3 may be an organometallic compound represented by Formula 3-1(1) or an organometallic compound represented by Formula 3-2(1): 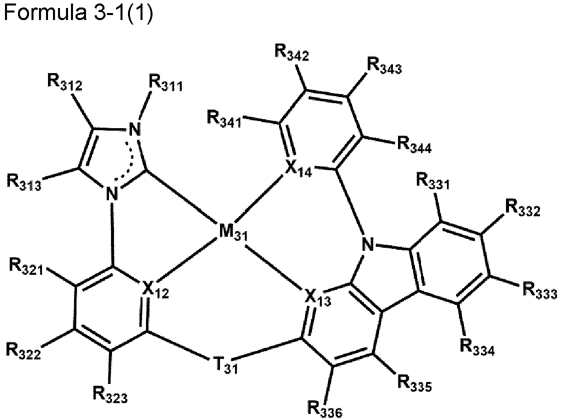 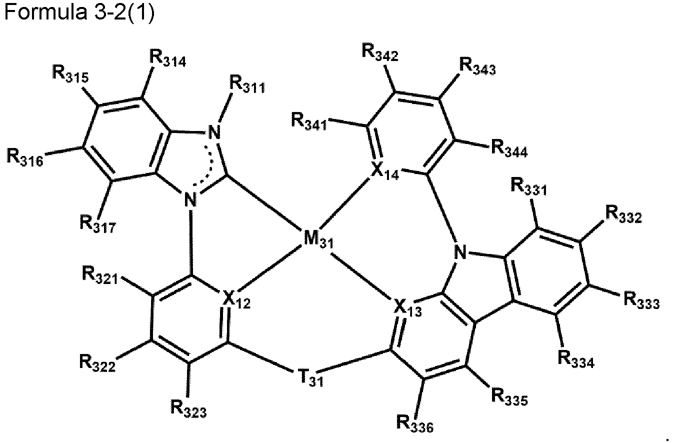 In Formulae 3-1(1) and 3-2(1),
M₃₁, X₁₂, X₁₃, X₁₄, and T₃₁ are each the same as described herein,
R₃₁₁ to R₃₁₇ may each be the same as described in connection with R₃₁,
R₃₂₁, R₃₂₂, and R₃₂₃ may each be the same as described in connection with R₃₂, and two or more of R₃₂₁, R₃₂₂, or R₃₂₃ may optionally be bonded together to form a C₅-C₃₀ carbocyclic group unsubstituted or substituted with at least one R₁₀ₐ or a C₁-C₃₀ heterocyclic group unsubstituted or substituted with at least one R₁₀ₐ,

R₃₃₁ to R₃₃₆ may each be the same as described in connection with R₃₃, and two or more of R₃₃₁ to R₃₃₆ may optionally be bonded together to form a C₅-C₃₀ carbocyclic group unsubstituted or substituted with at least one R₁₀ₐ or a C₁-C₃₀ heterocyclic group unsubstituted or substituted with at least one R₁₀ₐ, and
R₃₄₁ to R₃₄₄ may each be the same as described in connection with R₃₄, and two or more of R₃₄₁ to R₃₄₄ may optionally be bonded together to form a C₅-C₃₀ carbocyclic group unsubstituted or substituted with at least one R₁₀ₐ or a C₁-C₃₀ heterocyclic group unsubstituted or substituted with at least one R₁₀ₐ. R₁₀ₐ is as described herein.

### Description of Formula 5

The organometallic compound included in the emission layer in the present specification may be an organometallic compound represented by Formula 5:

Formula 5 M₅₁(L₅₁)ₙ₅₁(L₅₂)ₙ₅₂.

M₅₁ in Formula 5 may be a transition metal.

In an embodiment, M₅₁ may be a first-row transition metal, a second-row transition metal, or a third-row transition metal of the Periodic Table of Elements.

In one or more embodiments, M₅₁ may be iridium (Ir), platinum (Pt), osmium (Os), titanium (Ti), zirconium (Zr), hafnium (Hf), europium (Eu), terbium (Tb), thulium (Tm), or rhodium (Rh).

In one or more embodiments, M₅₁ may be Ir, Pt, Os, or Rh.

According to one or more embodiments, M₅₁ may be Ir or Os.

In Formula 5, L₅₁ may be a ligand represented by Formula 5A, and L₅₂ may be a ligand represented by Formula 5B: 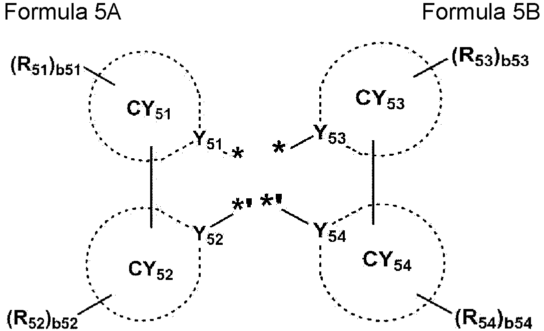
wherein Formulae 5A and 5B are each the same as described in the present specification.
n51 in Formula 5 may be 1, 2, or 3, wherein, when n51 is 2 or more, two or more of L₅₁(s) may be identical to or different from each other.
n52 in Formula 5 may be 0, 1, or 2, wherein, when n52 is 2, two L₅₂(s) may be identical to or different from each other.

The sum of n51 and n52 in Formula 5 may be 2 or 3. For example, the sum of n51 and n52 may be 3.

In an embodiment, in Formula 5, i) M may be Ir, and n51+n52=3; or ii) M may be Pt, and n51+n52=2.

In one or more embodiments, in Formula 5, M may be Ir, and i) n51 may be 1, and n52 may be 2, or ii) n51 may be 2, and n52 may be 1.

L₅₁ and L₅₂ in Formula 5 may be different from each other.

Y₅₁ to Y₅₄ in Formulae 5A to 5B may each independently be C or N. For example, Y₅₁ and Y₅₃ may each be N, and Y₅₂ and Y₅₄ may each be C.

Ring CY₅₁ to ring CY₅₄ in Formulae 5A and 5B may each independently be a C₅-C₃₀ carbocyclic group or a C₁-C₃₀ heterocyclic group.

For example, ring CY₅₁ to ring CY₅₄ in Formulae 5A and 5B may each independently include i) a third ring, ii) a fourth ring, iii) a condensed ring in which two or more third rings are condensed with each other, iv) a condensed ring in which two or more fourth rings are condensed with each other, or v) a condensed ring in which at least one third ring is condensed with at least one fourth ring,
wherein the third ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the fourth ring may be an adamantane group, a norbornane group, a norbornene group, a cyclohexane group, a cyclohexene group, a benzene group, a pyridine group, a pyrimidine group, a pyrazine group, a pyridazine group, or a triazine group.

In some embodiments, ring CY₁ to ring CY₄ in Formulae 5A and 5B may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluorene-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an isooxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinooxazole group, a pyrimidinoisoxazole group, a pyrimidinothiazole group, a pyrimidinoisothiazole group, a pyrimidinooxadiazole group, a pyrimidinothiadiazole group, a 5,6,7,8-tetrahydroisoquinoline group, a 5,6,7,8-tetrahydroquinoline group, an adamantane group, a norbornane group, a norbornene group, a benzene group condensed with a cyclohexane group, a benzene group condensed with a norbornane group, a pyridine group condensed with a cyclohexane group, or a pyridine group condensed with a norbornane group.

In one or more embodiments, ring CY₅₁ and ring CY₅₃ in Formulae 5A and 5B may be different from each other.

In one or more embodiments, ring CY₅₂ and ring CY₅₄ in Formulae 5A and 5B may be different from each other.

In one or more embodiments, ring CY₅₁ to ring CY₅₄ in Formulae 5A and 5B may be different from each other.

In one or more embodiments, R₅₁ to R₅₄ in Formulae 5A and 5B may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₅₁)(Q₅₂), -Si(Q₅₃)(Q₅₄)(Q₅₅), -Ge(Q₅₃)(Q₅₄)(Q₅₅), -B(Q₅₆)(Q₅₇), - P(=O)(Q₅₈)(Q₅₉), or -P(Q₅₈)(Q₅₉). Q₅₁ to Q₅₉ are each the same as described in the present specification.

In an embodiment, R₅₁ to R₅₄ in Formulae 5A and 5B may each independently be:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a (phenyl)C₁-C₁₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
-N(Q₅₁)(Q₅₂), -Si(Q₅₃)(Q₅₄)(Q₅₅), -Ge(Q₅₃)(Q₅₄)(Q₅₅), -B(Q₅₆)(Q₅₇), - P(=O)(Q₅₈)(Q₅₉), or -P(Q₅₈)(Q₅₉),
wherein Q₅₁ to Q₅₉ may each independently be:
   -CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or-CD₂CDH₂; or
   an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or a combination thereof.

In one or more embodiments, R₅₁ to R₅₄ may each independently be:
hydrogen, deuterium, -F, or a cyano group;
a C₁-C₂₀ alkyl group unsubstituted or substituted with deuterium, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or a combination thereof;
a C₃-C₁₀ cycloalkyl group, a C₁-C₁₀ heterocycloalkyl group, a phenyl group, or a biphenyl group, each unsubstituted or substituted with deuterium, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or a combination thereof; or
-Si(Q₅₃)(Q₅₄)(Q₅₅) or -Ge(Q₅₃)(Q₅₄)(Q₅₅).
b51 to b54 in Formulae 5A and 5B indicate the numbers of R₅₁ to R₅₄, respectively, and may each independently be an integer from 0 to 20. When b51 is 2 or more, two or more of R₅₁ may be identical to or different from each other, when b52 is 2 or more, two or more of R₅₂ may be identical to or different from each other, when b53 is 2 or more, two or more of R₅₃ may be identical to or different from each other, and when b54 is 2 or more, two or more of R₅₄ may be identical to or different from each other. For example, b51 to b54 may each independently be an integer from 0 to 8.

According to an embodiment, in Formula 5A, Y₅₂ may be C, the bond between Y₅₂ and M₅₁ may be a covalent bond, and at least one of b52 R₅₂ may be a cyano group or -F.

According to one or more embodiments, in Formula 5A, Y₅₁ may be N, the bond between Y₅₁ and M₅₁ may be a coordinate bond, CY₅₁ may be an imidazole group, a triazole group, a benzimidazole group, or a triazolopyridine group, and at least one of b52 R₅₂ may be a cyano group or -F.

According to one or more embodiments, in Formula 5A, Y₅₁ may be C, and the bond between Y₅₁ and M₅₁ may be a coordinate bond.

According to one or more embodiments, in Formula 5A, Y₅₁ may be C, the bond between Y₅₁ and M₅₁ may be a coordinate bond, and CY₅₁ may be a benzimidazole group or an imidazopyrazine group.

### Specific examples of organometallic compounds

According to an embodiment, the organometallic compound (for example, the organometallic compound represented by Formula 3 and the organometallic compound represented by Formula 5) included in the emission layer may be one of Compounds P1 to P52.

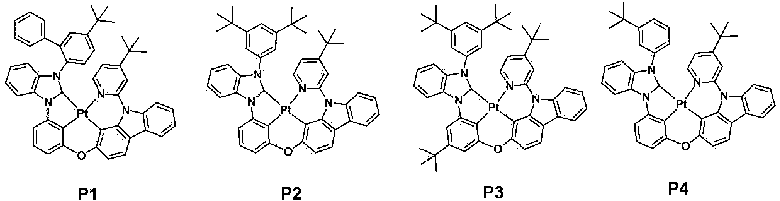

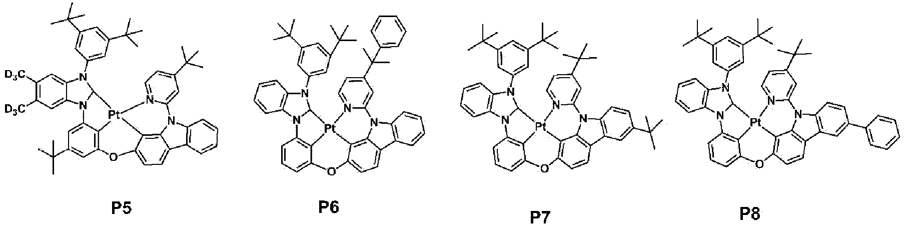

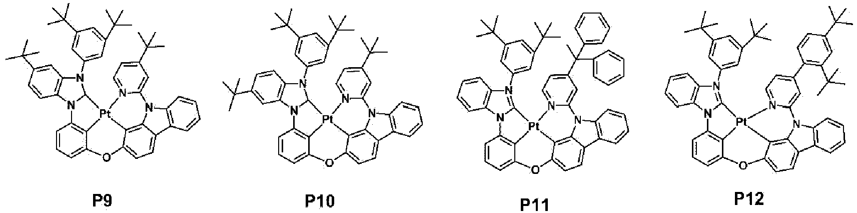

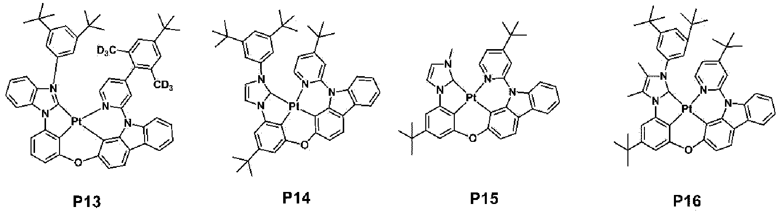

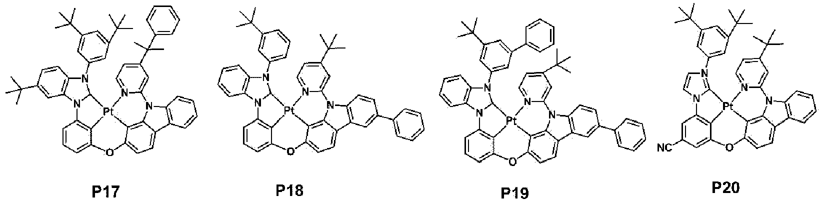

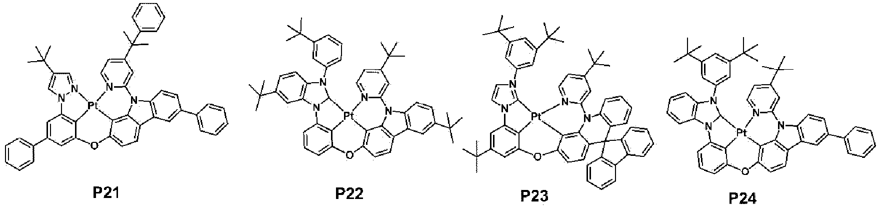

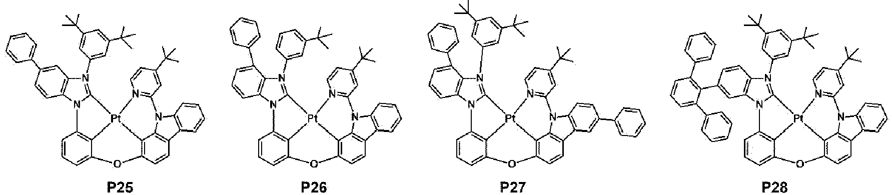

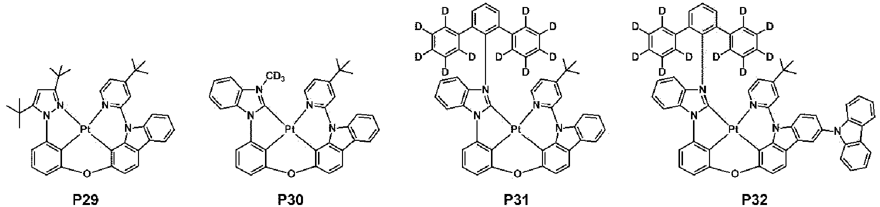

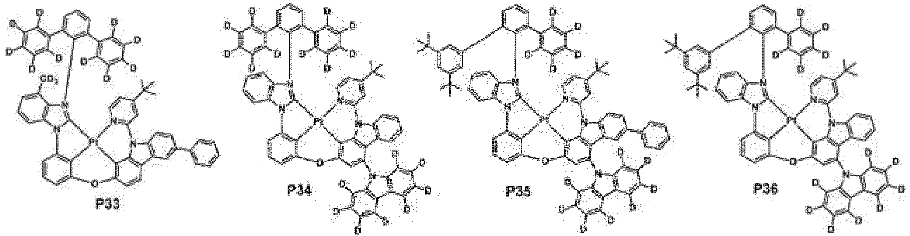

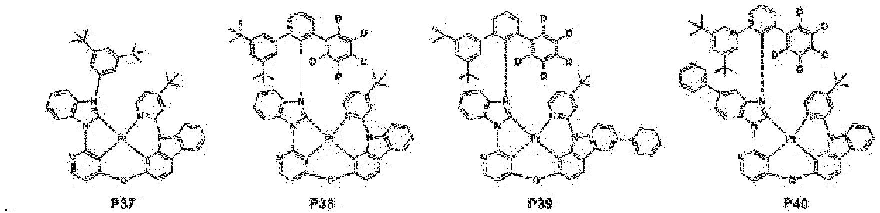

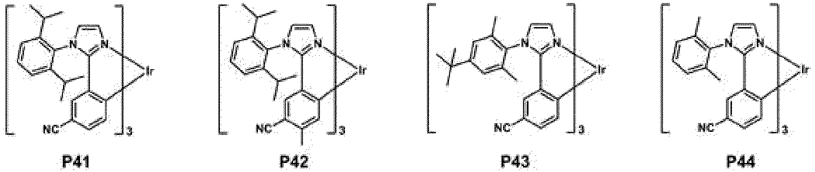

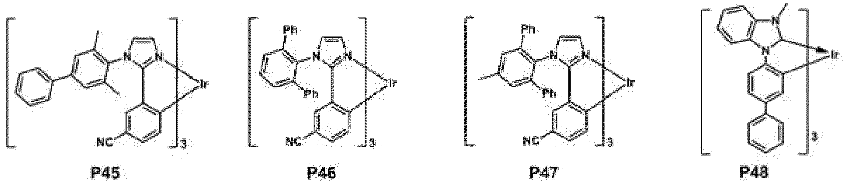

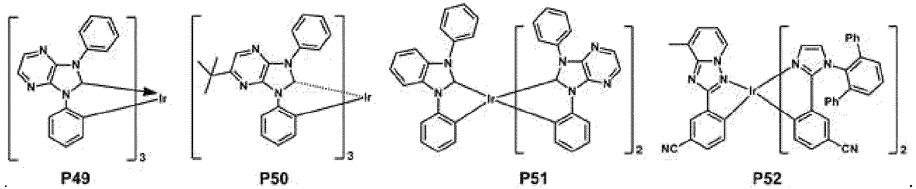

### Description of Formula 4

The thermally activated delayed fluorescent material that is included in the emission layer herein may be a polycyclic compound represented by Formula 4: 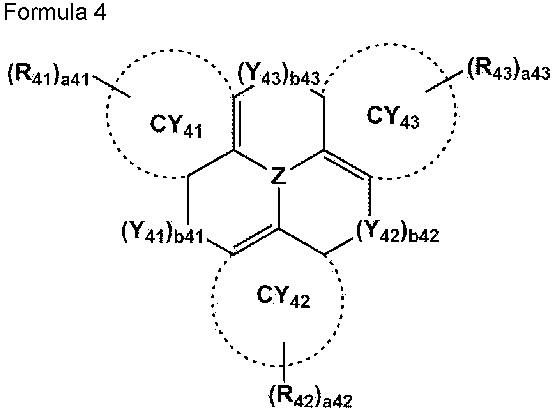 wherein, in Formula 4,
Z may be B or N,
ring CY₄₁ to ring CY₄₃ may each independently be a C₅-C₃₀ carbocyclic group or a C₁-C₃₀ heterocyclic group,
Y₄₁ may be a single bond, *-N(R₄₄)-*', *-B(R₄₄)-*', *-P(R₄₄)-*', *-C(R₄₄)(R₄₅)-*', *-Si(R₄₄)(R₄₅)-*', *-Ge(R₄₄)(R₄₅)-*', *-O-*', *-S-*', *-Se-*', *-C(=O)-*', or *-S(=O)₂-*',
Y₄₂ may be a single bond, *-N(R₄₆)-*', *-B(R₄₆)-*', *-P(R₄₆)-*', *-C(R₄₆)(R₄₇)-*', *-Si(R₄₆)(R₄₇)-*', *-Ge(R₄₆)(R₄₇)-*', *-O-*', *-S-*', *-Se-*', *-C(=O)-*', or *-S(=O)₂-*',
Y₄₃ may be a single bond, *-N(R₄₈)-*', *-B(R₄₈)-*', *-P(R₄₈)-*', *-C(R₄₈)(R₄₉)-*', *- Si(R₄₈)(R₄₉)-*', *-Ge(R₄₈)(R₄₉)-*', *-O-*', *-S-*', *-Se-*', *-C(= O)-*', or *-S(=O)₂-*',
b41 to b43 may each independently be 0 or 1, and
when b41 is 0, Y₄₁ is absent, when b42 is 0, Y₄₂ is absent, and when b43 is 0, Y₄₃ is absent,
R₄₁ to R₄₉ may each independently be hydrogen, deuterium, -F, -Cl, -Br, -I, - SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ heteroaryl alkyl group, a substituted or unsubstituted monovalent non-aromatic condensed polycyclic group, a substituted or unsubstituted monovalent non-aromatic condensed heteropolycyclic group, - N(Q₁)(Q₂), -Si(Q₃)(Q₄)(Q₅), -Ge(Q₃)(Q₄)(Q₅), -B(Q₆)(Q₇), -P(=O)(Q₈)(Q₉), or-P(Q₈)(Q₉),
a41 to a43 may each independently be an integer from 0 to 20,
two or more of R₄₁(s) in the number of a41 may optionally be bonded to each other to form a C₅-C₃₀ carbocyclic group unsubstituted or substituted with at least one R_{10b} or a C₁-C₃₀ heterocyclic group unsubstituted or substituted with at least one R_{10b},
two or more of R₄₂(s) in the number of a42 may optionally be bonded to each other to form a C₅-C₃₀ carbocyclic group unsubstituted or substituted with at least one R_{10b} or a C₁-C₃₀ heterocyclic group unsubstituted or substituted with at least one R_{10b},
two or more of R₄₃(s) in the number of a43 may optionally be bonded to each other to form a C₅-C₃₀ carbocyclic group unsubstituted or substituted with at least one R_{10b} or a C₁-C₃₀ heterocyclic group unsubstituted or substituted with at least one R_{10b},
two or more of R₄₁ to R₄₉ may optionally be bonded to each other to form a C₅-C₃₀ carbocyclic group unsubstituted or substituted with at least one R_{10b} or a C₁-C₃₀ heterocyclic group unsubstituted or substituted with at least one R_{10b},
R_{10b} is the same as described in connection with R₄₁,
*and *' each indicate a binding site to a neighboring atom.

As defined, a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ heteroaryl alkyl group, the substituted monovalent non-aromatic condensed polycyclic group, and the substituted monovalent non-aromatic condensed heteropolycyclic group may be:
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group,
a C₁-C₆₀ alkyl group, a C₂-C₆₀ alkenyl group, a C₂-C₆₀ alkynyl group, or a C₁-C₆₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -Ge(Q₁₃)(Q₁₄)(Q₁₅), - B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), -P(Q₂₈)(Q₂₉), or a combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
or a combination thereof, and
Q1 to Q9, Q11 to Q19, Q21 to Q29, and Q31 to Q39 may each independently be hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group which is unsubstituted or substituted with deuterium, a C₁-C₆₀ alkyl group, a C₆-C₆₀ aryl group, or a combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group which is unsubstituted or substituted with deuterium, a C₁-C₆₀ alkyl group, a C₆-C₆₀ aryl group, or a combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

According to an embodiment, the rings CY₄₁, CY₄₂, and CY₄₃ may each independently be i) a benzene group, or ii) a polycyclic group in which two or more C₃-C₆₀ cyclic groups are condensed with each other, and the condensed C₃-C₆₀ cyclic groups in the polycyclic group may share boron (B) or nitrogen (N).

According to one or more embodiments, at least one of b41, b42, or b43, or at least two of b41, b42, or b43, may each be 1. According to one or more embodiments, two of b41, b42, or b43 may be 1, and the remaining one may be 0.

According to one or more embodiments, R₄₁ to R₄₉ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₆₀ alkyl group or a C₁-C₆₀ alkoxy group, each substituted with at least one of deuterium, -F, -Cl, -Br, -I, a hydroxyl group, a cyano group, a nitro group, an amino group, a phenyl group, a biphenyl group, a naphthyl group, a fluorenyl group, a phenanthrenyl group, an anthracenyl group, a fluoranthenyl group, a triphenylenyl group, a pyrenyl group, and a chrysenyl group; or
a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, or a carbazolyl group, each unsubstituted or substituted with at least one of deuterium, -F, -Cl, -Br, -I, a hydroxyl group, a cyano group, a nitro group, an amino group, a C₁-C₆₀ alkyl group, a C₁-C₆₀ alkoxy group, a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, or a carbazolyl group.

According to one or more embodiments, the polycyclic compound represented by Formula 4 may be a polycyclic compound represented by one of Formulae 4-1 to 4-9: 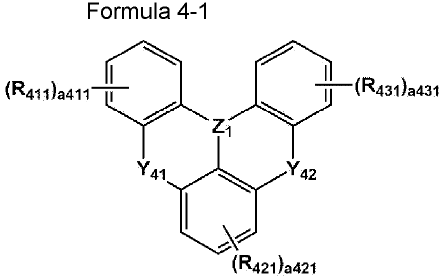 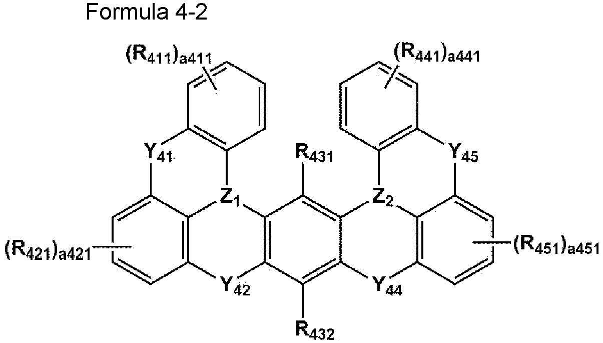 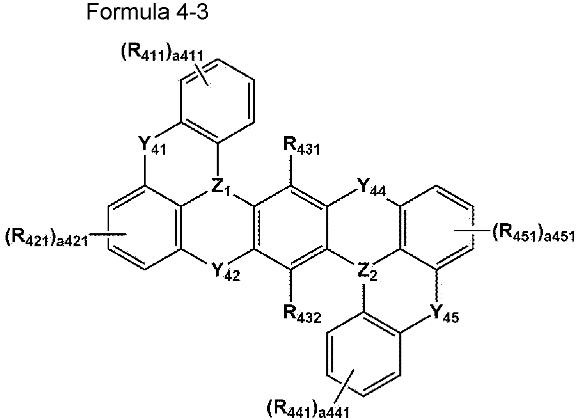 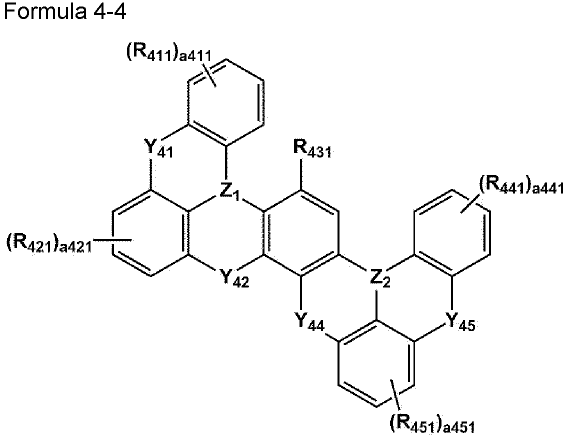 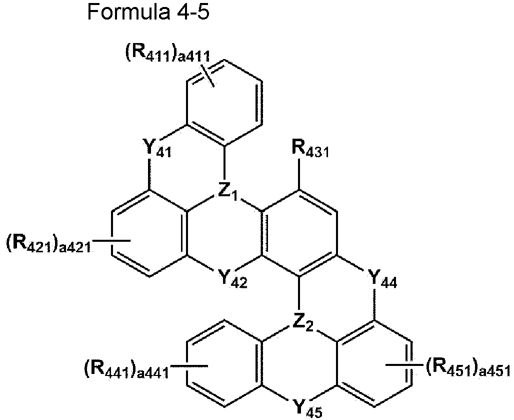 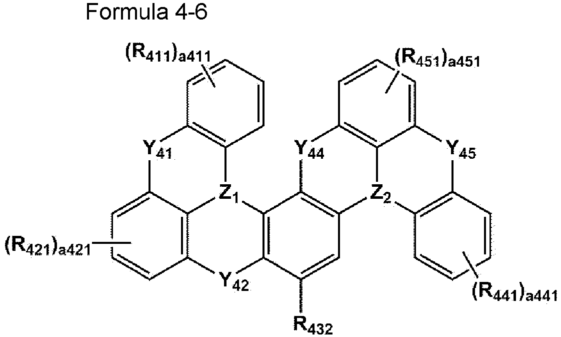 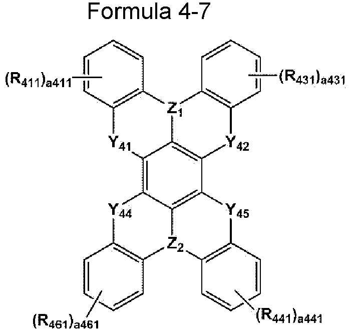 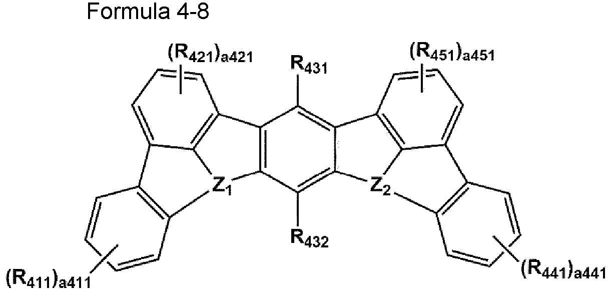 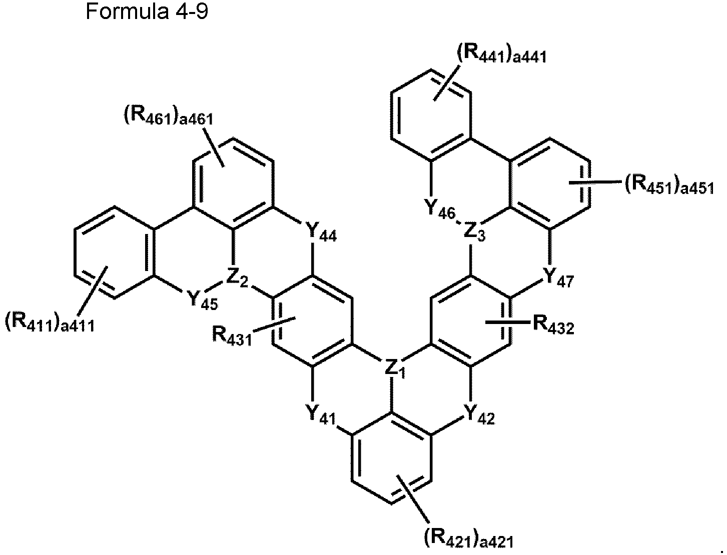 In Formulae 4-1 to 4-9,
Z₁, Z₂, and Z₃ may be B or N,
Y₄₁ and Y₄₂ are as described in the present specification,
Y₄₄ to Y₄₇ are the same as described in connection with Y₄₁ and Y₄₂, respectively,
R₄₁₁ is the same as described with R₄₁, and R₄₂₁ is the same as described with R₄₂, R₄₃₁ and R₄₃₂ are each the same as described with R₄₃, R₄₄₁ is the same as described with R₄₁, R₄₅₁ is the same as described with R₄₂, and R₄₆₁ is the same as described with R₄₃,
a411 may be an integer from 0 to 4, a421 may be an integer from 0 to 3, a431 may be an integer from 0 to 4, a441 may be an integer from 0 to 4, a451 may be an integer from 0 to 3, and a461 is an integer selected from 0 to 3.

### Specific examples of thermally activated delayed fluorescent materials.

According to an embodiment, the thermally activated delayed fluorescent material (for example, the polycyclic compound represented by Formula 4) may be selected from Compounds D1 to D30:

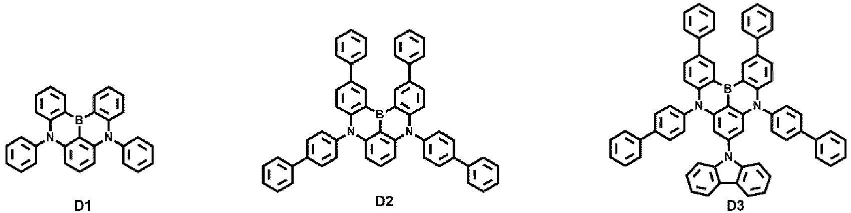

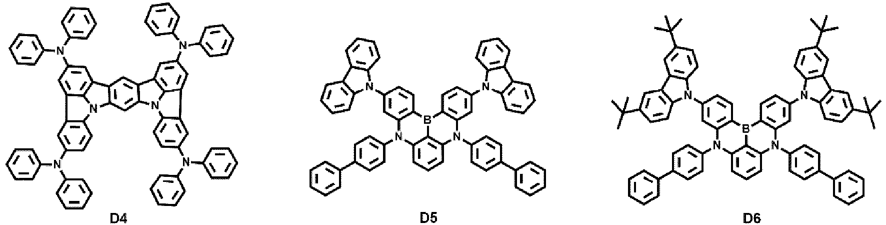

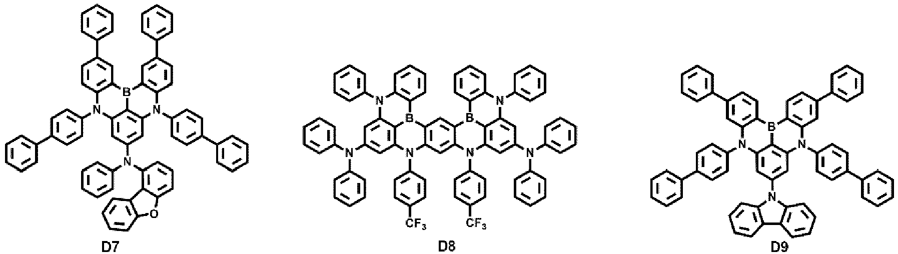

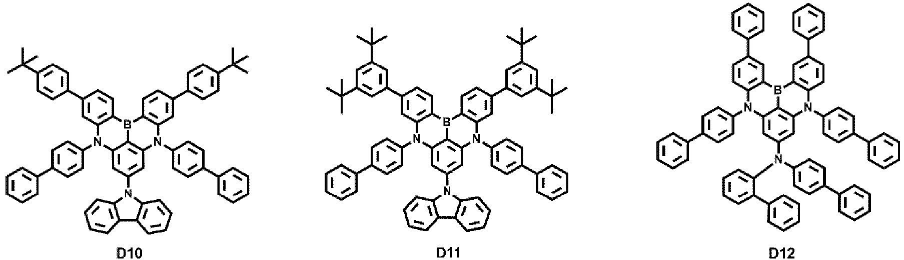

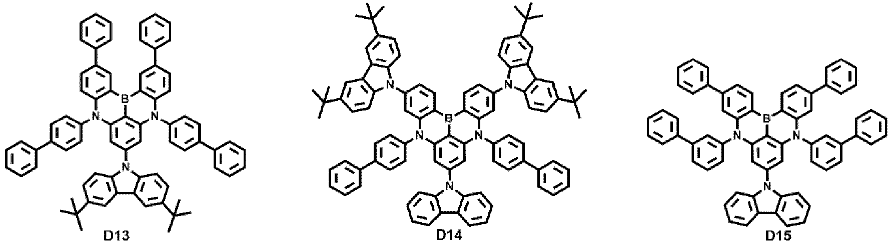

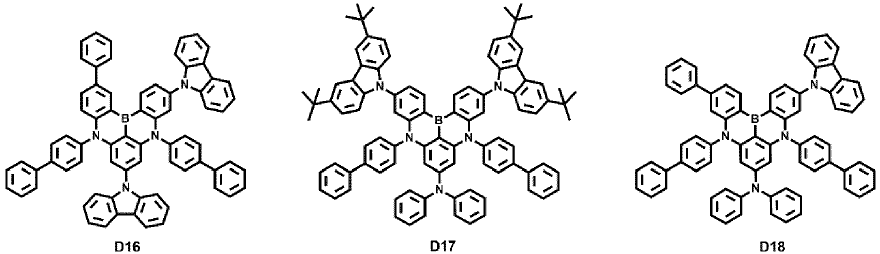

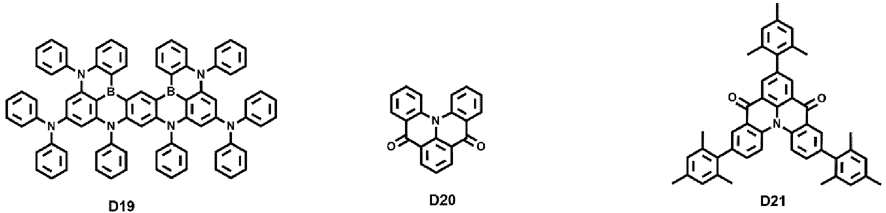

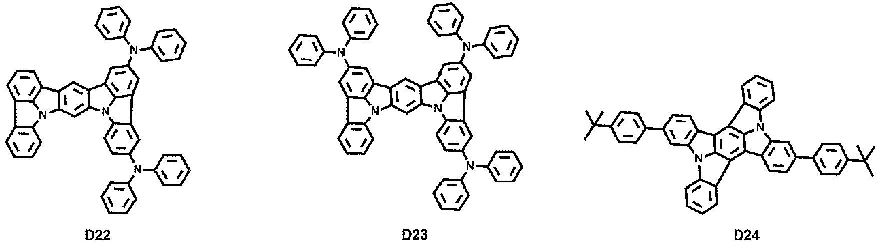

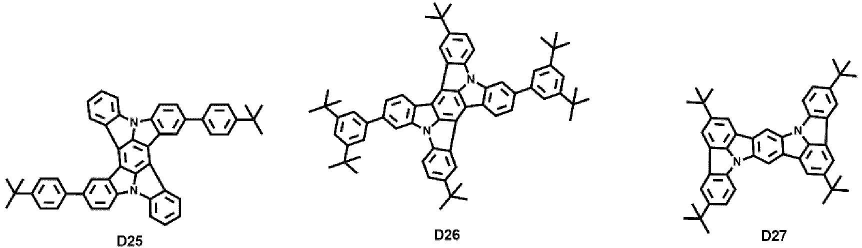

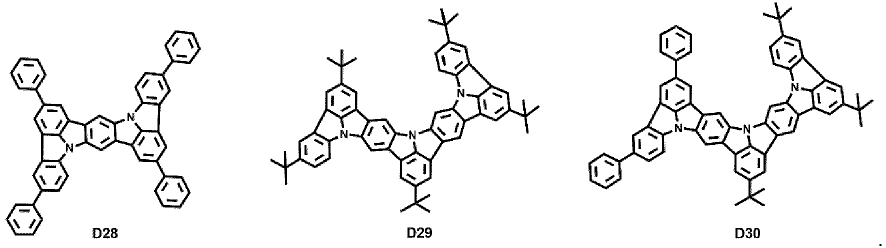

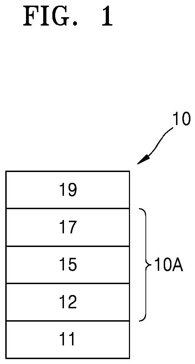

FIG. 1 schematically shows a cross-sectional view of an organic light-emitting device 10, which is one of light-emitting devices according to embodiments of the present disclosure. Hereinafter, the structure and manufacturing method of an organic light-emitting device according to an embodiment of the present disclosure will be described in accordance with the FIG. 1.

The organic light-emitting device 10 of FIG. 1 includes a first electrode 11, a second electrode 19 facing the first electrode 11, and an interlayer 10A disposed between the first electrode 11 and the second electrode 19.

The interlayer 10A may include an emission layer 15, a hole transport region 12 disposed between the first electrode 11 and the emission layer 15, and an electron transport region 17 disposed between the emission layer 15 and the second electrode 19. The hole transport region 12 may further include a first layer (not shown in FIG. 1). The first layer may directly contact the emission layer 15.

A substrate may be additionally disposed under the first electrode 11 or above the second electrode 19. The substrate may be a conventional substrate used in organic light-emitting devices, for example, a glass substrate or a transparent plastic substrate, each having excellent mechanical strength, thermal stability, transparency, surface smoothness, ease of handling, and water repellency.

The first electrode 11 may be formed by, for example, depositing or sputtering, onto the substrate, a material for forming the first electrode 11. The first electrode 11 may be an anode. The material for forming the first electrode 11 may include materials with a high work function to facilitate hole injection.

The first electrode 11 may be a reflective electrode, a semi-transmissive electrode, or a transmissive electrode. In an embodiment, when the first electrode 11 is a transmissive electrode, the material for forming the first electrode 11 may include indium tin oxide (ITO), indium zinc oxide (IZO), tin oxide (SnO₂), zinc oxide (ZnO), or a combination thereof. In one or more embodiments, when the first electrode 11 is a semi-transmissive electrode or a reflective electrode, the material for forming the first electrode 11 may include magnesium (Mg), silver (Ag), aluminum (Al), aluminum-lithium (Al-Li), calcium (Ca), magnesium-indium (Mg-In), magnesium-silver (Mg-Ag), or a combination thereof.

The first electrode 11 may have a single-layer structure or a multi-layer structure including a plurality of layers.

A thickness of the emission layer 15 may be in a range of about 100 Å to about 1,000 Å, for example, about 200 Å to about 600 Å. When the thickness of the emission layer 15 is within these ranges, excellent light-emission characteristics may be obtained without a substantial increase in driving voltage.

According to an embodiment, the emission layer 15 may include a first compound and an organometallic compound as described herein. Additionally, the emission layer 15 may further include at least one of a second compound and a thermally activated delayed fluorescent material in addition to the first compound and the organometallic compound.

The hole transport region 12 may be arranged between the first electrode 11 and the emission layer 15 of the organic light-emitting device 10.

The hole transport region 12 may include a first layer as described herein.

The hole transport region 12 may further include, in addition to the first layer, a hole injection layer, a hole transport layer, a hole injection layer/hole transport layer structure, a hole injection layer/first hole transport layer/second hole transport layer structure, a hole injection layer/first hole transport layer/second hole transport layer/electron-blocking layer structure, a hole transport layer/buffer layer structure, a hole injection layer/hole transport layer/buffer layer structure, a hole transport layer/electron-blocking layer structure, or a hole injection layer/hole transport layer/electron-blocking layer structure.

The hole transport region 12 may include any compound having hole-transporting properties.

For example, the hole transport region 12 may include an amine-based compound.

In an embodiment, the hole transport region 12 may include, for example, m-MTDATA, TDATA, 2-TNATA, NPB, β-NPB, TPD, spiro-TPD, spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), one of a compound represented by Formula 201 to a compound represented by Formula 205, or a combination thereof: 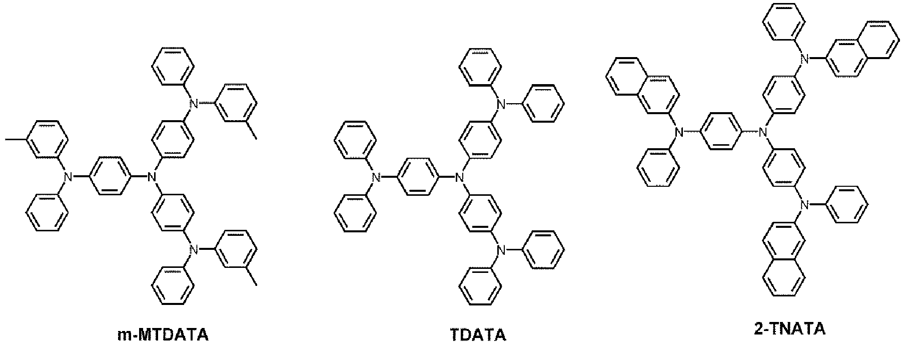 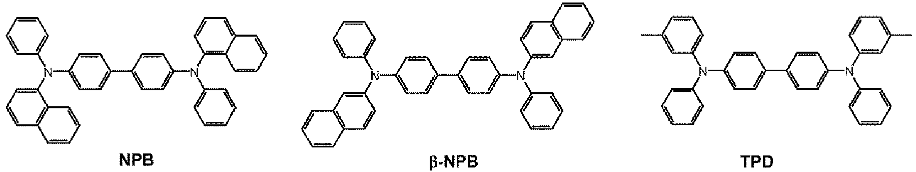 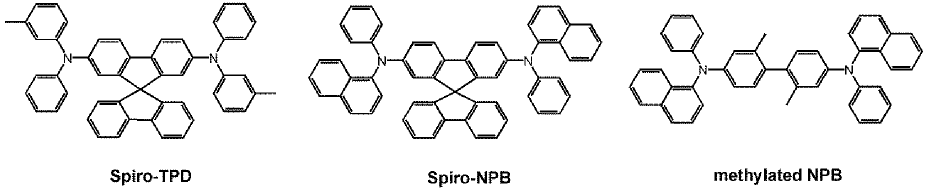 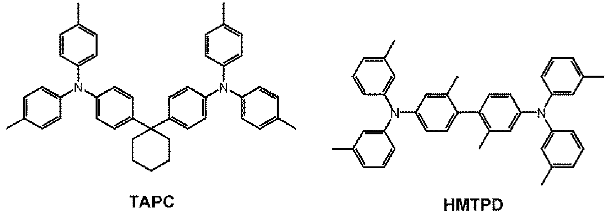 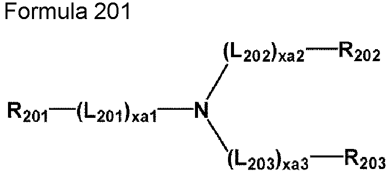 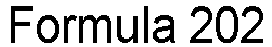 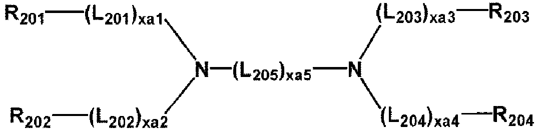 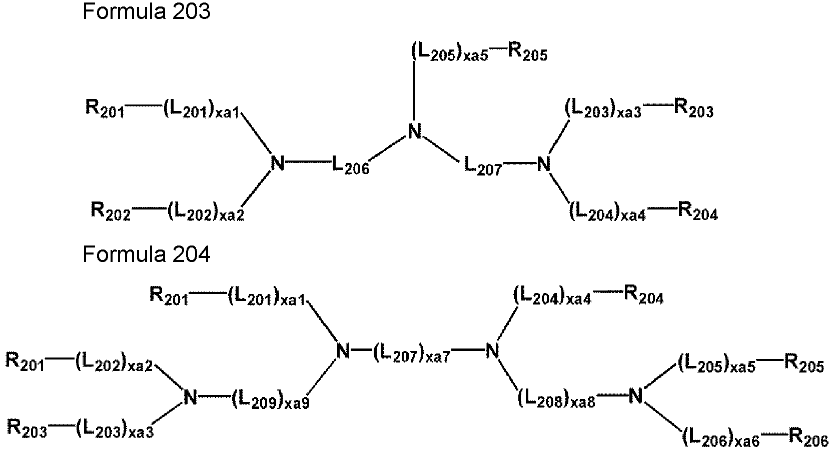 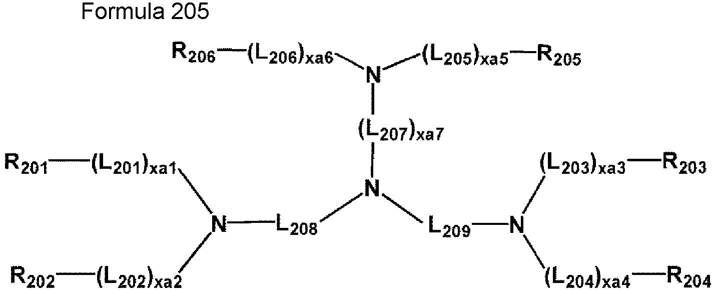 wherein, in Formulae 201 to 205,
L₂₀₁ to L₂₀₉ may each independently be *- O-*', *-S-*', a substituted or unsubstituted C₅-C₆₀ carbocyclic group, or a substituted or unsubstituted C₁-C₆₀ heterocyclic group,
xa1 to xa9 may each independently be an integer from 0 to 5, and
R₂₀₁ to R₂₀₆ may each independently be a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, wherein neighboring two groups of R₂₀₁ to R₂₀₆ may optionally be linked to each other via a single bond, a dimethyl-methylene group, or a diphenyl-methylene group. For example,
L₂₀₁ to L₂₀₉ may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a phenacene group, a hexacene group, a pentacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, or a triindolobenzene group, each unsubstituted or substituted with deuterium, a C₁-C₁₀ alkyl group, a C₁-C₁₀ alkoxy group, a phenyl group, a naphthyl group, a fluorenyl group, a carbazolyl group, a dibenzofuranyl group, a dibenzothiophenyl group, a triphenylenyl group, a biphenyl group, a quaterphenyl group, a tetraphenyl group, -Si(Q₁₁)(Q₁₂)(Q₁₃), or a combination thereof,
xa1 to xa9 may each independently be 0, 1, or 2, and
R₂₀₁ to R₂₀₆ may each independently be a phenyl group, a biphenyl group, a terphenyl group, a pentalenyl group, an indenyl group, a naphthyl group, an azulenyl group, a heptalenyl group, an indacenyl group, an acenaphthenyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an indenocarbazolyl group, an indolocarbazolyl group, a benzofurocarbazolyl group, or a benzothienocarbazolyl group, each unsubstituted or substituted with deuterium, -F, -Cl, -Br, -I, a hydroxyl group, a cyano group, a nitro group, an amidino group, a hydrazine group, a hydrazone group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthenyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), -N(Q₃₁)(Q₃₂), or a combination thereof.

Q₁₁, Q₁₂, Q₁₃, Q₃₁, Q₃₂, and Q₃₃ may each independently be a C₁-C₁₀ alkyl group, a C₁-C₁₀ alkoxy group, a phenyl group, a biphenyl group, a terphenyl group, or a naphthyl group.

In one or more embodiments, the hole transport region 12 may include a carbazole-containing amine-based compound.

In one or more embodiments, the hole transport region 12 may include a carbazole-containing amine-based compound and a carbazole-free amine-based compound.

The carbazole-containing amine-based compound may include, for example, compounds represented by Formula 201 including a carbazole group and further including at least one of a dibenzofuran group, a dibenzothiophene group, a fluorene group, a spiro-bifluorene group, an indenocarbazole group, an indolocarbazole group, a benzofurocarbazole group, or a benzothienocarbazole group.

The carbazole-free amine-based compound may include, for example, a compound represented by Formula 201 that does not include a carbazole group and includes at least one of a dibenzofuran group, a dibenzothiophene group, a fluorene group, a spiro-bifluorene group, an indenocarbazole group, an indolocarbazole group, a benzofurocarbazole group, or a benzothienocarbazole group.

In one or more embodiments, the hole transport region 12 may include a compound represented by Formula 201, a compound represented by Formula 202, or a combination thereof.

In one or more embodiments, the hole transport region 12 may include a compound represented by Formula 201-1, 202-1, or 201-2, or a combination thereof: 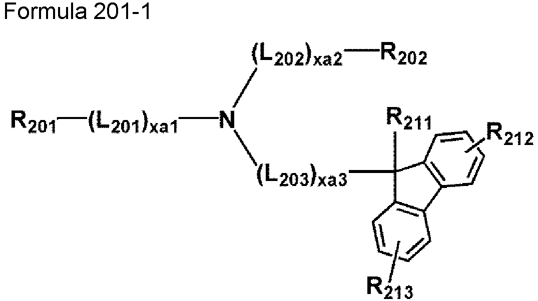 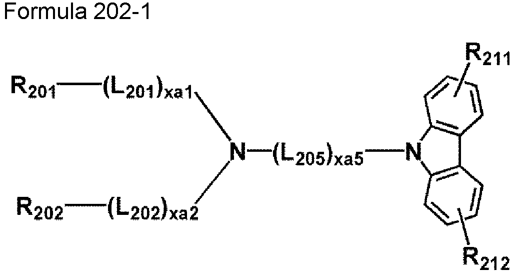 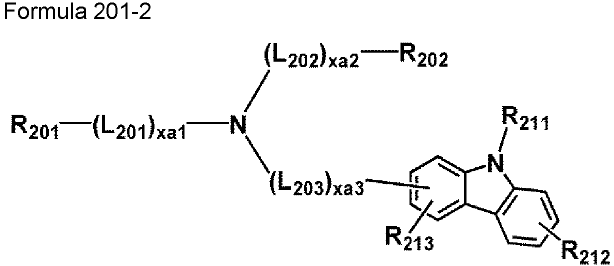 wherein, in Formulae 201-1, 202-1, and 201-2, L₂₀₁, L₂₀₂, L₂₀₃, L₂₀₅, xa1, xa2, xa3, xa5, R₂₀₁ and R₂₀₂ are as described herein, and R₂₁₁, R₂₁₂, and R₂₁₃ may each independently be hydrogen, deuterium, -F, -Cl, -Br, -I, a hydroxyl group, a cyano group, a nitro group, an amidino group, a hydrazine group, a hydrazone group, a C₁-C₂₀ alkyl group, a C₁-C₂₀ alkoxy group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a dimethylfluorenyl group, a diphenylfluorenyl group, a triphenylenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, or a combination thereof.

In an embodiment, the hole transport region 12 may include one of Compounds HT1 to HT39 or any combination thereof:

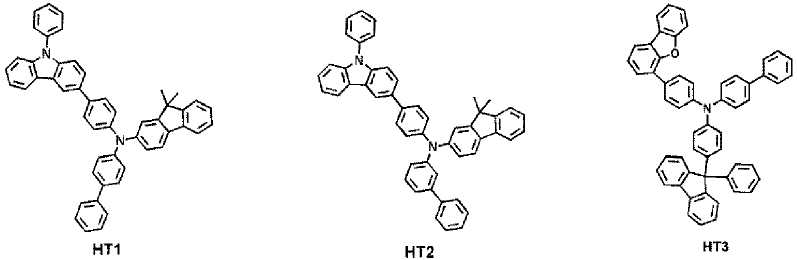

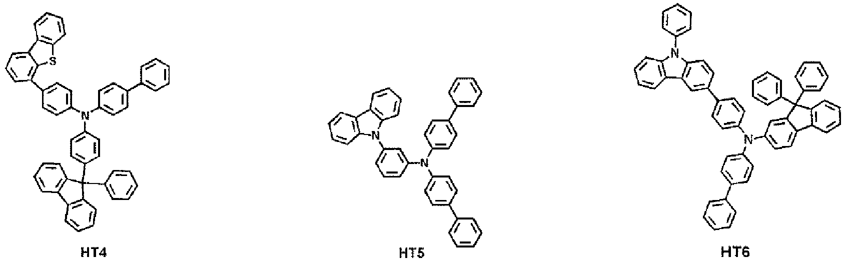

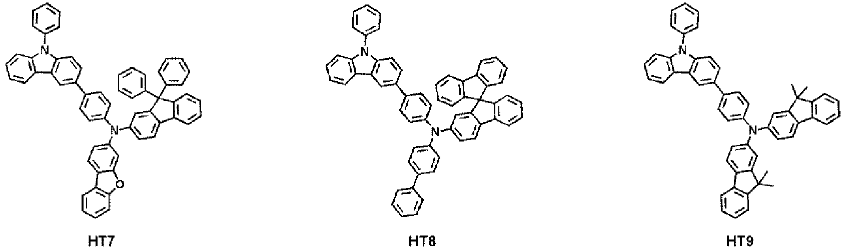

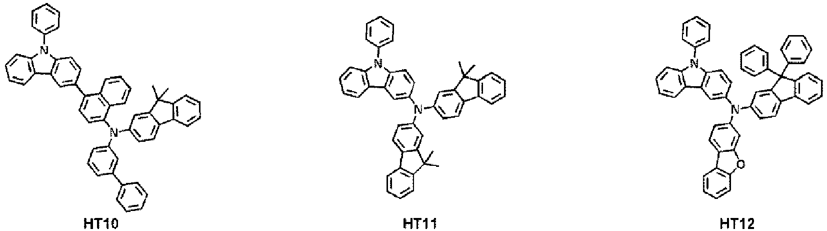

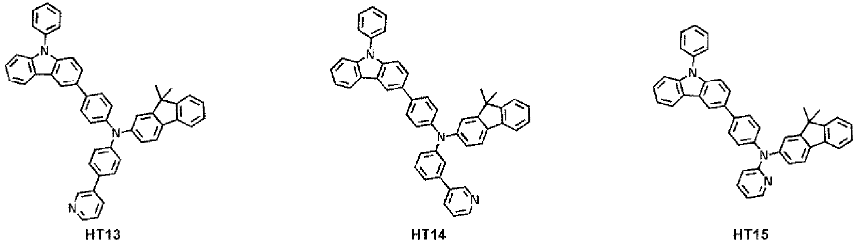

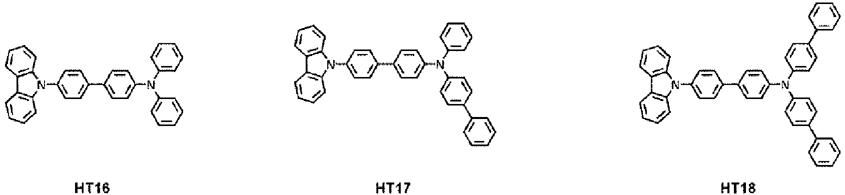

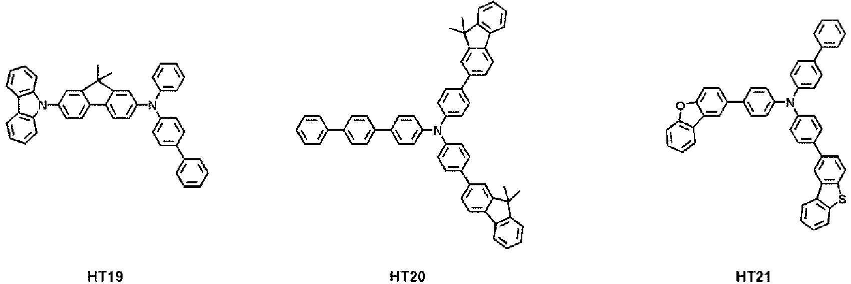

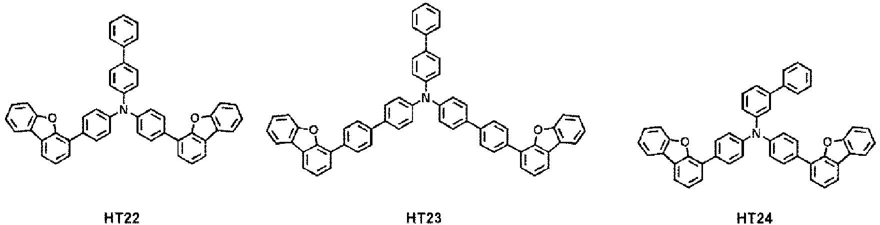

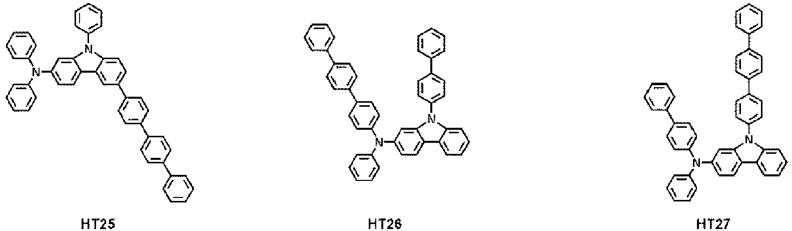

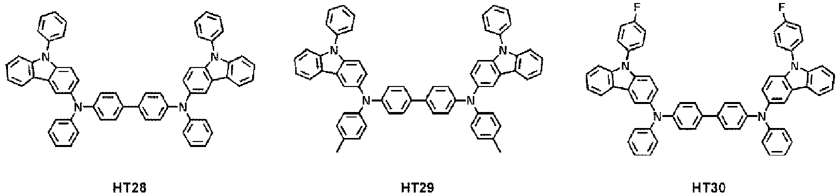

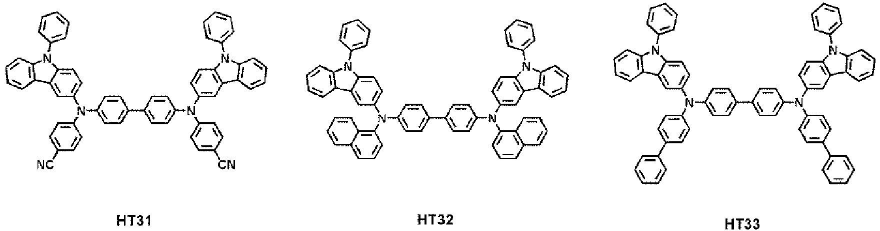

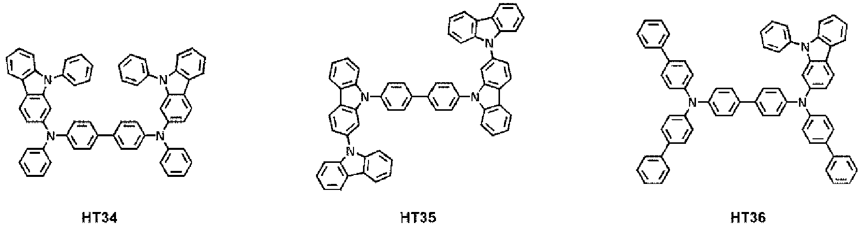

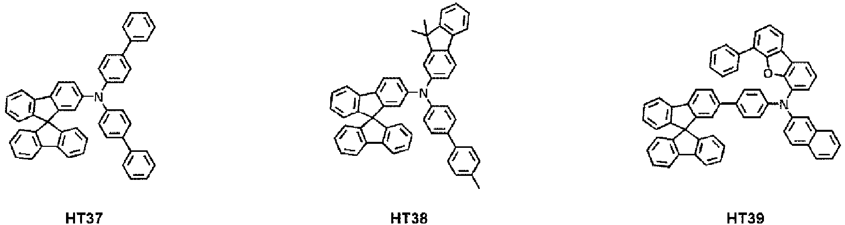

In one or more embodiments, the hole transport region 12 of the organic light-emitting device 10 may further include a p-dopant. When the hole transport region 12 further includes a p-dopant, the hole transport region 12 may have a matrix (for example, at least one of compounds represented by Formulae 201 to 205) and a p-dopant included in the matrix. The p-dopant may be uniformly or non-uniformly doped in the hole transport region 12.

In an embodiment, the LUMO energy level of the p-dopant may be less than or equal to -3.5 eV.

The p-dopant may include a quinone derivative, a metal oxide, a cyano group-containing compound, or a combination thereof.

For example, the p-dopant may include:
a quinone derivative, e.g., tetracyanoquinodimethane (TCNQ),2,3,5,6-tetrafluoro-7,7,8,8-tetracyanoquinodimethane (F4-TCNQ), or F6-TCNNQ;
   a metal oxide, e.g., tungsten oxide or molybdenum oxide; 1,4,5,8,9,12-hexaazatriphenylene-hexacarbonitrile (HAT-CN);
   a compound represented by Formula 221; or a combination thereof. 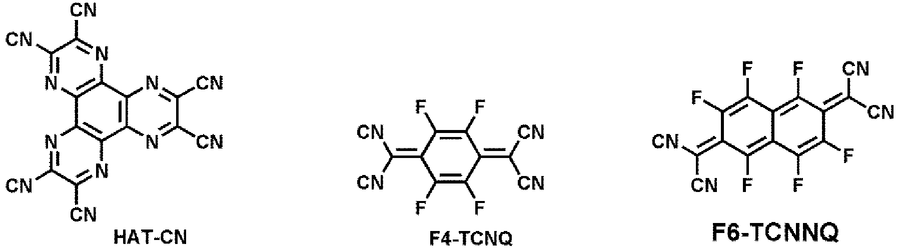 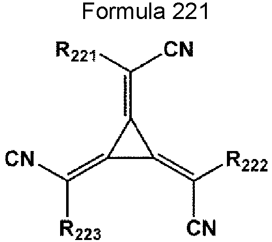 In Formula 221,
      R₂₂₁, R₂₂₂, and R₂₂₃ may each independently be a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, wherein a substituent of at least one of R₂₂₁, R₂₂₂, or R₂₂₃ may be: a cyano group; -F; -Cl; -Br; -I; a C₁-C₂₀ alkyl group substituted with -F; a C₁-C₂₀ alkyl group substituted
with -Cl; a C₁-C₂₀ alkyl group substituted with -Br; a C₁-C₂₀ alkyl group substituted with -I; or a combination thereof.

The compound represented by Formula 221 may include, for example, Compound HT-D2:

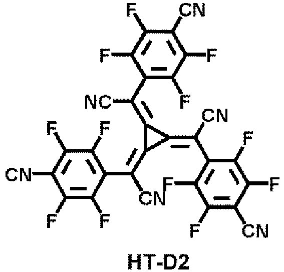

The hole transport region 12 may have a thickness in a range about 100 Å to about 10,000 Å, for example, about 400 Å to about 2,000 Å, and the emission layer 15 may have a thickness in a range of about 100 Å to about 3,000 Å, for example, about 300 Å to about 1,000 Å. When the thickness of each of the hole transport region 12 and the emission layer 15 is within these ranges, satisfactory hole transportation characteristics and/or luminescence characteristics may be obtained without a substantial increase in driving voltage.

The hole transport region 12 may further include a buffer layer. The buffer layer may compensate for an optical resonance distance according to a wavelength of light emitted from the emission layer 15, and thus, efficiency of a formed organic light-emitting device may be improved.

The hole transport region 12 may further include an electron-blocking layer. The electron-blocking layer may include a known material, for example, mCP or DBFPO:

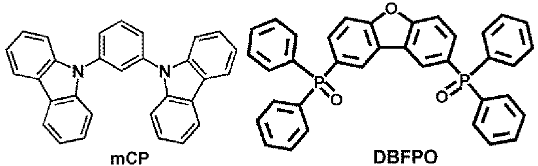

The electron transport region 17 may be arranged between the emission layer 15 and the second electrode 19 of the organic light-emitting device 10.

The electron transport region 17 may have a single-layer structure or a multi-layer structure.

For example, the electron transport region 17 may have an electron transport layer, an electron transport layer/electron injection layer structure, a buffer layer/electron transport layer structure, hole-blocking layer/electron transport layer structure, a buffer layer/electron transport layer/electron injection layer structure, or a hole-blocking layer/electron transport layer/electron injection layer structure. The electron transport region 17 may further include an electron control layer.

The electron transport region 17 may include known electron-transporting materials.

The electron transport region 17 (for example, a buffer layer, a hole-blocking layer, an electron control layer, or an electron transport layer in the electron transport region) may include a metal-free compound containing at least one π electron-deficient nitrogen-containing C₁-C₆₀ cyclic group. The π electron-deficient nitrogen-containing C₁-C₆₀ cyclic group is the same as described herein.

For example, the electron transport region 17 may include a compound represented by Formula 601:

Formula 601 [Ar₆₀₁]ₓₑ₁₁-[(L₆₀₁)ₓₑ₁-R₆₀₁]ₓₑ₂₁

wherein, in Formula 601,
Ar₆₀₁ and L₆₀₁ may each independently be a C₅-C₆₀ carbocyclic group unsubstituted or substituted with at least one R₆₀₁ₐ or a C₁-C₆₀ heterocyclic group unsubstituted or substituted with at least one R₆₀₁ₐ,
xe11 may be 1, 2, or 3,
xe1 may be an integer from 0 to 5,
R₆₀₁ₐ and R₆₀₁ may each independently be a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
wherein Q₆₀₁, Q₆₀₂, and Q₆₀₃ may each independently be a C₁-C₁₀ alkyl group, a C₁-C₁₀ alkoxy group, a phenyl group, a biphenyl group, a terphenyl group, or a naphthyl group, and
xe21 may be an integer from 1 to 5.

In an embodiment, at least one of Ar₆₀₁(s) of xe11 and R₆₀₁(s) of xe21 may include the π electron-deficient nitrogen-containing C₁-C₆₀ cyclic group.

In an embodiment, Ar₆₀₁ and L₆₀₁ in Formula 601 may each independently be a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, a benzoisothiazole group, a benzoxazole group, a benzoisoxazole group, a triazole group, a tetrazole group, an oxadiazole group, a triazine group, a thiadiazole group, an imidazopyridine group, an imidazopyrimidine group, or an azacarbazole group,
each of which is unsubstituted or substituted with deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -S(=O)₂(Q₃₁), -P(=O)(Q₃₁)(Q₃₂), or a combination thereof, and
wherein Q₃₁, Q₃₂, and Q₃₃ may each independently be a C₁-C₁₀ alkyl group, a C₁-C₁₀ alkoxy group, a phenyl group, a biphenyl group, a terphenyl group, or a naphthyl group.

When xe11 in Formula 601 is 2 or more, two or more of Ar₆₀₁ may be linked to each other via a single bond.

In one or more embodiments, Ar₆₀₁ in Formula 601 may be an anthracene group.

In one or more embodiments, the compound represented by Formula 601 may be represented by Formula 601-1: 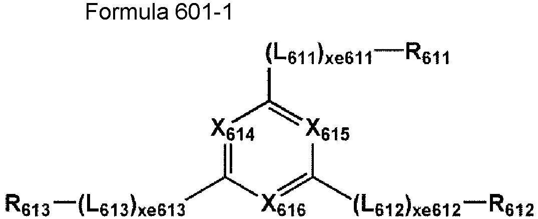 wherein, in Formula 601-1,
X₆₁₄ may be N or C(R₆₁₄), X₆₁₅ may be N or C(R₆₁₅), X₆₁₆ may be N or C(R₆₁₆), and at least one of X₆₁₄, X₆₁₅, or X₆₁₆ may be N,
L₆₁₁, L₆₁₂, and L₆₁₃ are each independently the same as described with L₆₀₁,
xe611 to xe613 are each independently the same as described in connection with xe1,
R₆₁₁, R₆₁₂, and R₆₁₃ are each independently the same as described with R₆₀₁, and
R₆₁₄, R₆₁₅, and R₆₁₆ may each independently be hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, or a combination thereof.

In one or more embodiments, xe1 and xe611 to xe613 in Formulae 601 and 601-1 may each independently be 0, 1, or 2.

In one or more embodiments, R₆₀₁ and R₆₁₁, R₆₁₂, and R₆₁₃ in Formulae 601 and 601-1 may each independently be a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzoisothiazolyl group, a benzoxazolyl group, a benzoisoxazolyl group, a triazolyl group, a tetrazolyl group, an imidazopyridinyl group, an imidazopyrimidinyl group, or an azacarbazolyl group,
each unsubstituted or substituted with deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzoisothiazolyl group, a benzoxazolyl group, a benzoisoxazolyl group, a triazolyl group, a tetrazolyl group, an imidazopyridinyl group, an imidazopyrimidinyl group, an azacarbazolyl group, or a combination thereof; or
-S(=O)₂(Q₆₀₁), or -P(=O)(Q₆₀₁)(Q₆₀₂), and
Q₆₀₁ and Q₆₀₂ are the same as described herein.

The electron transport region 17 may include one of Compounds ET1 to ET36 or a combination thereof:

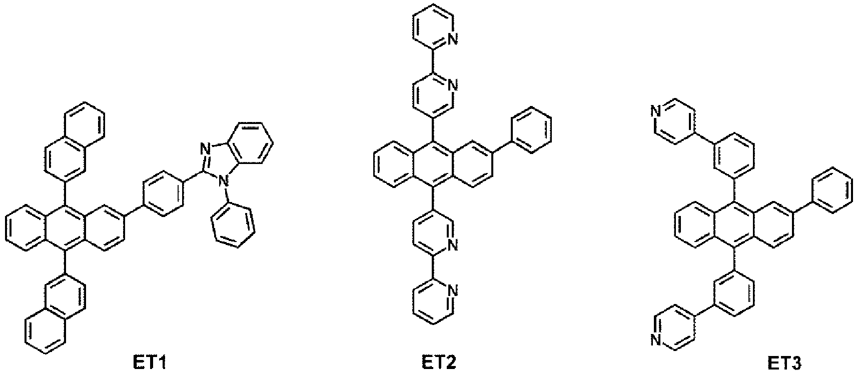

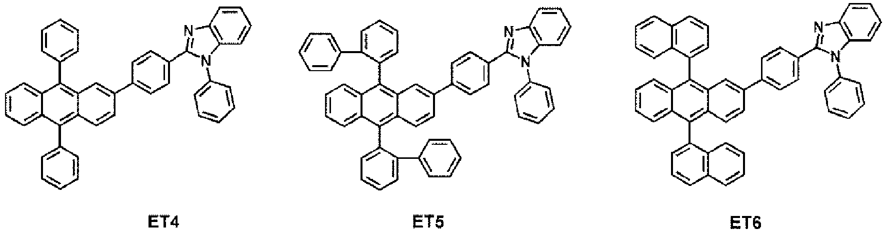

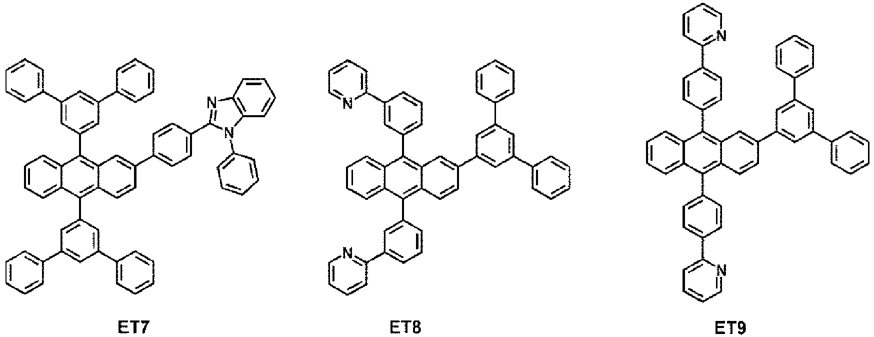

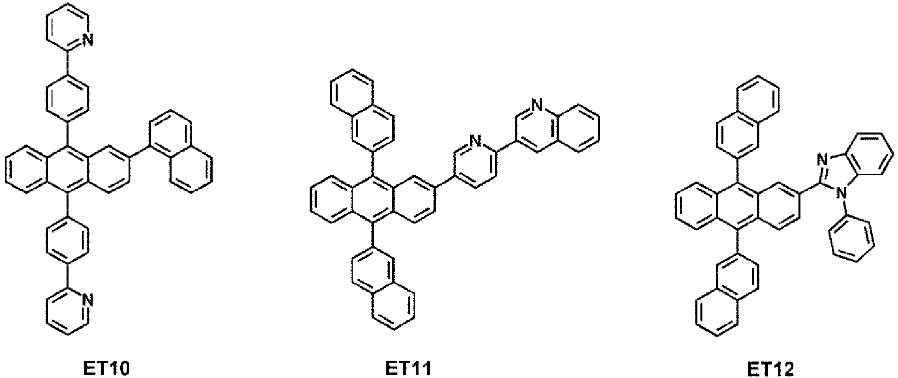

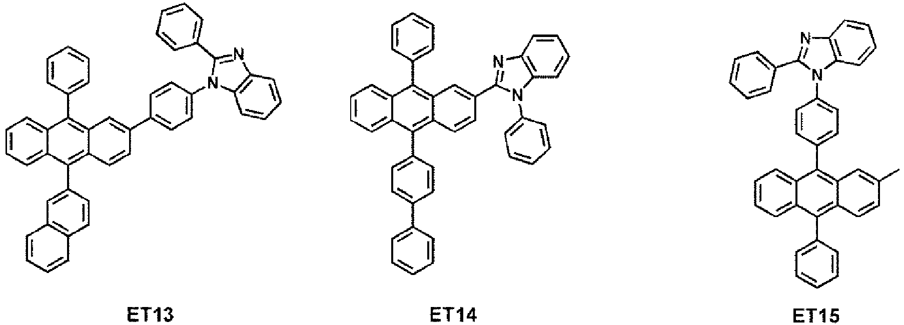

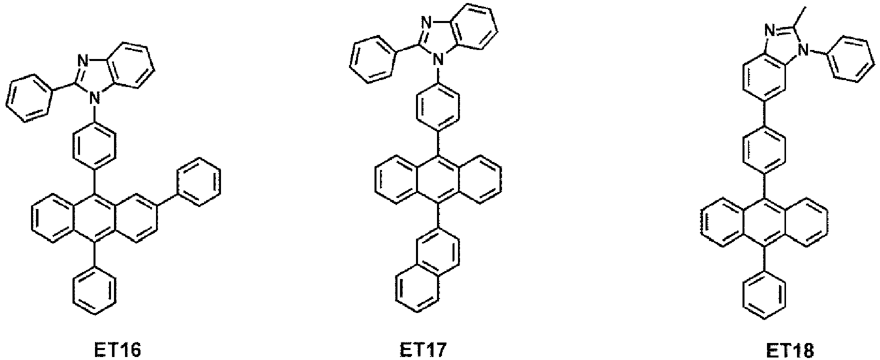

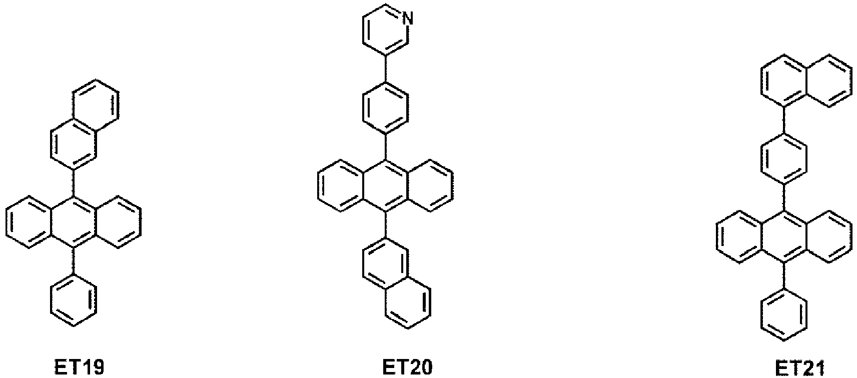

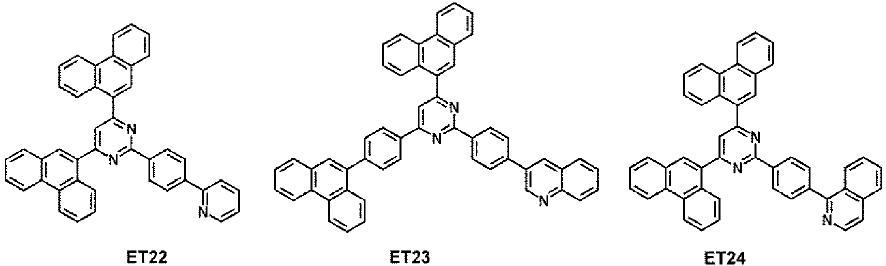

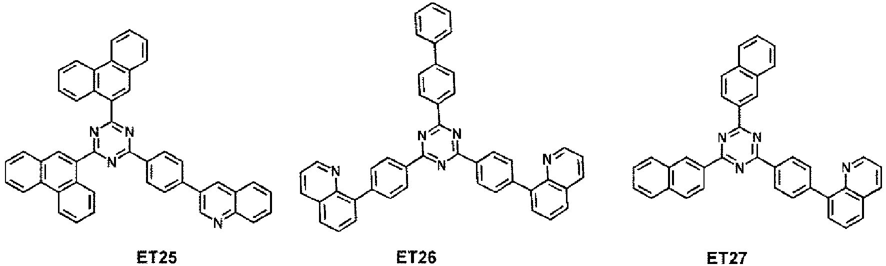

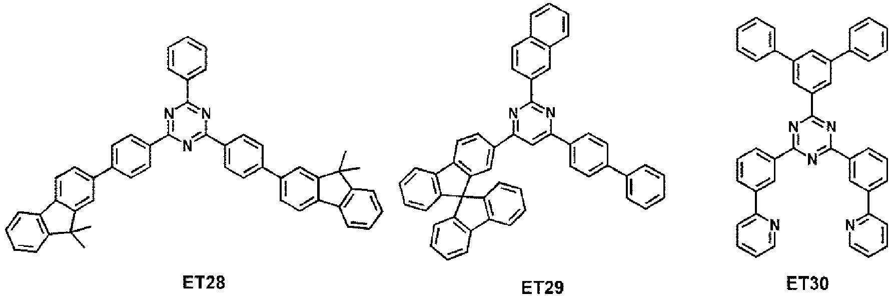

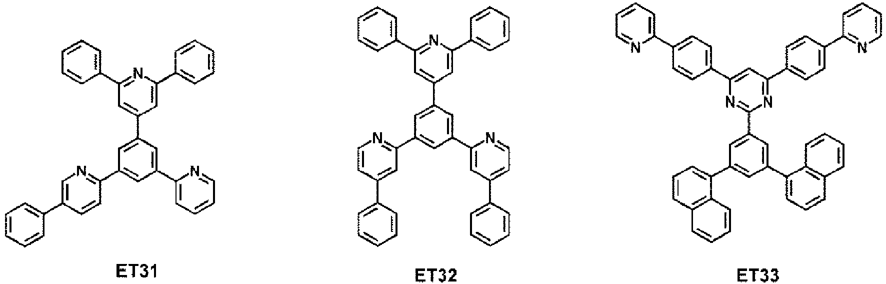

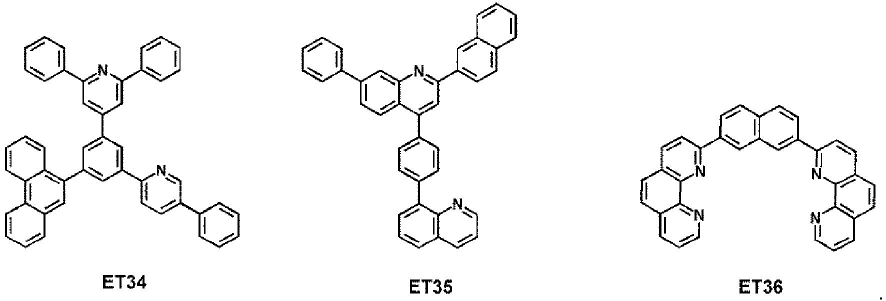

In one or more embodiments, the electron transport region 17 may include 2,9-dimethyl-4,7-diphenyl-1,10-phenanthroline (BCP), 4,7-diphenyl-1,10-phenanthroline (Bphen), Alq₃, BAlq, 3-(biphenyl-4-yl)-5-(4-tert-butylphenyl)-4-phenyl-4H-1,2,4-triazole (TAZ), NTAZ, DBFPO, or a combination thereof. For example, when the electron transport region 17 includes a hole-blocking layer, the hole-blocking layer may include BCP or Bphen:

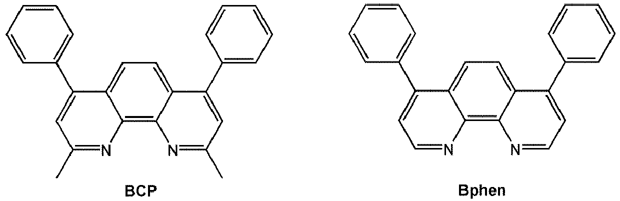

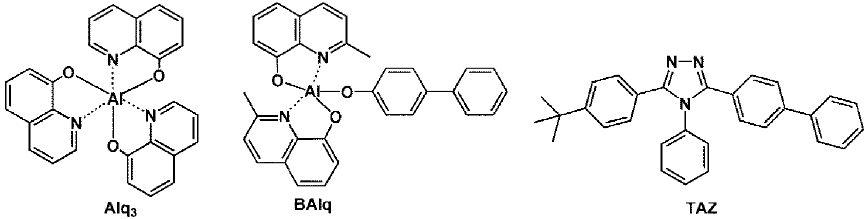

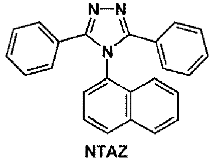

Thicknesses of the buffer layer, the hole-blocking layer, and the electron control layer may each independently be in a range of about 20 Å to about 1,000 Å, for example, about 30 Å to about 300 Å. When the thicknesses of the buffer layer, the hole-blocking layer, and the electron control layer are within these ranges, excellent hole blocking characteristics or excellent electron control characteristics may be obtained without a substantial increase in driving voltage.

A thickness of the electron transport layer may be in a range of about 100 Å to about 1,000 Å, for example, about 150 Å to about 500 Å. When the thickness of the electron transport layer is within these ranges, satisfactory electron transporting characteristics may be obtained without a substantial increase in driving voltage.

The electron transport region 17 (for example, the electron transport layer in the electron transport region 17) may further include, in addition to the materials described above, a metal-containing material.

The metal-containing material may include an alkali metal complex, an alkaline earth metal complex, or a combination thereof. A metal ion of the alkali metal complex may include a Li ion, a Na ion, a K ion, a Rb ion, a Cs ion, or a combination thereof, and a metal ion of the alkaline earth metal complex may include a Be ion, a Mg ion, a Ca ion, a Sr ion, a Ba ion, or a combination thereof. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxydiphenyloxadiazole, a hydroxydiphenylthiadiazole, a hydroxyphenylpyridine, a hydroxyphenylbenzimidazole, a hydroxyphenylbenzothiazole, a bipyridine, a phenanthroline, a cyclopentadiene, or a combination thereof.

In an embodiment, the metal-containing material may include a Li complex. The Li complex may include, for example, Compound ET-D1 (LiQ) or ET-D2:

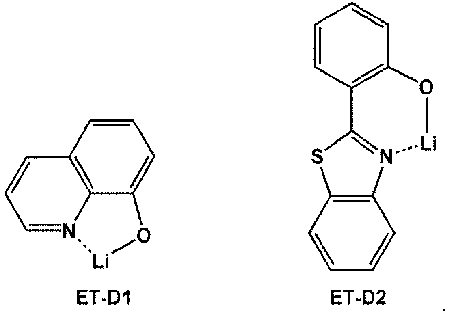

The electron transport region 17 may include an electron injection layer that facilitates the injection of electrons from the second electrode 19. The electron injection layer may directly contact the second electrode 19.

The electron injection layer may have i) a single-layer structure consisting of a single layer including a single material, ii) a single-layer structure consisting of a single layer including multiple materials that are different from each other, or iii) a multi-layer structure consisting of multiple layers including multiple materials that are different from each other.

The electron injection layer may include an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof.

The alkali metal may include Li, Na, K, Rb, Cs, or a combination thereof. In an embodiment, the alkali metal may be Li, Na, or Cs. In one or more embodiments, the alkali metal may be Li or Cs.

The alkaline earth metal may include Mg, Ca, Sr, Ba, or a combination thereof.

The rare earth metal may include Sc, Y, Ce, Tb, Yb, Gd, or a combination thereof.

The alkali metal compound, the alkaline earth metal compound, and the rare earth metal compound may include oxides and halides (for example, fluorides, chlorides, bromides, or iodides) of the alkali metal, the alkaline earth metal, and the rare earth metal, or a combination thereof.

The alkali metal compound may include: one of alkali metal oxides such as Li₂O, Cs₂O, K₂O, and the like; one of alkali metal halides such as LiF, NaF, CsF, KF, Lil, Nal, Csl, KI, and the like; or a combination thereof. In an embodiment, the alkali metal compound may include LiF, Li₂O, NaF, Lil, Nal, Csl, KI, or a combination thereof.

The alkaline earth-metal compound may include one of alkaline earth-metal compounds, such as BaO, SrO, CaO, BaₓSr₁₋ₓO (wherein 0<x<1), or BaₓCa₁₋ₓO (wherein 0<x<1), or a combination thereof. In an embodiment, the alkaline earth metal compound may include BaO, SrO, CaO, or a combination thereof.

The rare earth metal compound may include YbF₃, ScF₃, ScO₃, Y₂O₃, Ce₂O₃, GdF₃, TbF₃, or a combination thereof. In an embodiment, the rare earth metal compound may include YbF₃, ScF₃, TbF₃, Ybl₃, Scl₃, Tbl₃, or a combination thereof.

The alkali metal complex, the alkaline earth metal complex, and the rare earth metal complex may include an ion of alkali metal, alkaline earth metal, and rare earth metal as described above, and a ligand coordinated with a metal ion of the alkali metal complex, the alkaline earth metal complex, or the rare earth metal complex may include hydroxy quinoline, hydroxy isoquinoline, hydroxy benzoquinoline, hydroxy acridine, hydroxy phenanthridine, hydroxy phenyloxazole, hydroxy phenylthiazole, hydroxy diphenyloxadiazole, hydroxy diphenylthiadiazole, hydroxy phenylpyridine, hydroxy phenylbenzimidazole, hydroxy phenylbenzothiazole, bipyridine, phenanthroline, cyclopentadiene, or a combination thereof.

The electron injection layer may consist of an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof, as described above. In one or more embodiments, the electron injection layer may further include an organic material. When the electron injection layer further includes an organic material, an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or a combination thereof may be homogeneously or non-homogeneously dispersed in a matrix including the organic material.

A thickness of the electron injection layer may be in a range of about 1 Å to about 100 Å, and, for example, about 3 Å to about 90 Å. When the thickness of the electron injection layer is within these ranges, satisfactory electron injection characteristics may be obtained without a substantial increase in driving voltage.

The second electrode 19 may be disposed on the interlayer 10A as described above. The second electrode 19 may be a cathode which is an electron injection electrode, and in this regard, a material for forming the second electrode 19 may be selected from a metal, an alloy, an electrically conductive compound, and a combination thereof, which have a relatively low work function.

The second electrode 19 may include Li, Ag, Mg, Al, Al-Li, Ca, Mg-In, Mg-Ag, ITO, IZO, or a combination thereof. The second electrode 19 may be a transmissive electrode, a semi-transmissive electrode, or a reflective electrode.

The second electrode 19 may have a single-layer structure having a single layer or a multi-layer structure including two or more layers.

### Explanation of terms

The term "C₁-C₆₀ alkyl group" as used herein refers to a linear or branched saturated aliphatic hydrocarbons monovalent group having 1 to 60 carbon atoms, and the term "C₁-C₆₀ alkylene group" as used here refers to a divalent group having the same structure as the C₁-C₆₀ alkyl group.

Examples of the C₁-C₆₀ alkyl group, the C₁-C₂₀ alkyl group, and/or the C₁-C₁₀ alkyl group are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof.

The term "C₁-C₆₀ alkoxy group" as used herein refers to a monovalent group represented by -OA₁₀₁ (wherein A₁₀₁ is the C₁-C₆₀ alkyl group, the C₁-C₂₀ alkyl group, or the C₁-C₁₀ alkyl group), and examples thereof would include any one of the above listed alkyl proups, e.g, a methoxy group, an ethoxy group, a propoxy group, a butoxy group, or a pentoxy group.

The term "C₂-C₆₀ alkenyl group" as used herein refers to a hydrocarbon group formed by substituting at least one carbon-carbon double bond in the middle or at the terminus of the C₂-C₆₀ alkyl group, and examples thereof are an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and examples thereof are an ethynyl group, and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and the term "C₃-C₁₀ cycloalkylene group" as used herein refers to a divalent group having the same structure as the C₃-C₁₀ cycloalkyl group.

Examples of the C₃-C₁₀ cycloalkyl group are a cyclopropyl group, a cyclobutyl group, a cyclopentyl group, a cyclohexyl group, a cycloheptyl group, a cyclooctyl group, an adamantanyl group, a norbornanyl group (a bicyclo[2.2.1]heptyl group), a bicyclo[1.1.1]pentyl group, a bicyclo[2.1.1]hexyl group, and a bicyclo[2.2.2]octyl group.

The term "C₁-C₁₀ heterocycloalkyl group" as used herein refers to a monovalent monocyclic group that includes at least one heteroatom selected from N, O, P, Si, S, Se, Ge, and B as a ring-forming atom and 1 to 10 carbon atoms, and the term "the C₁-C₁₀ heterocycloalkylene group" as used herein refers to a divalent group having the same structure as the C₁-C₁₀ heterocycloalkyl group.

Examples of the C₁-C₁₀ heterocycloalkyl group are a silolanyl group, a silinanyl group, tetrahydrofuranyl group, a tetrahydro-2H-pyranyl group, and a tetrahydrothiophenyl group.

The term "C₃-C₁₀ cycloalkenyl group" as used herein refers to a monovalent cyclic group that includes 3 to 10 carbon atoms and at least one carbon-carbon double bond in the ring thereof and has no aromaticity, and examples thereof are a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one hetero atom selected from N, O, P, Si, S, Se, Ge, and B as a ring-forming atom, 1 to 10 carbon atoms, and at least one carbon-carbon double bond in the ring thereof. Examples of the C₁-C₁₀ heterocycloalkenyl group are a 2,3-dihydrofuranyl group and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Examples of the C₆-C₆₀ aryl group are a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

The term "C₁-C₆₀ heteroaryl group" as used herein refers to a monovalent group that includes at least one heteroatom selected from N, O, P, Si, S, Se, Ge, and B as a ring-forming atom and a heterocyclic aromatic system having 1 to 60 carbon atoms, and the term "C₁-C₆₀ heteroarylene group" as used herein refers to a divalent group that includes at least one heteroatom selected from N, O, P, Si, S, Se, Ge, and B as a ring-forming atom and a heterocyclic aromatic system having 1 to 60 carbon atoms. Examples of the C₁-C₆₀ heteroaryl group are a pyridinyl group, a pyrimidinyl group, a pyrazinyl group, a pyridazinyl group, a triazinyl group, a quinolinyl group, and an isoquinolinyl group. When the C₆-C₆₀ heteroaryl group and the C₆-C₆₀ heteroarylene group each include two or more rings, the rings may be fused to each other.

The term "C₆-C₆₀ aryloxy group" as used herein indicates -OA₁₀₂ (wherein A₁₀₂ is the C₆-C₆₀ aryl group), and the term "C₆-C₆₀ arylthio group" as used herein indicates -SA₁₀₃ (wherein A₁₀₃ is the C₆-C₆₀ aryl group).

The term "monovalent non-aromatic condensed polycyclic group" as used herein refers to a monovalent group in which two or more rings are condensed with each other, only carbon is used as a ring-forming atom (for example, the number of carbon atoms may be 8 to 60), and the whole molecule is a non-aromaticity group. An example of the monovalent non-aromatic condensed polycyclic group is a fluorenyl group. The term "divalent non-aromatic condensed polycyclic group" as used herein refers to a divalent group having the same structure as the monovalent non-aromatic condensed polycyclic group described above.

The term "monovalent non-aromatic condensed heteropolycyclic group" as used herein refers to a monovalent group having two or more rings condensed with each other, a heteroatom selected from N, O, P, Si, S, Se, Ge, and B, other than carbon atoms (for example, having 1 to 60 carbon atoms), as a ring-forming atom, and no aromaticity in the entire molecular structure thereof. An example of the monovalent non-aromatic condensed heteropolycyclic group is a carbazolyl group. The term "divalent non-aromatic condensed heteropolycyclic group" as used herein refers to a divalent group having the same structure as the monovalent non-aromatic condensed heteropolycyclic group described above.

The term "π electron-depleted nitrogen-containing C₁-C₆₀ cyclic group" as used herein refers to a cyclic group having 1 to 60 carbon atoms and including at least one *-N=*' (wherein * and *' each indicate a binding site to an adjacent atom) as a ring-forming moiety. For example, the π electron-depleted nitrogen-containing C₁-C₆₀ cyclic group may be a) a first ring, b) a condensed ring in which at least two first rings are condensed, or c) a condensed ring in which at least one first ring and at least one second ring are condensed.

The term "π electron-rich C₃-C₆₀ cyclic group" as used herein refers to a cyclic group having 3 to 60 carbon atoms and not including at least one *-N=*' (wherein * and *' each indicate a binding site to an adjacent atom) as a ring-forming moiety. For example, the π electron-rich C₃-C₆₀ cyclic group may be a) a second ring or b) a condensed ring in which at least two second rings are condensed.

The term "C₅-C₆₀ cyclic group" as used herein refers to a monocyclic or polycyclic group having 5 to 60 carbon atoms, and may be, for example, a) a third ring or b) a condensed ring in which two or more third rings are condensed with each other.

The term "C₁-C₆₀ heterocyclic group" as used herein refers to a monocyclic or polycyclic group that has 1 to 60 carbon atoms and includes at least one heteroatom, and may be, for example, a) a fourth ring, b) a condensed ring in which two or more fourth rings are condensed with each other, or c) a condensed ring in which at least one third ring is condensed with at least one fourth ring.

The "first ring" as used herein may be an imidazole group, a pyrazole group, a thiazole group, an isothiazole group, an oxazole group, an isoxazole group, a pyridine group, a pyrazine group, a pyridazine group, a pyrimidine group, a triazole group, a tetrazole group, an oxadiazole group, a triazine group, or a thiadiazole group.

The "second ring" as used herein may be a benzene group, a cyclopentadiene group, a pyrrole group, a furan group, a thiophene group, or a silole group.

The "third ring" as used herein may be a cyclopentane group, a cyclopentadiene group, an indene group, an adamantane group, a norbornene group, a bicyclo[1.1.1]pentane group, a bicyclo[2.1.1]hexane group, a bicyclo[2.2.1]heptane group (a norbornane group), a bicyclo[2.2.2]octane group, a cyclohexane group, a cyclohexene group, or a benzene group.

The "fourth ring" as used herein may be a furan group, a thiophene group, a pyrrole group, a silole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, a triazasilole group, a pyridine group, a pyrimidine group, a pyrazine group, a pyridazine group, or a triazine group.

For example, the π electron-depleted nitrogen-containing C₁-C₆₀ cyclic group may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, an acridine group, a phenanthroline group, a phenazine group, a benzimidazole group, a benzoisothiazole group, a benzoxazole group, a benzoisoxazole group, a triazole group, a tetrazole group, an oxadiazole group, a triazine group, a thiadiazole group, an imidazopyridine group, an imidazopyrimidine group, an azacarbazole group, an azadibenzofuran group, an azadibenzothiophene group, an azadibenzosilole group, an acridine group, or a pyridopyrazine group.

For example, the π electron-rich C₃-C₆₀ cyclic group may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, a furan group, a thiophene group, an isoindole group, an indole group, an indene group, a benzofuran group, a benzothiophene group, a benzosilole group, a naphthopyrrole group, a naphthofuran group, a naphthothiophene group, a naphthosilole group, a benzocarbazole group, a dibenzocarbazole group, a dibenzofuran group, a dibenzothiophene group, a carbazole group, a dibenzosilole group, an indenocarbazole group, an indolocarbazole group, a benzofurocarbazole group, a benzothienocarbazole group, a benzosilolocarbazole group, a triindolobenzene group, a pyrrolophenanthrene group, a furanophenanthrene group, a thienophenanthrene group, a benzonaphthofuran group, a benzonapthothiophene group, an (indolo)phenanthrene group, a (benzofurano)phenanthrene group, or a (benzothieno)phenanthrene group.

For example, the C₅-C₆₀ carbocyclic group may be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, an indene group, a fluorene group, a 5,6,7,8-tetrahydroisoquinoline group, a 5,6,7,8-tetrahydroquinoline group, an adamantane group, a norbornane group, or a norbornene group.

For example, the C₁-C₆₀ heterocyclic group may be a thiophene group, a furan group, a pyrrole group, a cyclopentadiene group, a silole group, a borole group, a phosphole group, a selenophene group, a germole group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group.

The term "N-carbazolyl group" as used herein refers to a monovalent group 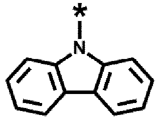 in which hydrogen is separated from N of the carbazole group to enable bonding with another group (where * is the binding site to a neighboring atom).

The terms "a π electron-deficient nitrogen-containing C₁-C₆₀ cyclic group, a π electron-rich C₃-C₆₀ cyclic group, a C₅-C₆₀ cyclic group, and a C₁-C₆₀ heterocyclic group" as used herein each refer to a part of a condensed ring or a monovalent, a divalent, a trivalent, a tetravalent, a pentavalent, or a hexavalent group, depending on the formula structure.

Substituents of the substituted π electron-deficient nitrogen-containing C₁-C₆₀ cyclic group, the substituted π electron-rich C₃-C₆₀ cyclic group, the substituted C₅-C₆₀ cyclic group, the substituted C₁-C₆₀ heterocyclic group, the substituted C₅-C₃₀ carbocyclic group, the substituted C₁-C₃₀ heterocyclic group, the substituted C₁-C₆₀ alkylene group, the substituted C₂-C₆₀ alkenylene group, the substituted C₂-C₆₀ alkynylene group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed polycyclic group, the substituted divalent non-aromatic condensed heteropolycyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ heteroaryl alkyl group, the substituted monovalent non-aromatic condensed polycyclic group, and the substituted monovalent non-aromatic condensed heteropolycyclic group may each independently be:
deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or a C₁-C₆₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇₋C₆₀ alkylaryl group, a C₆-C₆₀ aryloxy group, a C₆-C₆₀ arylthio group, a C₁-C₆₀ heteroaryl group, a C₂-C₆₀ alkylheteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇₋C₆₀ alkylaryl group, a C₆-C₆₀ aryloxy group, a C₆-C₆₀ arylthio group, a C₁-C₆₀ heteroaryl group, a C₂-C₆₀ alkylheteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇₋C₆₀ alkylaryl group, a C₆-C₆₀ aryloxy group, a C₆-C₆₀ arylthio group, a C₁-C₆₀ heteroaryl group, a C₂-C₆₀ alkylheteroaryl group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), -P(Q₂₈)(Q₂₉), or a combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉);or
or a combination thereof.
Q₁ to Q₉, Q₁₁ to Q₁₉, Q₂₁ to Q₂₉, and Q₃₁ to Q₃₉ described herein may each independently be: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group which is unsubstituted or substituted with deuterium, a C₁-C₆₀ alkyl group, a C₆-C₆₀ aryl group, or a combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group which is unsubstituted or substituted with deuterium, a C₁-C₆₀ alkyl group, a C₆-C₆₀ aryl group, or a combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

For example, Q₁ to Q₉, Q₁₁ to Q₁₉, Q₂₁ to Q₂₉, and Q₃₁ to Q₃₉ described herein may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or a combination thereof.

The term "room temperature" as used herein refers to a temperature of about 25 °C.

The terms "a biphenyl group, a terphenyl group, and a quaterphenyl group" used herein respectively refer to monovalent groups in which two, three, or four phenyl groups which are linked together via a single bond.

Hereinafter, a compound and an organic light-emitting device according to embodiments are described in detail with reference to Synthesis Examples and Examples. However, the organic light-emitting device is not limited thereto. The wording '''B' was used instead of 'A'" used in describing Synthesis Examples means that an amount of 'B' used was identical to an amount of 'A' used, in terms of a molar equivalent.

### Examples

### Evaluation Example 1

The HOMO energy level, LUMO energy level, dipole moment and T₁ energy level of the compounds listed in Table 1 below were evaluated using the DFT method (T1 adiabatic) of a Gaussian program that is structurally optimized at the B3LYP/6-31G(d,p) level.

**Table 1**

| Compound No. | HOMO energy level (eV) | LUMO Energy level (eV) | Dipole moment (debye) | T₁ energy level (eV) |
|---|---|---|---|---|
| H1 | -5.109 | -0.911 | 4.373 | 3.00 |
| H2 | -5.176 | -1.213 | 5.008 | 2.95 |
| H3 | -5.104 | -1.214 | 2.458 | 3.00 |
| H4 | -5.125 | -1.085 | 4.365 | 2.99 |
| H5 | -5.419 | -1.066 | 1.341 | 3.00 |
| H6 | -5.220 | -1.035 | 2.805 | 3.05 |
| H7 | -5.230 | -0.833 | 1.886 | 2.81 |
| H8 | -5.330 | -1.050 | 2.218 | 3.02 |
| H9 | -5.206 | -1.351 | 2.378 | 2.97 |
| H10 | -5.105 | -1.034 | 4.667 | 2.95 |
| H11 | -5.173 | -1.357 | 2.726 | 2.98 |
| H12 | -5.161 | -1.338 | 2.676 | 2.99 |
| H13 | -5.066 | -1.180 | 4.499 | 3.00 |
| H14 | -5.169 | -1.222 | 2.317 | 3.00 |
| E1 | -5.757 | -1.808 | 1.6 | 2.970 |
| P31 | -4.630 | -1.230 | 7.8 | 2.689 |
| D3 | -4.919 | -1.368 | 2.1 | 2.525 |
| 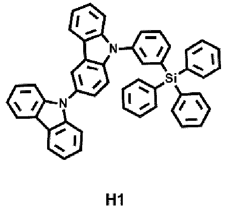 | | 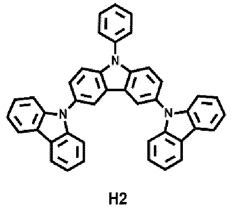 | | 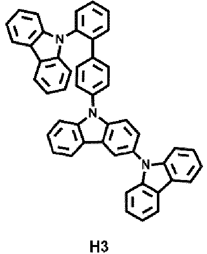 |
| 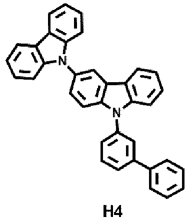 | | 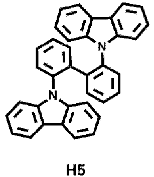 | | 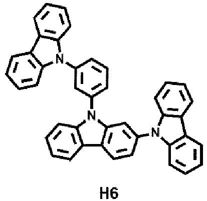 |
| 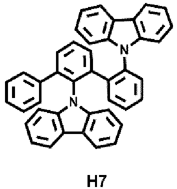 | 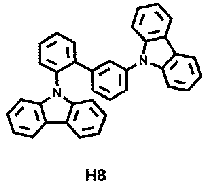 | | 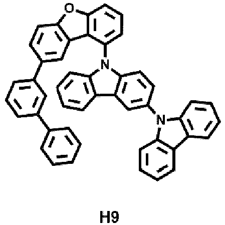 | |
| 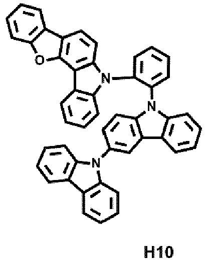 | 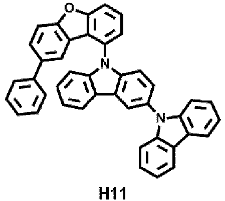 | | 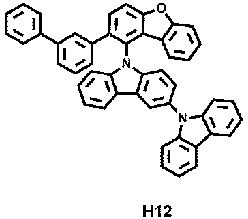 | |
| 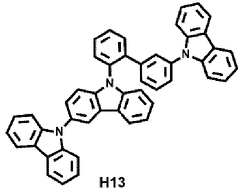 | 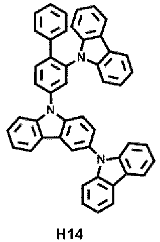 | | | |
| 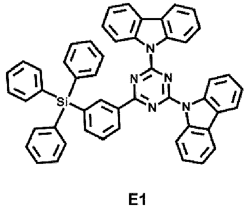 | 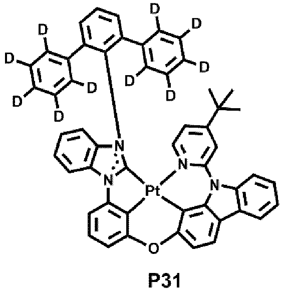 | | | |
| 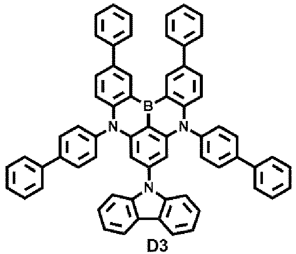 | | | | |

### Production of OLED A1

A glass substrate on which a 1,500 Å-thick indium tin oxide (ITO) electrode (first electrode, anode) was formed was cleaned by ultrasonication using distilled water. Thereafter, the substrate/ITO electrode was cleaned by ultrasonication using isopropyl alcohol, acetone, and methanol in order. The substrate/ITO electrode was dried and transferred to a chamber of a plasma cleaner. The substrate/ ITO electrode was cleaned in an oxygen plasma for 5 minutes and then transferred to a vacuum deposition device.

Compound HT1 and Compound HT-D2 were co-deposited on the ITO electrode at a weight ratio of 98:2 to form a hole injection layer having a thickness of 100 Å. Compound HT3 was then deposited on the hole injection layer to form a hole transport layer having a thickness of 1300 Å. Then a first material listed in Table 2 was deposited on the hole transport layer to form a first layer having a thickness of 50 Å to complete the formation of a hole transport region. A total of four comparative examples (A1 to A4) and a total of ten Examples (A5 to A14) of substrate/ITO electrode/hole transport region were prepared.

A first compound, a second compound, and an organometallic compound (the weight ratio of the first compound: second compound: organometallic compound is 57:30:13) were co-deposited on the hole transport region of each of A1 to A14 (Table 2) to form an emission layer having a thickness of 400 Å. The first compound, the second compound, and the organometallic compound (emitter) were H1, E1, and P31, respectively.

BCP was vacuum-deposited on the emission layer above to form a hole-blocking layer having a thickness of 100 Å, Compound ET27 and LiQ were co-deposited on the hole-blocking layer at a volume ratio of 50:50 to form an electron transport layer having a thickness of 300 Å. LiQ was deposited on the electron transport layer to form an electron injection layer having a thickness of 10 Å, and an AI second electrode (cathode) having a thickness of 1,200 Å was formed on the electron injection layer, thereby completing the manufacture of an organic light-emitting device.

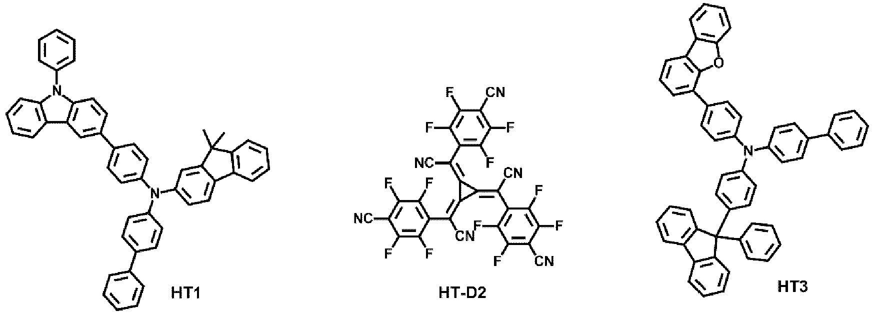

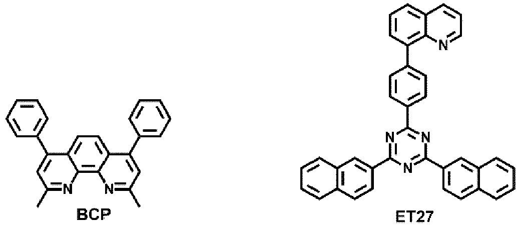

### Production of OLED A2 to OLED A14

As noted above, organic light-emitting devices were manufactured using the same method as the manufacturing method of OLED A1, except that the compounds listed in Table 2 was used as the first material when forming the first layer. Accordingly, the only structural/compositional difference between each OLED A1 to OLED A14 is the listed first material in Table 2.

### Evaluation Example 2

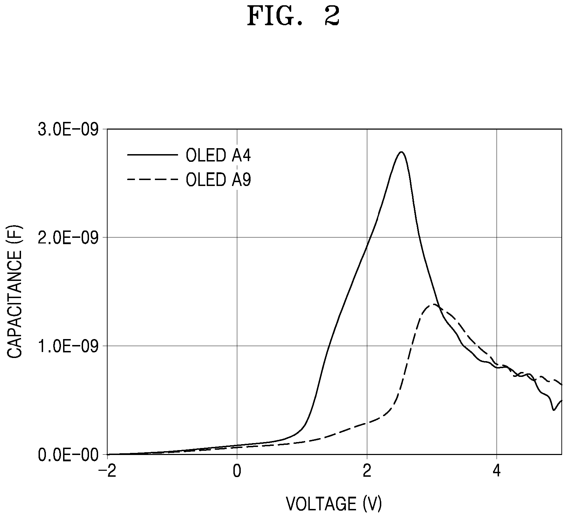

The capacitance (F)-voltage (V) curve of each of the OLED A1 to OLED A14 was measured using FLUXIM PAIOS (applying an AC amplitude of 0.1 V in the DC current range of -2 V to 6 V and 80 steps, and the measurement frequency fixed at 500 Hz). The maximum capacitance value (Cmax) of each OLED A1 to OLED A14 was read/obtained from the capacitance (F)-voltage (V) curve, and the Cmax of each of OLED A2 to OLED A14 was shown in Table 2 as a relative value (%) with respect to the Cmax of OLED A1. The capacitance-voltage curves of OLED A4 and OLED A9 are shown in FIG. 2.

**Table 2**

| | First material | HOMO energy level of first material (eV) | ΔHOMO¹ (eV) | Dipole moment of the first material (debye) | Maximum capacitance value (Cmax) (Relative value, %) |
|---|---|---|---|---|---|
| OLED A1 (Comparative Example) | H1 | -5.109 | 0.000 | 4.373 | 100 % |
| OLED A2 (Comparative Example) | H2 | -5.176 | -0.067 | 5.008 | 107 % |
| OLED A3 (Comparative Example) | H3 | -5.104 | 0.005 | 2.458 | 100 % |
| OLED A4 (Comparative Example) | H4 | -5.125 | -0.016 | 4.365 | 105 % |
| OLED A5 (Example) | H5 | -5.419 | -0.310 | 1.341 | 76 % |
| OLED A6 (Example) | H6 | -5.220 | -0.111 | 2.805 | 84 % |
| OLED A7 (Example) | H7 | -5.230 | -0.121 | 1.886 | 92 % |
| OLED A8 (Example) | H8 | -5.330 | -0.221 | 2.218 | 81 % |
| OLED A9 (Example) | H9 | -5.206 | -0.097 | 2.378 | 73 % |
| OLED A10 (Example) | H10 | -5.105 | 0.004 | 4.667 | 71 % |
| OLED A11 (Example) | H11 | -5.173 | -0.064 | 2.726 | 73 % |
| OLED A12 (Example) | H12 | -5.161 | -0.052 | 2.676 | 77 % |
| OLED A13 (Example) | H13 | -5.066 | 0.043 | 4.499 | 73 % |
| OLED A14 (Example) | H14 | -5.169 | -0.060 | 2.317 | % |

| | | | | | |
|---|---|---|---|---|---|
| ¹: HOMO energy level of the first material - HOMO energy level of the first compound | | | | | |

From Table 2 and FIG. 2, it can be seen that the maximum capacitance value of OLED A5 to OLED A14, which is an example, is decreased compared to the maximum capacitance value of OLED A1 to OLED A4, which are comparative examples.

### Production of OLED B1 to OLED B14

Organic light-emitting devices were manufactured in the same manner as used to manufacture each of OLED A1 to OLED A14, except that, when forming the emission layer, the first compound, the second compound, the thermally activated delayed fluorescent material, and the organometallic compound (the weight ratio of the first compound: second compound: thermally activated delayed fluorescent material: organometallic compound is 56:30.2:13:0.8) were co-deposited to form an emission layer having a thickness of 400 Å. The first compound, the second compound, the thermally activated delayed fluorescent material (emitter), and the organometallic compound (sensitizer) were H1, E1, D3, and P31, respectively. Again, the only structural/compositional difference between each OLED B1 to OLED B14 is the listed first material in Table 2.

### Evaluation Example 3

The capacitance-voltage curve and maximum capacitance value (Cmax) of each of OLED B1 to OLED B14 were obtained using the same method as in Evaluation Example 2, and then the Cmax of each OLED B2 to OLED B14 was expressed as a relative value (%) to Cmax of OLED B1 and summarized in Table 3.

**Table 3**

| | First material | HOMO energy level of first material (eV) | ΔHOMO¹ (eV) | Dipole moment of the first material (debye) | Maximum capacitance value (Cmax) (Relative value, %) |
|---|---|---|---|---|---|
| OLED B1 (Comparative Example) | H1 | -5.109 | 0.000 | 4.373 | 100 % |
| OLED B2 (Comparative Example) | H2 | -5.176 | -0.067 | 5.008 | 110 % |
| OLED B3 (Comparative Example) | H3 | -5.104 | 0.005 | 2.458 | 105 % |
| OLED B4 (Comparative Example) | H4 | -5.125 | -0.016 | 4.365 | 107 % |
| OLED B5 (Example) | H5 | -5.419 | -0.310 | 1.341 | 70 % |
| OLED B6 (Example) | H6 | -5.220 | -0.111 | 2.805 | 77 % |
| OLED B7 (Example) | H7 | -5.230 | -0.121 | 1.886 | 88 % |
| OLED B8 (Example) | H8 | -5.330 | -0.221 | 2.218 | 79 % |
| OLED B9 (Example) | H9 | -5.206 | -0.097 | 2.378 | 71 % |
| OLED B10 (Example) | H10 | -5.105 | 0.004 | 4.667 | 73 % |
| OLED B11 (Example) | H11 | -5.173 | -0.064 | 2.726 | 75 % |
| OLED B12 (Example) | H12 | -5.161 | -0.052 | 2.676 | 74 % |
| OLED B13 (Example) | H13 | -5.066 | 0.043 | 4.499 | 75 % |
| OLED B14 (Example) | H14 | -5.169 | -0.060 | 2.317 | 88 % |

As indicated from Table 3, OLED B5 to OLED B14, which represent working Examples, is shown to have decreased Cmax compared to the Cmax of OLED B1 to B4, which are comparative examples.

The light-emitting device according to an embodiment has improved capacitance characteristics, and thus, has improved light-emitting characteristics in a low gray level area. Moreover, high-quality electronic devices can be manufactured based on the compound and material selection described herein.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the FIG.s, it will be understood by those of ordinary skill in the art that various changes in form and details may be made therein without departing from the scope as defined by the following claims.

## Claims

1. A light-emitting device comprising:
a first electrode; a second electrode facing the first electrode; and an interlayer disposed between the first electrode and the second electrode,
wherein the interlayer comprises an emission layer and a hole transport region,
wherein the hole transport region includes a first layer, the first layer includes a first material and is disposed between the first electrode and the emission layer,
wherein the emission layer includes a host and an organometallic compound, the organometallic compound includes a transition metal, and the host includes a first compound, and
the light-emitting device satisfies Condition 1 or Condition 2:
Condition 1
Δ HOMO is less than 0 eV, and a dipole moment of the first material is less than 3.0 debye
Condition 2
Δ HOMO is greater than 0 eV, and the dipole moment of the first material is equal to or greater than 3.0 debye.
wherein, in Condition 1 and Condition 2,
ΔHOMO is a value obtained by subtracting the HOMO energy level of the first compound from a HOMO energy level of the first material,
the HOMO energy level of the first compound, the HOMO energy level of the first material, and the dipole moment of the first material are each calculated based on density functional theory (DFT), and
the HOMO energy level of the first compound and the HOMO energy level of the first material are negative values.

2. The light-emitting device of claim 1, wherein
the light-emitting device satisfies Condition 1, and the ΔHOMO is -0.5 eV to less than 0 eV.

3. The light-emitting device of claims 1 or 2, wherein
the light-emitting device satisfies Condition 1, and the dipole moment of the first material is 0.5 debye to less than 3.0 debye.

4. The light-emitting device of claim 1, wherein
the light-emitting device satisfies Condition 2, and the ΔHOMO is greater than 0 eV to 0.1 eV.

5. The light-emitting device of claims 1 or 4, wherein
the light-emitting device satisfies Condition 2, and the dipole moment of the first material is 3.0 debye to 6.0 debye.

6. The light-emitting device of any of claims 1-5, wherein the HOMO energy level of the first compound is -5.6 eV to -4.8 eV; and/or
wherein a triplet (T₁) energy level of the first compound is 2.8 eV or greater; and/or
wherein the HOMO energy level of the first material is -5.6 eV to -4.8 eV.

7. The light-emitting device of any of claims 1, 2, 4 or 6, wherein
the dipole moment of the first material is 0.8 debye to 7.0 debye.

8. The light-emitting device of any of claims 1-7, wherein
the organometallic compound further includes a tetradentate ligand coordinated to the transition metal, and the transition metal is platinum (Pt) or palladium (Pd);
preferably wherein
the tetradentate ligand includes a carbene moiety coordinated to the platinum or palladium.

9. The light-emitting device of any of claims 1-8, wherein
the host of the emission layer further includes a second compound,
the second compound is different from the first compound, and
the first compound is a hole-transporting compound, and the second compound is an electron-transporting compound, and
a highest occupied molecular orbital (HOMO) energy level of the first compound is greater than a HOMO energy of the second compound.

10. The light-emitting device of any of claims 1-9, wherein
the emission layer emits blue light.

11. The light-emitting device of any of claims 1-10, wherein
the organometallic compound is an emitter.

12. The light-emitting device of any of claims 1-11, wherein
the emission layer further includes a thermally activated delayed fluorescence material;
preferably wherein
the thermally activated delayed fluorescence material is a multiple resonance thermally activated delayed fluorescence material comprising a polycyclic compound, which i) does not include a transition metal, and ii) includes a core in which two or more C₃-C₆₀ cyclic groups are condensed with each other, and
the condensed C₃-C₆₀ cyclic groups share a boron (8) or a nitrogen (N).

13. The light-emitting device of claim 12, wherein the thermally activated delayed fluorescence material is an emitter, and the organometallic compound is a sensitizer; and/or
wherein the thermally activated delayed fluorescence material emits blue light.

14. The light-emitting device of any of claims 11-13, wherein
the organometallic compound includes a tetradentate ligand coordinated to platinum (Pt) or palladium (Pd), and optionally, the tetradentate ligand includes a carbene moiety coordinated to the platinum or palladium.

15. An electronic device comprising the light-emitting device of any of claims 1 to 14.
